(19) Europäisches Patentamt
European Patent Office
Office européen des brevets

(11) EP 2 629 346 B1

(12) # EUROPEAN PATENT SPECIFICATION

(45) Date of publication and mention of the grant of the patent:
**30.05.2018 Bulletin 2018/22**

(51) Int Cl.:
***H01L 51/52*** *(2006.01)* ***H01L 51/54*** *(2006.01)*
***C07C 15/28*** *(2006.01)*

(21) Application number: **12197357.2**

(22) Date of filing: **14.12.2012**

(54) **Organic light-emitting device having improved efficiency characteristics and organic light-emitting display apparatus including the same**

Organische lichtemittierende Vorrichtung mit verbesserten Effizienzmerkmalen und organische lichtemittierende Anzeigevorrichtung damit

Dispositif électroluminescent organique ayant des caractéristiques d'efficacité améliorées et appareil d'affichage électroluminescent organique comprenant celui-ci

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **14.02.2012 KR 20120148252**

(43) Date of publication of application:
**21.08.2013 Bulletin 2013/34**

(73) Proprietor: **Samsung Display Co., Ltd.**
**Gyeonggi-do (KR)**

(72) Inventors:
- **Cho, Hwan-Hee**
  **446-711 Gyeonggi-do (KR)**
- **Lee, Kwan-Hee**
  **446-711 Gyeonggi-do (KR)**
- **Chu, Chang-Woong**
  **446-711 Gyeonggi-do (KR)**
- **Lee, Moon-Jae**
  **446-711 Gyeonggi-do (KR)**
- **Kwak, Jae-Hyun**
  **446-711 Gyeonggi-do (KR)**
- **Park, Young-Ho**
  **446-711 Gyeonggi-do (KR)**
- **Seo, Ji-Hyun**
  **446-711 Gyeonggi-do (KR)**

(74) Representative: **Russell, Tim et al**
**Venner Shipley LLP**
**200 Aldersgate**
**London EC1A 4HD (GB)**

(56) References cited:
**WO-A1-2010/108579**
**WO-A1-2011/076323**
**WO-A2-2011/057706**
**DE-A1-102009 048 791**
**US-A1- 2007 252 516**
**US-A1- 2009 191 427**
**US-A1- 2011 175 071**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 2 629 346 B1

## Description

The present invention relates to an organic light-emitting device (OLED) having improved efficiency characteristics, and more particularly, to an OLED of which luminous efficiency characteristics are improved according to luminance. Also, the present invention relates to an OLED apparatus including the OLED of which luminous efficiency characteristics are improved in a black state.

Organic light-emitting devices (OLEDs) are self-emission devices, have a wide viewing angle, a high contrast ratio, a short response time, and excellent luminance, driving voltage, and response speed characteristics, and enable generation of multi-colored images.

In a typical OLED, an anode is formed on a substrate, and a hole transport layer, an emission layer, an electron transport layer, and a cathode are sequentially formed in this stated order on the anode. In this regard, the hole transport layer, the emission layer, and the electron transport layer are organic film layers including organic compounds. When a voltage is applied between the anode and the cathode, holes injected from the anode pass the hole transport layer and migrate toward the emission layer, and electrons injected from the cathode pass the electron transport layer and migrate toward the emission layer. Carriers such as the holes and electrons are recombined in the emission layer to generate excitons, and then the excitons change from an excited state to a ground state, thereby generating light.

The most important factor to determine luminous efficiency in an OLED is the light emitting material. Though fluorescent materials have been widely used up to the present as the light emitting material, development of a phosphorescent material, from the aspect of the mechanism of electroluminescence, is one of the best ways to improve the luminous efficiency; theoretically up to 4-fold.

An OLED using a phosphorescent material shows a very high efficiency compared to an OLED using a fluorescent material at a low luminance region. In particular, since an OLED using a phosphorescent material has a high luminous efficiency at a region where low current flows, the organic light-emitting display apparatus may emit weak green or red light due to current leakage when the apparatus needs to display a black state. In order to overcome such a problem, a method of inserting a layer which slows down hole transportation between a hole transport layer and an emission layer, or a method of applying pure metal to an electron injection layer have been used.

However, even with the above methods, low luminance state efficiency characteristics of an OLED using a phosphorescent material have not reached a satisfactory level, and improvements are thereby needed.

Exemplary phosphorescent organic light-emitting devices are already described in US 2009/0191427 A1 and US2007/0252516 A1. The present invention provides an organic light-emitting device (OLED) which has excellent luminous efficiency at a high luminance region and low luminous efficiency at a low luminance region, meaning that emission of green or red light due to current leakage may be avoided.

The present invention also provides an organic light-emitting display apparatus including the OLED, which suppresses emission of red and green light in a black state.

According to a first aspect of the present invention, there is provided an organic light-emitting device (OLED) including a first electrode; a second electrode opposite to the first electrode; a phosphorescent emission layer disposed between the first electrode and the second electrode; an electron transport layer disposed between the phosphorescent emission layer and the second electrode; and an electron control layer disposed between the phosphorescent emission layer and the electron transport layer, wherein the phosphorescent emission layer includes a host material and a dopant material, and the electron control layer includes an electron control material of Formula 1 as defined in claim 1, wherein the highest occupied molecular orbital (HOMO) energy level of the host material ($EH_H$), the lowest unoccupied molecular orbital (LUMO) energy level of the host material ($EL_H$), the HOMO energy level of the electron control material ($EH_C$), and the LUMO energy level of the electron control material ($EL_C$) satisfy both relationships of $|EH_H - EH_C| \leq 0.3$ eV and $|EL_H - EL_C| \leq 0.5$eV, wherein the thickness of the electron control layer is from 50 Å to 450 Å (10 Å = 1 nm). $EH_H$, $EL_H$, $EH_C$, and $EL_C$ may satisfy the relationships of $0 \leq EH_H - EH_C \leq 0.3$ eV and $0 \leq EL_H - EL_C \leq 0.5$ eV.

The electron mobility of the electron control material may be greater than or equal to the hole mobility of the electron control material.

EHc may be in a range from -5.2 eV to -6.1 eV.

ELc may be in a range from -2.5 eV to -3.2 eV.

The content of the electron control material may be in the range from 30 weight % (wt %) to 100 wt % based on the total weight of the electron control layer.

The thickness ratio of the electron transport layer and the electron control layer may be in the range from 5:1 to 5:10.

According to another aspect of the present invention, there is provided an OLED including a first electrode; a second electrode opposite to the first electrode; a phosphorescent emission layer disposed between the first electrode and the second electrode; an electron transport layer disposed between the phosphorescent emission layer and the second electrode; an electron control layer disposed between the phosphorescent emission layer and the electron transport layer; and an electron blocking layer disposed between the phosphorescent emission layer and the first electrode, wherein the phosphorescent emission layer includes a host material and a dopant material, the electron control layer includes an electron control material of Formula 1 as defined in claim 1, and the electron blocking layer includes an electron blocking material, wherein $EH_H$, $EL_H$, $EH_C$, $EL_C$ and the LUMO energy level of the electron blocking material $EL_B$ satisfy relationships of $|EH_H - EH_C| \leq 0.3$ eV, $|EL_H - EL_C| \leq 0.5$ eV, and $EL_B > EL_H$, wherein the thickness of the electron control layer is from 50 Å to 450 Å.

The electron blocking material may include at least one of a triphenylamine derivative, a carbazole derivative, and a spirobifluorene derivative.

The thickness of the electron blocking layer may be from 10 Å to 1000 Å.

$EH_H$, $EL_H$, EHc, and ELc may satisfy relationships of $0 \leq EH_H - EHc \leq 0.3$ eV and $0 \leq EL_H - EL_C \leq 0.5$ eV.

The electron mobility of the electron control material may be greater than or equal to the hole mobility of the electron control material.

EHc may be in a range from -5.2 eV to -6.1 eV.

ELc may be in a range from -2.5 eV to -3.2 eV.

The content of the electron control material may be in the range from 30 wt % to 100 wt % based on the total weight of the electron control layer.

The thickness ratio of the electron transport layer and the electron control layer may be in a range from 5:1 to 5:10.

The electron control material may include a compound represented by Formula 1 below:

Formula 1

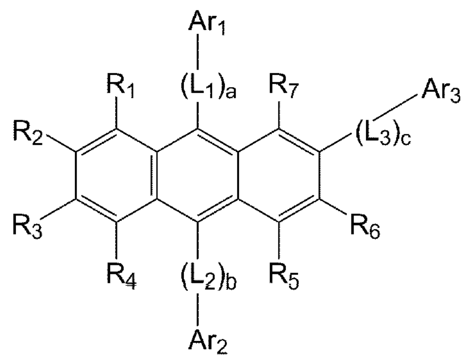

In Formula 1, wherein $R_1$ to $R_7$ are each independently one of a hydrogen, a deuterium, a halogen, a hydroxy group, a cyano group, a nitro group, an amino group, a carboxyl group, a substituted or unsubstituted $C_1$-$C_{30}$ alkyl group, a substituted or unsubstituted $C_2$-$C_{30}$ alkenyl group, a substituted or unsubstituted $C_2$-$C_{30}$ alkynyl group, a substituted or unsubstituted $C_1$-$C_{30}$ alkoxy group, a substituted or unsubstituted $C_3$-$C_{30}$ cycloalkyl group, a substituted or unsubstituted $C_3$-$C_{30}$ cycloalkenyl group, and a substituted or unsubstituted $C_6$-$C_{30}$ aryl group,

$Ar_1$, $Ar_2$, and $Ar_3$ are each independently one of a substituted or unsubstituted $C_6$-$C_{30}$ aryl group, a substituted or unsubstituted $C_6$-$C_{30}$ aryloxy group, a substituted or unsubstituted $C_6$-$C_{30}$ arylthio group, a substituted or unsubstituted $C_2$-$C_{30}$ heteroaryl group, and a group represented by $-N(Q_1)(Q_2)$, wherein at least one of $Ar_1$, $Ar_2$, and $Ar_3$ is a substituted or unsubstituted $C_2$-$C_{30}$ heteroaryl group, wherein $Q_1$ and $Q_2$ are each independently one of a hydrogen, a deuterium, a halogen, a hydroxy group, a cyano group, an amino group, a nitro group, a carboxyl group, a substituted or unsubstituted $C_1$-$C_{30}$ alkyl group, a substituted or unsubstituted $C_2$-$C_{30}$ alkenyl group, a substituted or unsubstituted $C_2$-$C_{30}$ alkynyl group, a substituted or unsubstituted $C_1$-$C_{30}$ alkoxy group, a substituted or unsubstituted $C_3$-$C_{30}$ cycloalkyl group, a substituted or unsubstituted $C_3$-$C_{30}$ cycloalkenyl group, a substituted or unsubstituted $C_6$-$C_{30}$ aryl group, a substituted or unsubstituted $C_6$-$C_{30}$ aryloxy group, a substituted or unsubstituted $C_6$-$C_{30}$ arylthio group, and a substituted or unsubstituted $C_2$-$C_{30}$ heteroaryl group,

$L_1$, $L_2$ ,and $L_3$ are each independently one of a substituted or unsubstituted $C_6$-$C_{30}$ arylene group, and a substituted or unsubstituted $C_2$-$C_{30}$ heteroarylene group, and

a, b, and c are each independently one of integers 0, 1, 2 or 3.

The electron control material may comprise at least one compound represented by Formulae 2 and 3 below:

Formula 2

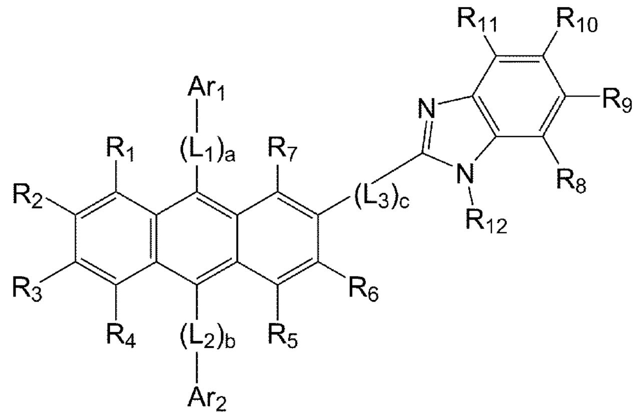

Formula 3

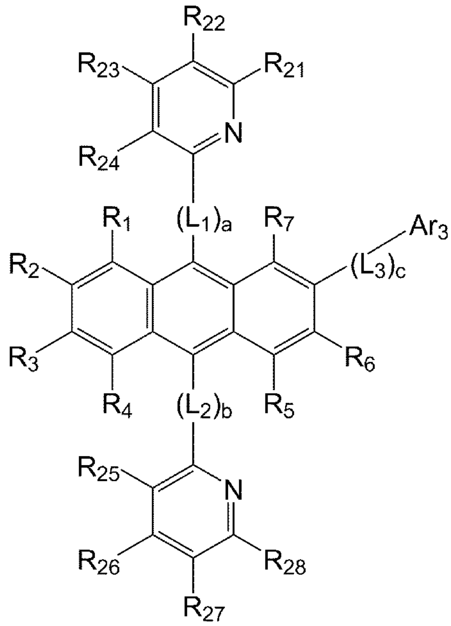

wherein In Formulae 2 and 3, $R_1$ to $R_{12}$ and $R_{21}$ to $R_{28}$ are each independently one of a hydrogen, a deuterium, a substituted or unsubstituted methyl group, a substituted or unsubstituted ethyl group, a substituted or unsubstituted propyl group, a substituted or unsubstituted butyl group, a substituted or unsubstituted phenyl group, a substituted or unsubstituted biphenyl group, a substituted or unsubstituted naphthyl group, a substituted or unsubstituted anthryl, a substituted or unsubstituted phenanthrenyl, a substituted or unsubstituted pyrenyl group,

$Ar_1$, $Ar_2$, and $Ar_3$ are each independently one of a substituted or unsubstituted phenyl group, a substituted or unsubstituted pentalenyl group, a substituted or unsubstituted indenyl group, a substituted or unsubstituted naphtyl group, a substituted or unsubstituted azulenyl group, a substituted or unsubstituted heptalenyl group, a substituted or unsubstituted indacenyl group, a substituted or unsubstituted acenaphtyl group, a substituted or unsubstituted fluorenyl group, a substituted or unsubstituted spirofluorenyl group, a substituted or unsubstituted phenalenyl group, a substituted or unsubstituted phenanthrenyl group, a substituted or unsubstituted anthryl group, a substituted or unsubstituted fluoranthenyl group, a substituted or unsubstituted triphenylenyl group, a substituted or unsubstituted pyrenyl group, a substituted or unsubstituted chrysenyl group, a substituted or unsubstituted naphthacenyl group, a substituted or unsubstituted picenyl group, a substituted or unsubstituted perylenyl group, a substituted or unsubstituted pentaphenyl group, a substituted or unsubstituted hexacenyl group, a substituted or unsubstituted pyrrolyl group, a substituted or unsubstituted imidazolyl group, a substituted or unsubstituted pyrazolyl group, a substituted or unsubstituted pyridinyl group, a substituted or unsubstituted bipyridinyl group, a substituted or unsubstituted pyrazinyl group, a substituted or unsubstituted pyrimidinyl group, a substituted or unsubstituted pyridazinyl group, a substituted or unsubstituted isoindolyl group, a substituted or unsubstituted indolyl group, a substituted or unsubstituted indazolyl group, a substituted or unsubstituted purinyl group,

a substituted or unsubstituted quinolinyl group, a substituted or unsubstituted benzoquinolinyl group, a substituted or unsubstituted phthalazinyl group, a substituted or unsubstituted naphthyridinyl group, a substituted or unsubstituted quinoxalinyl group, a substituted or unsubstituted quinazolinyl group, a substituted or unsubstituted cinnolinyl group, a substituted or unsubstituted carbazolyl group, a substituted or unsubstituted phenanthridinyl group, a substituted or unsubstituted acridinyl group, a substituted or unsubstituted phenanthrolinyl group, a substituted or unsubstituted phenazinyl group, a substituted or unsubstituted benzooxazolyl group, a substituted or unsubstituted benzoimidazolyl group, a substituted or unsubstituted furanyl group, a substituted or unsubstituted benzofuranyl group, a substituted or unsubstituted thiophenyl group, a substituted or unsubstituted benzothiophenyl group, a substituted or unsubstituted thiazolyl group, a substituted or unsubstituted isothiazolyl group, a substituted or unsubstituted benzothiazolyl group, a substituted or unsubstituted isoxazolyl group, a substituted or unsubstituted oxazolyl group, a substituted or unsubstituted triazolyl group, a substituted or unsubstituted tetrazolyl group, a substituted or unsubstituted oxadiazolyl group, a substituted or unsubstituted triazinyl group, a substituted or unsubstituted benzooxazolyl group, a substituted or unsubstituted dibenzopuranyl group, a substituted or unsubstituted dibenzothiophenyl group, and a substituted or unsubstituted bezocarbazolyl group,

$L_1$, $L_2$ ,and $L_3$ are each independently one of a substituted or unsubstituted phenylene group, a substituted or unsubstituted pentalenylene group, a substituted or unsubstituted indenylene group, a substituted or unsubstituted naphthylene group, a substituted or unsubstituted azulenylene group, a substituted or unsubstituted heptalenylene group, a substituted or unsubstituted indacenylene group, a substituted or unsubstituted acenaphthylene group, a substituted or unsubstituted fluorenylene group, a substituted or unsubstituted phenalenylene group, a substituted or unsubstituted phenanthrenylene group, a substituted or unsubstituted anthrylene group, a substituted or unsubstituted fluoranthenylene group, a substituted or unsubstituted triphenylenylene group, a substituted or unsubstituted pyrenylene group, a substituted or unsubstituted chrysenylene group, a substituted or unsubstituted naphthacenylene group, a substituted or unsubstituted picenylene group, a substituted or unsubstituted perylenylene group, a substituted or unsubstituted pentaphenylene group, a substituted or unsubstituted hexacenylene group, a substituted or unsubstituted pyrrolylene group, a substituted or unsubstituted pyrazolylene group, a substituted or unsubstituted imidazolylene group, a substituted or unsubstituted imidazolinylene group, a substituted or unsubstituted imidazopyridinylene group, a substituted or unsubstituted imidazopyrimidinylene group, a substituted or unsubstituted pyridinylene group, a substituted or unsubstituted pyrazinylene group, a substituted or unsubstituted pyrimidinylene group, a substituted or unsubstituted indolylene group, a substituted or unsubstituted purinylene group, a substituted or unsubstituted quinolinylene group, a substituted or unsubstituted phthalazinylene group, a substituted or unsubstituted indolizinylene group, a substituted or unsubstituted naphthyridinylene group, a substituted or unsubstituted quinazolinylene group, a substituted or unsubstituted cinnolinylene group, a substituted or unsubstituted indazolylene group, a substituted or unsubstituted carbazolylene group, a substituted or unsubstituted phenazinylene group, a substituted or unsubstituted phenanthridinylene group, a substituted or unsubstituted pyranylene group, a substituted or unsubstituted chromenylene group, a substituted or unsubstituted furanylene group, a substituted or unsubstituted benzofuranylene group, a substituted or unsubstituted thiophenylene group, a substituted or unsubstituted benzothiophenylene group, a substituted or unsubstituted isothiazolylene group, a substituted or unsubstituted benzoimidazolylene group, a substituted or unsubstituted isoxazolylene group, a substituted or unsubstituted dibenzothiophenylene group, a substituted or unsubstituted dibenzopuranylene group, a substituted or unsubstituted triazinylene group, and a substituted or unsubstituted oxadiazolylene group, and

a, b, and c are each independently one of integers of 0 to 1.

The electron control material may comprise at least one of Compounds 1 and 2 below:

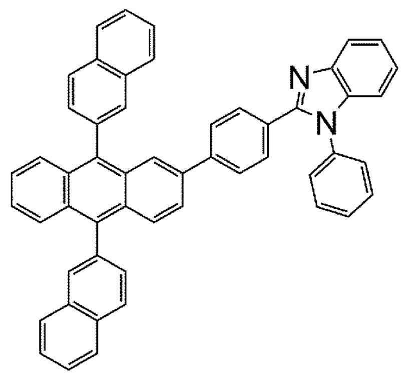

1

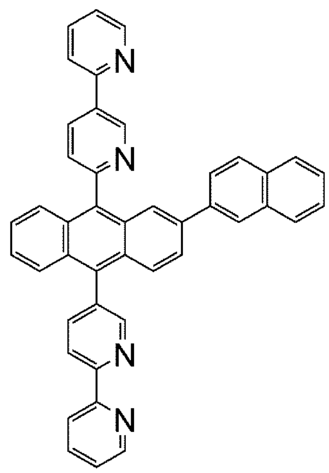

2

The host material may include a bipolar compound having both a hole transport unit and an electron transport unit.

The host material may include a mixture of a bipolar compound having both a hole transport unit and an electron transport unit and a compound having at least a hole transport unit.

The phosphorescent emission layer may emit red light. The phosphorescent emission layer may emit green light.

The electron transport layer may include a compound represented by Formula 4 below:

Formula 4

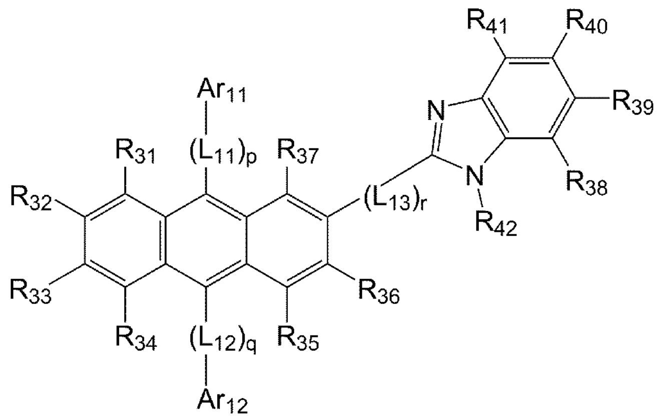

In Formula 4, $R_{31}$ to $R_{42}$ are each independently one of a hydrogen, a deuterium, a substituted or unsubstituted methyl group, a substituted or unsubstituted ethyl group, a substituted or unsubstituted propyl group, a substituted or unsubstituted butyl group, a substituted or unsubstituted phenyl group, a substituted or unsubstituted biphenyl group, a substituted or unsubstituted naphthyl group, a substituted or unsubstituted anthryl, a substituted or unsubstituted phenanthrenyl, a substituted or unsubstituted pyrenyl group, $Ar_{11}$ and $Ar_{12}$ are each independently one of a substituted or unsubstituted phenyl group, a substituted or unsubstituted pentalenyl group, a substituted or unsubstituted indenyl group, a substituted or unsubstituted naphtyl group, a substituted or unsubstituted azulenyl group, a substituted or unsubstituted heptalenyl group, a substituted or unsubstituted indacenyl group, a substituted or unsubstituted acenaphtyl group, a substituted or unsubstituted fluorenyl group, a substituted or unsubstituted spirofluorenyl group, a substituted or unsubstituted phenalenyl group, a substituted or unsubstituted phenanthrenyl group, a substituted or unsubstituted anthryl group, a substituted or unsubstituted fluoranthenyl group, a substituted or unsubstituted triphenylenyl group, a substituted or unsubstituted pyrenyl group, a substituted or unsubstituted chrysenyl group, a substituted or unsubstituted naphthacenyl group. a substituted or unsubstituted picenyl group, a substituted or unsubstituted perylenyl group, a substituted or unsubstituted pentaphenyl group, a substituted or unsubstituted hexacenyl group, a substituted or unsubstituted pyrrolyl group, a substituted or unsubstituted imidazolyl group, a substituted or unsubstituted pyrazolyl group, a substituted or unsubstituted pyridinyl group, a substituted or unsubstituted bipyridinyl group, a substituted or unsubstituted pyrazinyl group, a substituted or unsubstituted pyrimidinyl group, a substituted or unsubstituted pyridazinyl group, a substituted or unsubstituted isoindolyl group, a substituted or unsubstituted indolyl group, a substituted or unsubstituted indazolyl

group, a substituted or unsubstituted purinyl group, a substituted or unsubstituted quinolinyl group, a substituted or unsubstituted benzoquinolinyl group, a substituted or unsubstituted phthalazinyl group, a substituted or unsubstituted naphthyridinyl group, a substituted or unsubstituted quinoxalinyl group, a substituted or unsubstituted quinazolinyl group, a substituted or unsubstituted cinnolinyl group, a substituted or unsubstituted carbazolyl group, a substituted or unsubstituted phenanthridinyl group, a substituted or unsubstituted acridinyl group, a substituted or unsubstituted phenanthrolinyl group, a substituted or unsubstituted phenazinyl group, a substituted or unsubstituted benzooxazolyl group, a substituted or unsubstituted benzoimidazolyl group, a substituted or unsubstituted furanyl group, a substituted or unsubstituted benzofuranyl group, a substituted or unsubstituted thiophenyl group, a substituted or unsubstituted benzothiophenyl group, a substituted or unsubstituted thiazolyl group, a substituted or unsubstituted isothiazolyl group, a substituted or unsubstituted benzothiazolyl group, a substituted or unsubstituted isoxazolyl group, a substituted or unsubstituted oxazolyl group, a substituted or unsubstituted triazolyl group, a substituted or unsubstituted tetrazolyl group, a substituted or unsubstituted oxadiazolyl group, a substituted or unsubstituted triazinyl group, a substituted or unsubstituted benzooxazolyl group, a substituted or unsubstituted dibenzopuranyl group, a substituted or unsubstituted dibenzothiophenyl group, and a substituted or unsubstituted bezocarbazolyl group,

$L_{11}$, $L_{12}$ ,and $L_{13}$ are each independently one of a substituted or unsubstituted phenylene group, a substituted or unsubstituted pentalenylene group, a substituted or unsubstituted indenylene group, a substituted or unsubstituted naphthylene group, a substituted or unsubstituted azulenylene group, a substituted or unsubstituted heptalenylene group, a substituted or unsubstituted indacenylene group, a substituted or unsubstituted acenaphthylene group, a substituted or unsubstituted fluorenylene group, a substituted or unsubstituted phenalenylene group, a substituted or unsubstituted phenanthrenylene group, a substituted or unsubstituted anthrylene group, a substituted or unsubstituted fluoranthenylene group, a substituted or unsubstituted triphenylenylene group, a substituted or unsubstituted pyrenylene group, a substituted or unsubstituted chrysenylene group, a substituted or unsubstituted naphthacenylene group, a substituted or unsubstituted picenylene group, a substituted or unsubstituted perylenylene group, a substituted or unsubstituted pentaphenylene group, a substituted or unsubstituted hexacenylene group, a substituted or unsubstituted pyrrolylene group, a substituted or unsubstituted pyrazolylene group, a substituted or unsubstituted imidazolylene group, a substituted or unsubstituted imidazolinylene group, a substituted or unsubstituted imidazopyridinylene group, a substituted or unsubstituted imidazopyrimidinylene group, a substituted or unsubstituted pyridinylene group, a substituted or unsubstituted pyrazinylene group, a substituted or unsubstituted pyrimidinylene group, a substituted or unsubstituted indolylene group, a substituted or unsubstituted purinylene group, a substituted or unsubstituted quinolinylene group, a substituted or unsubstituted phthalazinylene group, a substituted or unsubstituted indolizinylene group, a substituted or unsubstituted naphthyridinylene group, a substituted or unsubstituted quinazolinylene group, a substituted or unsubstituted cinnolinylene group, a substituted or unsubstituted indazolylene group, a substituted or unsubstituted carbazolylene group, a substituted or unsubstituted phenazinylene group, a substituted or unsubstituted phenanthridinylene group, a substituted or unsubstituted pyranylene group, a substituted or unsubstituted chromenylene group, a substituted or unsubstituted furanylene group, a substituted or unsubstituted benzofuranylene group, a substituted or unsubstituted thiophenylene group, a substituted or unsubstituted benzothiophenylene group, a substituted or unsubstituted isothiazolylene group, a substituted or unsubstituted benzoimidazolylene group, a substituted or unsubstituted isoxazolylene group, a substituted or unsubstituted dibenzothiophenylene group, a substituted or unsubstituted dibenzopuranylene group, a substituted or unsubstituted triazinylene group, and a substituted or unsubstituted oxadiazolylene group, and

p, q, and r are each independently an integer of 0 to 1.

The electron transport layer may further include at least one selected from a lithium quinolate (LiQ) and Compound 101 below:

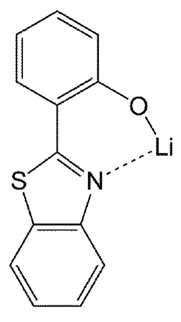

101

The electron transport layer may further include at least one selected from 1,4,5,8,9,12-hexaazatriphenylene hexacarbonitrile, tetracyanoquinodimethane, anthraquinone, perylenebisimide, and tetracyanoanthraquinodimethane.

The electron transport layer may further include at least one selected from at least one metal selected from Li, Cs, Na, K, Ca, Mg, Ba, and Ra; a metal carbonate; a metal acetate; a metal benzoate; a metal acetoacetate; a metal acetylacetonate; and a metal stearate.

The OLED may further include a hole transport layer disposed between the phosphorescent emission layer and the first electrode, wherein the hole transport layer includes a compound represented by Formula 5 below:

Formula 5

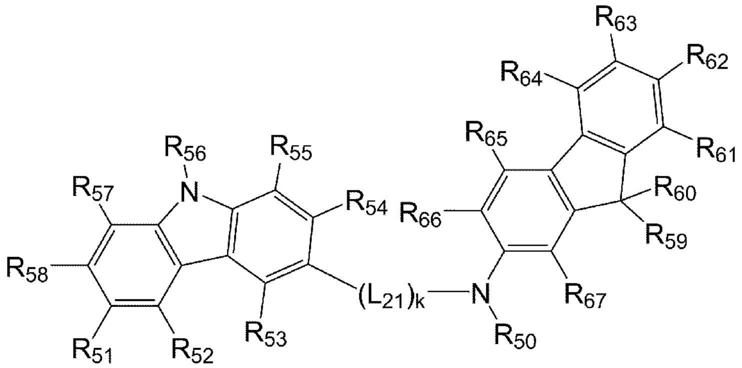

In Formula 5,

wherein $R_{50}$ is one of a substituted or unsubstituted phenyl group, a substituted or unsubstituted naphthyl group, a substituted or unsubstituted anthryl group, a substituted or unsubstituted biphenyl group, and a substituted or unsubstituted pyridyl group;

$L_{21}$ is one of a substituted or unsubstituted $C_1$-$C_{30}$ alkylene group, a substituted or unsubstituted $C_2$-$C_{30}$ alkenylene group, a substituted or unsubstituted $C_6$-$C_{30}$ arylene group, and a substituted or unsubstituted $C_2$-$C_{30}$ heteroarylene group;

$R_{51}$ to $R_{67}$ are each independently one of a hydrogen, a deuterium, a halogen, a hydroxy group, a cyano group, a nitro group, a carboxyl group, a substituted or unsubstituted $C_1$-$C_{30}$ alkyl group, a substituted or unsubstituted $C_2$-$C_{30}$ alkenyl group, a substituted or unsubstituted $C_2$-$C_{30}$ alkynyl group, a substituted or unsubstituted $C_1$-$C_{30}$ alkoxy group, a substituted or unsubstituted $C_1$-$C_{30}$ alkylthiol group, a substituted or unsubstituted $C_3$-$C_{30}$ cycloalkyl group, a substituted or unsubstituted $C_3$-$C_{30}$ cycloalkenyl group, a substituted or unsubstituted $C_6$-$C_{30}$ aryl group, a substituted or unsubstituted $C_6$-$C_{30}$ aryloxy group, a substituted or unsubstituted $C_6$-$C_{30}$ arylthio group, a substituted or unsubstituted $C_2$-$C_{30}$ heteroaryl group, and a group represented by $-N(Q_{11})(Q_{12})$; $Q_{11}$ and $Q_{12}$ are each independently one of a hydrogen, a deuterium, a halogen, a hydroxy group, a cyano group, an amino group, a nitro group, a carboxyl group, a $C_1$-$C_{30}$ alkyl group, a $C_2$-$C_{30}$ alkenyl group, a $C_2$-$C_{30}$ alkynyl group, a $C_1$-$C_{30}$ alkoxy group, a $C_1$-$C_{30}$ alkylthiol group, a $C_3$-$C_{30}$ cycloalkyl group, a $C_3$-$C_{30}$ cycloalkenyl group, a $C_6$-$C_{30}$ aryl group, a $C_6$-$C_{30}$ aryloxy group, a $C_6$-$C_{30}$ arylthio group, and a $C_2$-$C_{30}$ heteroaryl group; and k is one of the integers 0, 1, 2, or 3..

The OLED may further include a hole injection layer disposed between the hole transport layer and the first electrode, wherein the hole injection layer includes a compound represented by Formula 6 below:

Formula 6

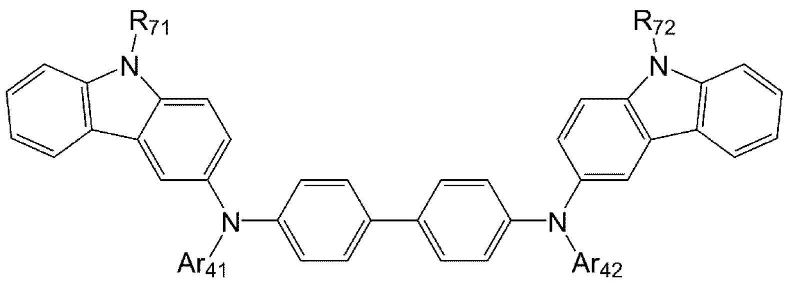

In Formula 6, $Ar_{41}$ and $Ar_{42}$ are each independently one of a substituted or unsubstituted $C_6$-$C_{30}$ arylene group and a substituted or unsubstituted $C_2$-$C_{30}$ heteroarylene group,

$R_{71}$ and $R_{72}$ are each independently one of a hydrogen, a deuterium, a halogen, a hydroxy group, a cyano group, a nitro group, an amino group, an amidino group, a hydrazine, a hydrazone, a carboxyl group or a salt thereof, a sulfonic acid

group or a salt thereof, a phosphoric acid group or a salt thereof, a substituted or unsubstituted $C_1$-$C_{30}$ alkyl group, a substituted or unsubstituted $C_2$-$C_{30}$ alkenyl group, a substituted or unsubstituted $C_2$-$C_{30}$ alkynyl group, a substituted or unsubstituted $C_1$-$C_{30}$ alkoxy group, a substituted or unsubstituted $C_3$-$C_{30}$ cycloalkyl group, a substituted or unsubstituted $C_6$-$C_{30}$ aryl group, a substituted or unsubstituted $C_6$-$C_{30}$ aryloxy group, and a substituted or unsubstituted $C_6$-$C_{30}$ arylthio group

According to another aspect of the present invention, there is provided an organic light-emitting display apparatus including a transistor including source, drain, gate, and an active layer, and the OLED, wherein a first electrode of the OLED is electrically connected to the source or the drain.

## BRIEF DESCRIPTION OF THE DRAWINGS

A more complete appreciation of the present invention, and many of the attendant advantages thereof, will be readily apparent as the same becomes better understood by reference to the following detailed description when considered in conjunction with the accompanying drawings, wherein:

FIG. 1 is a schematic cross-sectional view of a structure of an organic light-emitting diode (OLED) according to an embodiment;

FIG. 2 is a schematic cross-sectional view of a structure of an OLED according to an embodiment;

FIG. 3 is a schematic cross-sectional view of an OLED having a structure of a substrate / a first electrode / a hole injection layer / a hole transport layer / an emission layer / an electron control layer / an electron transport layer / an electron injection layer / a second electrode, according to an embodiment;

FIG. 4 is a schematic cross-sectional view of an OLED having a structure of a substrate / a first electrode / a hole injection layer / a hole transport layer / an electron blocking layer / an emission layer / an electron control layer / an electron transport layer / an electron injection layer / a second electrode, according to an embodiment;

FIG. 5 schematically illustrates the HOMO energy level and the LUMO energy level of each layer of the OLED shown in FIG. 3;

FIG. 6 schematically illustrates the HOMO energy level and the LUMO energy level of each layer of the OLED shown in FIG. 4;

FIG. 7 is a graph illustrating efficiencies of the OLEDs manufactured in Examples 1 to 6 and Comparative Examples 1 to 4 according to luminance;

FIG. 8 is a normalized graph illustrating efficiencies of the OLEDs manufactured in Examples 1 to 6 and Comparative Examples 1 to 4 according to luminance;

FIG. 9 is a graph illustrating efficiencies of the OLEDs manufactured in Examples 7 to 10 and Comparative Examples 5 to 7 according to luminance;

FIG. 10 is a normalized graph illustrating efficiencies of the OLEDs manufactured in Examples 7 to 10 and Comparative Examples 5 to 7 according to luminance;

FIG. 11 is a graph illustrating efficiencies of the OLEDs manufactured in Examples 11 to 14 and Comparative Examples 8 to 10 according to luminance; and

FIG. 12 is a normalized graph illustrating efficiencies of the OLEDs manufactured in Examples 11 to 14 and Comparative Examples 8 to 10 according to luminance.

## DETAILED DESCRIPTION

Embodiments of the present invention will now be described more fully with reference to the accompanying drawings. Expressions such as "at least one of," when preceding a list of elements, modify the entire list of elements and do not modify the individual elements of the list.

FIG. 1 is a schematic cross-sectional view of a structure of an organic light-emitting diode (OLED) 100 according

to an embodiment.

Referring to FIG. 1, the OLED 100 includes a substrate 110, a first electrode 130 formed on the substrate 110, a second electrode 190 opposite to the first electrode 130, and an organic layer 150 disposed between the first electrode 130 and the second electrode 190.

The organic layer 150 includes an emission layer 160 in which holes and electrons are recombined to generate excitons and thereby light is emitted when the excitons change from an excited state to a ground state, an electron transport layer 173 disposed between the emission layer 160 and the second electrode 190, and an electron control layer 171 disposed between the emission layer 160 and the electron transport layer 173.

The emission layer 160 is a phosphorescent emission layer including a phosphorescent host material and a dopant material. The electron control layer 173 includes an electron control material.

Since a phosphorescent host material and a dopant material implement a light-emitting mechanism of which light, not heat, is emitted from a triplet excited state, an OLED using a phosphorescent host material and a dopant material in an emission layer may have a luminous efficiency that is theoretically improved up to 4 times compared to when a fluorescent material of which light is emitted from a singlet excited state is used.

According to the invention, the highest occupied molecular orbital (HOMO) energy level of the host material ($EH_H$), the lowest unoccupied molecular orbital (LUMO) energy level of the host material ($EL_H$), the HOMO energy level of the electron control material (EHc), and the LUMO energy level of the electron control material (ELc) satisfy both relationships below:

$$|EH_H - EH_C| \leq 0.3eV$$

and

$$|EL_H - EL_C| \leq 0.5eV.$$

In some embodiments, $EH_C$ has a similar value to $EH_H$. The difference between absolute values of EHc and $EH_H$ may be 0.3 eV or less. When the difference between the absolute values of EHc and $EH_H$ is 0.3 eV or less, a hole blocking mechanism from an emission layer to an electron control layer at a low luminance region may be suppressed.

In some embodiments, the difference between the absolute values of $EL_C$ and $EL_H$ is 0.5 eV or less. When the difference between absolute values of $EL_C$ and $EL_H$ is 0.5 eV or less, an electron transport capacity may be appropriate, and driving voltage may not be excessively raised.

In some embodiments, the thickness of the electron control layer 171 including the electron control material is from 50 Å to 450 Å. The electron control layer 171 may serve to control electron injection to the emission layer 160. When the thickness of the electron control layer 171 is 50 Å or greater, a luminous efficiency lowering effect occurs appropriately at a low luminance, and when the thickness is 450 Å or less, an excessive raise of driving voltage is suppressed.

The OLED 100 having such structure includes an emission layer 160, which is a phosphorescent emission layer, thereby a luminous efficiency is significantly improved, and since injection and transportation of holes and electrons at a high luminance region are smooth, the OLED 100 has an excellent luminous efficiency. However, a hole blocking mechanism is suppressed at a low luminance region due to presence of the electron control layer 171 in the OLED 100, and injection and transportation of electrons in a direction from the electron transport layer 173 to the emission layer 160 are slowed down. As a result, electrons and holes for generating exitons in the emission layer 160 at a low luminance region are unbalanced, thereby a luminous efficiency of the device may be reduced.

In some embodiments, $EH_H$, $EL_H$, $EH_C$, and $EL_C$ may satisfy both relationships below:

$$0 \leq EH_H - EH_C \leq 0.3 \text{ eV}$$

and

$$0 \leq EL_H - EL_C \leq 0.5 \text{ eV}$$

In some embodiments, $EH_C$ has a lower value than $EH_H$. The difference between $EH_C$ and $EH_H$ may be 0.3 eV or less.

Since EHc is lower than $EH_H$, luminous efficiency may be raised due to a hole blocking mechanism at a high

luminance. However, since the difference is 0.3 eV or less, the luminous efficiency may be reduced as the hole blocking mechanism is suppressed at a low luminance.

Also, since ELc is lower than $EL_H$, electrons may be transported smoothly. However, excessive raise of driving voltage may be suppressed since the difference between ELc and $EL_H$ is 0.5 eV or less.

In some embodiments, the electron mobility of the electron control material may be greater than or equal to the hole mobility of the electron control material. In this regard, the flow of electrons in the electron control layer 171 where the electron control material is included may be slowed down. That is, the flow of electrons moving fast in the electron transport layer 173 is slowed down to a certain degree while passing through the electron control layer 171, thereby the luminous efficiency of the device at a low luminance region may be reduced.

In some embodiments, $EH_C$ may be from -5.2 eV to -6.1 eV. In some embodiments, $EL_C$ may be from -2.5 eV to -3.2 eV.

When $EH_C$ and $EL_C$ satisfy the ranges above, luminous efficiency may be raised due to a hole blocking mechanism at a high luminance, and a luminous efficiency may be reduced as a hole blocking mechanism is suppressed at a low luminance.

In some embodiments, the content of the electron control material may be in the range from 30 weight % (wt %) to 100 wt % based on the total weight of the electron control layer 171.

The electron control layer 171 may be composed of the electron control material only or may include other materials than the electron control material. However, in order to have an improved effect of luminous efficiency characteristics according to luminance due to an electron control material, the content of the electron control material needs to be sufficient and thus may be 30 wt % or more based on the total weight of the electron control layer 171.

In some embodiments, the thickness ratio of the electron transport layer 173 and the electron control layer 171 may be in the range from 5:1 to 5:10.

The thickness ratio of the electron transport layer 173 and the electron control layer 171 relates to a weight ratio of a material for forming an electron transport layer included in the electron transport layer 173 and an electron control material included in the electron control layer 171 or the like, and the thickness ratio is related to an amount affected by the electron control material as well. When a thickness of the electron control layer 171 satisfies the relationship with regard to a thickness of electron transport layer 173, a luminous efficiency control effect according to luminance due to an electron control material may properly appear.

FIG. 2 is a schematic cross-sectional view of a structure of an OLED 200 according to an embodiment.

Referring to FIG. 2, the OLED 200 according to this embodiment includes a substrate 210, a first electrode 230 formed on the substrate 210, a second electrode 290 opposite to the first electrode 230, and an organic layer 250 disposed between the first electrode 230 and the second electrode 290.

The organic layer 250 includes an emission layer 260 in which holes and electrons are recombined to generate excitons and thereby light is emitted when the excitons change from an excited state to a ground state, an electron transport layer 273 disposed between the emission layer 260 and the second electrode 290, an electron control layer 271 disposed between the emission layer 260 and the electron transport layer 273, and an electron blocking layer 281 disposed between the emission layer 260 and the first electrode 230.

The emission layer 260 includes a phosphorescent host material and a dopant material, the electron control layer 173 includes an electron control material, and the electron blocking layer 281 includes an electron blocking material.

In some embodiments, $EH_H$, $EL_H$, $EH_C$, $EL_C$, and a LUMO energy level of the electron blocking material $EL_B$ satisfy all three relationships below:

$$|EH_H - EH_C| \leq 0.3\ eV$$

$$|EL_H - EL_C| \leq 0.5\ eV$$

and

$$EL_B > EL_H.$$

In some embodiments, $EH_C$ has a similar value to $EH_H$. The difference between absolute values of EHc and $EH_H$ may be 0.3 eV or less. When the difference between the absolute values of EHc and $EH_H$ is 0.3 eV or less, a hole blocking mechanism from an emission layer to an electron control layer at a low luminance region may be suppressed.

In some embodiments, the difference between absolute values of $EL_C$ and $EL_H$ is 0.5 eV or less. When the difference between the absolute values of $EL_C$ and $EL_H$ is 0.5 eV or less, an electron transport capacity may be appropriate,

and driving voltage may not be excessively raised.

$EL_B$ may be higher than $EL_H$. When $EL_B$ is higher than $EL_H$, the mobility of electrons flowing in a direction from the emission layer 260 to the first electrode 230 may be suppressed.

In some embodiments, the thickness of the electron control layer 271 including the electron control material is from 50 Å to 450 Å. When the thickness of the electron control layer 271 is 50 Å or greater, a luminous efficiency lowering effect occurs appropriately at a low luminance, and when the thickness is 450 Å or less, an excessive raise of driving voltage is suppressed.

In the OLED 200 having such structure, injection and transportation of holes and electrons at a high luminance region are smooth, and particularly luminous efficiency of the device is excellent since the electron blocking layer 281 suppresses the electrons from transferring in a direction to the first electrode 230 over the emission layer 260.

However, in the OLED 200, a hole blocking mechanism is suppressed at a low luminance region due to a presence of the electron control layer 271, and thereby injection and transportation of electrons in a direction from the electron transport layer 273 to the emission layer 260 are slowed down. As a result, electrons and holes for generating exitons in the emission layer 260 at a low luminance region are unbalanced, thereby luminous efficiency of the device is reduced.

In some embodiments, the electron blocking material can be a material with a high LUMO energy level, for example, including but not limited to a triarylamine-based triphenylamine derivative, a carbazole derivative, or a spirobifluorene derivative. As the electron blocking material, for example, 1,4,7-triazacylclononane-N,N',N"-triacetate (TCTA), spiro-TAD(2,2',7,7'-tetrakis(N,N-diphenylamino)-9,9'-spirobifluorene) or a material such as Compound 701 below may be used, or a metal complex such as Irppz or ppz2Ir(dpm) may be used:

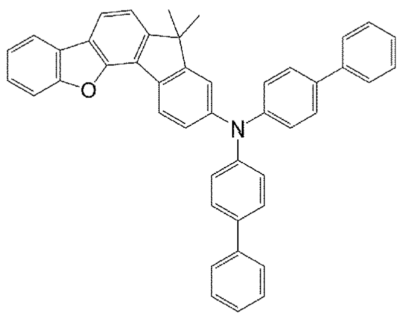

701

In some embodiments, the thickness of the electron blocking layer 281 may be from 10 Å to 1000 Å. When the thickness of the electron blocking layer 281 is 10 Å or greater, an excellent electron blocking ability of the electron blocking layer 281 may be obtained, and when the thickness is 1000 Å or less, an excessive raise of driving voltage is suppressed. For example, the thickness of the electron blocking layer 281 may be in a range of 50 Å to 800 Å.

$EH_H$, $EL_H$, EHc, and ELc may satisfy relationships below:

$$0 \leq EH_H - EH_C \leq 0.3 \text{ eV}$$

and

$$0 \leq EL_H - EL_C \leq 0.5 \text{ eV}.$$

EHc may be lower than $EH_H$., The difference between $EH_C$ and $EH_H$ may be 0.3 eV or less. When EHc is lower than $EH_H$, luminous efficiency may be raised due to a hole blocking mechanism at a high luminance. However, since the difference is 0.3 eV or less, the luminous efficiency may be reduced as the hole blocking mechanism is suppressed at a low luminance.

Also, since ELc is lower than $EL_H$, electrons may be transported smoothly. However, excessive raise of driving voltage may be suppressed since a difference between ELc and $EL_H$ is 0.5 eV or less.

In some embodiments, the electron mobility of the electron control material may be greater than or the same as the hole mobility of the electron control material. In this regard, the flow of electrons in the electron control layer 271 where the electron control material is included may be slowed down. The flow of electrons moving fast in the electron transport layer 273 is slowed down to a certain degree while passing through the electron control layer 271, thereby a

luminous efficiency of the device at a low luminance region may be reduced.

EHc may be in a range, for example, from -5.2 eV to -6.1 eV, and ELc may be in a range, for example, from -2.5 eV to -3.2 eV. When EHc and ELc satisfy the ranges above, luminous efficiency may be raised due to a hole blocking mechanism at a high luminance, and luminous efficiency may be reduced as a hole blocking mechanism is suppressed at a low luminance.

In some embodiments, the content of the electron control material may be in a range from 30 weight % (wt %) to 100 wt % based on the total weight of the electron control layer 271.

The electron control layer 271 may be composed of the electron control material only or may include other materials than the electron control material. However, in order to have an improved effect of luminous efficiency characteristics according to luminance due to an electron control material, the content of the electron control material needs to be sufficient and thus may be 30 wt % or more based on the total weight of the electron control layer 271.

In some embodiments, the thickness ratio of the electron transport layer 273 and the electron control layer 271 may be from about 5:1 to about 5:10.

When the thickness of the electron control layer 271 satisfies the relationship with regard to the thickness of electron transport layer 273, a luminous efficiency control effect depending on luminance due to an electron control material may properly appear.

The electron control material is included in the electron control layer 171 or 271 with a content in a range from 30 wt % to 100 wt % based on the total weight of the electron control layer 171 or 271. The electron control material is a material that controls the HOMO energy level relationship between the electron control layer 171 or 271 and the emission layer 160 or 260 and thus serves to increase rates of injection and transportation of electrons at a high luminance region and to decrease rates of injection and transportation of electrons at a low luminance region. Such electron control material includes a compound represented by Formula 1 below:

Formula 1

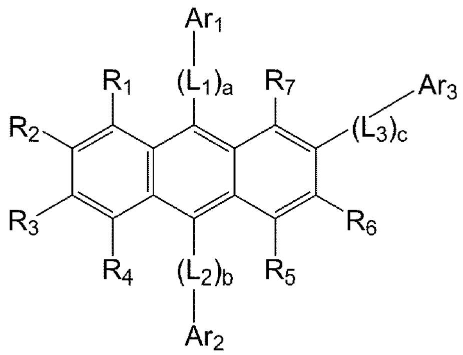

In Formula 1, $R_1$ to $R_7$ are each independently one of a hydrogen, a deuterium, a halogen, a hydroxy group, a cyano group, a nitro group, an amino group, a carboxyl group, a substituted or unsubstituted $C_1$-$C_{30}$ alkyl group, a substituted or unsubstituted $C_2$-$C_{30}$ alkenyl group, a substituted or unsubstituted $C_2$-$C_{30}$ alkynyl group, a substituted or unsubstituted $C_1$-$C_{30}$ alkoxy group, a substituted or unsubstituted $C_3$-$C_{30}$ cycloalkyl group, a substituted or unsubstituted $C_3$-$C_{30}$ cycloalkenyl group, and a substituted or unsubstituted $C_6$-$C_{30}$ aryl group,

$Ar_1$, $Ar_2$, and $Ar_3$ are each independently one of a substituted or unsubstituted $C_6$-$C_{30}$ aryl group, a substituted or unsubstituted $C_6$-$C_{30}$ aryloxy group, a substituted or unsubstituted $C_6$-$C_{30}$ arylthio group, a substituted or unsubstituted $C_2$-$C_{30}$ heteroaryl group, and a group represented by $-N(Q_1)(Q_2)$,

$L_1$, $L_2$ ,and $L_3$ are each independently one of a substituted or unsubstituted $C_6$-$C_{30}$ arylene group, and a substituted or unsubstituted $C_2$-$C_{30}$ heteroarylene group, and a, b, and c are each independently one of integers of 0 to 3.

In Formula 1, at least one of $Ar_1$, $Ar_2$, and $Ar_3$ is a substituted or unsubstituted $C_2$-$C_{30}$ heteroaryl group.

In the group represented by $-N(Q_1)(Q_2)$, $Q_1$ and $Q_2$ are each independently one of a hydrogen, a deuterium, a halogen, a hydroxy group, a cyano group, an amino group, a nitro group, a carboxyl group, a substituted or unsubstituted $C_1$-$C_{30}$ alkyl group, a substituted or unsubstituted $C_2$-$C_{30}$ alkenyl group, a substituted or unsubstituted $C_2$-$C_{30}$ alkynyl group, a substituted or unsubstituted $C_1$-$C_{30}$ alkoxy group, a substituted or unsubstituted $C_3$-$C_{30}$ cycloalkyl group, a substituted or unsubstituted $C_3$-$C_{30}$ cycloalkenyl group, a substituted or unsubstituted $C_6$-$C_{30}$ aryl group, a substituted or unsubstituted $C_6$-$C_{30}$ aryloxy group, a substituted or unsubstituted $C_6$-$C_{30}$ arylthio group, and a substituted or unsubstituted $C_2$-$C_{30}$ heteroaryl group.

In Formula 1, when a is 0, $-(L_1)_a-$ indicates a single bond, and when a is 2 or greater, a plurality of $L_1$ may be identical to or different from each other. Likewise, when b is 0, $-(L_2)_b-$indicates a single bond, and when b is 2 or greater, a plurality of $L_2$ may be identical to or different from each other. When c is 0, $-(L_3)_c-$ indicates a single bond, and when

c is 2 or greater, a plurality of $L_3$ may be identical to or different from each other.

The compound represented by Formula 1 has a HOMO energy level in a range from -5.2 eV to -6.1 eV and a LUMO energy level in a range from -2.5 eV to -3.2 eV. The compound includes at least one $C_2$-$C_{30}$ heteroaryl group in the molecular structure of the compound and thus has an excellent electron mobility.

The compound represented by Formula 1 is included in the electron control layer 171 or 271 and serves to accelerate injection and transportation of electrons at a high luminance region and slow down injection and transportation of electrons at a low luminance region.

The electron control material may include at least one of the compounds represented by Formulae 2 and 3 below:

Formula 2

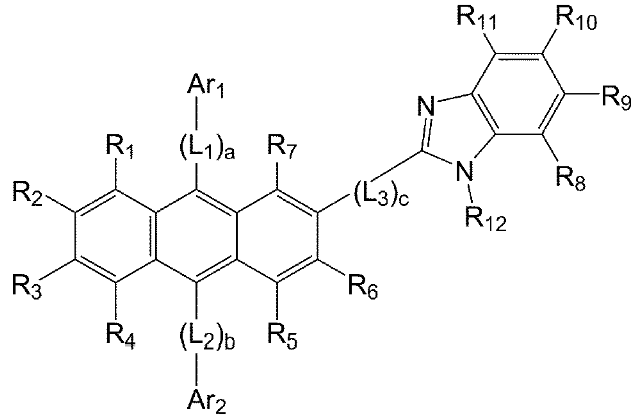

Formula 3

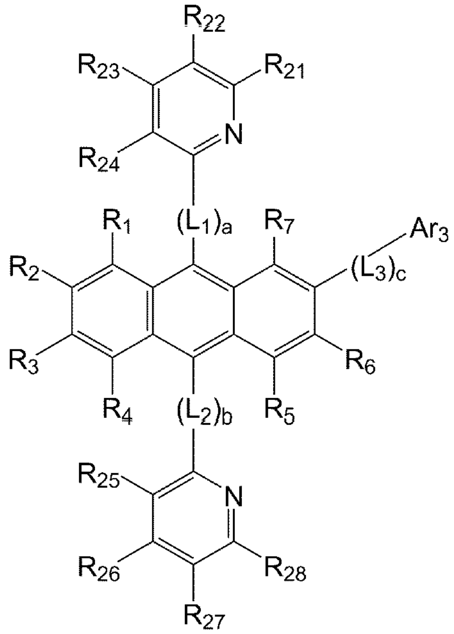

In Formulae 2 and 3, $R_1$ to $R_{12}$ and $R_{21}$ to $R_{28}$ are each independently one of a hydrogen, a deuterium, a substituted or unsubstituted methyl group, a substituted or unsubstituted ethyl group, a substituted or unsubstituted propyl group, a substituted or unsubstituted butyl group, a substituted or unsubstituted phenyl group, a substituted or unsubstituted biphenyl group, a substituted or unsubstituted naphthyl group, a substituted or unsubstituted anthryl, a substituted or unsubstituted phenanthrenyl, a substituted or unsubstituted pyrenyl group, $Ar_1$, $Ar_2$, and $Ar_3$ are each independently one of a substituted or unsubstituted phenyl group, a substituted or unsubstituted pentalenyl group, a substituted or unsubstituted indenyl group, a substituted or unsubstituted naphtyl group, a substituted or unsubstituted azulenyl group, a substituted or unsubstituted heptalenyl group, a substituted or unsubstituted indacenyl group, a substituted or unsubstituted acenaphtyl group, a substituted or unsubstituted fluorenyl group, a substituted or unsubstituted spirofluorenyl group, a substituted or unsubstituted phenalenyl group, a substituted or unsubstituted phenanthrenyl

group, a substituted or unsubstituted anthryl group, a substituted or unsubstituted fluoranthenyl group, a substituted or unsubstituted triphenylenyl group, a substituted or unsubstituted pyrenyl group, a substituted or unsubstituted chrysenyl group, a substituted or unsubstituted naphthacenyl group, a substituted or unsubstituted picenyl group, a substituted or unsubstituted perylenyl group, a substituted or unsubstituted pentaphenyl group, a substituted or unsubstituted hexacenyl group, a substituted or unsubstituted pyrrolyl group, a substituted or unsubstituted imidazolyl group, a substituted or unsubstituted pyrazolyl group, a substituted or unsubstituted pyridinyl group, a substituted or unsubstituted bipyridinyl group, a substituted or unsubstituted pyrazinyl group, a substituted or unsubstituted pyrimidinyl group, a substituted or unsubstituted pyridazinyl group, a substituted or unsubstituted isoindolyl group, a substituted or unsubstituted indolyl group, a substituted or unsubstituted indazolyl group, a substituted or unsubstituted purinyl group, a substituted or unsubstituted quinolinyl group, a substituted or unsubstituted benzoquinolinyl group, a substituted or unsubstituted phthalazinyl group, a substituted or unsubstituted naphthyridinyl group, a substituted or unsubstituted quinoxalinyl group, a substituted or unsubstituted quinazolinyl group, a substituted or unsubstituted cinnolinyl group, a substituted or unsubstituted carbazolyl group, a substituted or unsubstituted phenanthridinyl group, a substituted or unsubstituted acridinyl group, a substituted or unsubstituted phenanthrolinyl group, a substituted or unsubstituted phenazinyl group, a substituted or unsubstituted benzooxazolyl group, a substituted or unsubstituted benzoimidazolyl group, a substituted or unsubstituted furanyl group, a substituted or unsubstituted benzofuranyl group, a substituted or unsubstituted thiophenyl group, a substituted or unsubstituted benzothiophenyl group, a substituted or unsubstituted thiazolyl group, a substituted or unsubstituted isothiazolyl group, a substituted or unsubstituted benzothiazolyl group, a substituted or unsubstituted isoxazolyl group, a substituted or unsubstituted oxazolyl group, a substituted or unsubstituted triazolyl group, a substituted or unsubstituted tetrazolyl group, a substituted or unsubstituted oxadiazolyl group, a substituted or unsubstituted triazinyl group, a substituted or unsubstituted benzooxazolyl group, a substituted or unsubstituted dibenzopuranyl group, a substituted or unsubstituted dibenzothiophenyl group, and a substituted or unsubstituted bezocarbazolyl group, $L_1$, $L_2$ ,and $L_3$ are each independently one of a substituted or unsubstituted phenylene group, a substituted or unsubstituted pentalenylene group, a substituted or unsubstituted indenylene group, a substituted or unsubstituted naphthylene group, a substituted or unsubstituted azulenylene group, a substituted or unsubstituted heptalenylene group, a substituted or unsubstituted indacenylene group, a substituted or unsubstituted acenaphthylene group, a substituted or unsubstituted fluorenylene group, a substituted or unsubstituted phenalenylene group, a substituted or unsubstituted phenanthrenylene group, a substituted or unsubstituted anthrylene group, a substituted or unsubstituted fluoranthenylene group, a substituted or unsubstituted triphenylenylene group, a substituted or unsubstituted pyrenylene group, a substituted or unsubstituted chrysenylene group, a substituted or unsubstituted naphthacenylene group, a substituted or unsubstituted picenylene group, a substituted or unsubstituted perylenylene group, a substituted or unsubstituted pentaphenylene group, a substituted or unsubstituted hexacenylene group, a substituted or unsubstituted pyrrolylene group, a substituted or unsubstituted pyrazolylene group, a substituted or unsubstituted imidazolylene group, a substituted or unsubstituted imidazolinylene group, a substituted or unsubstituted imidazopyridinylene group, a substituted or unsubstituted imidazopyrimidinylene group, a substituted or unsubstituted pyridinylene group, a substituted or unsubstituted pyrazinylene group, a substituted or unsubstituted pyrimidinylene group, a substituted or unsubstituted indolylene group, a substituted or unsubstituted purinylene group, a substituted or unsubstituted quinolinylene group, a substituted or unsubstituted phthalazinylene group, a substituted or unsubstituted indolizinylene group, a substituted or unsubstituted naphthyridinylene group, a substituted or unsubstituted quinazolinylene group, a substituted or unsubstituted cinnolinylene group, a substituted or unsubstituted indazolylene group, a substituted or unsubstituted carbazolylene group, a substituted or unsubstituted phenazinylene group, a substituted or unsubstituted phenanthridinylene group, a substituted or unsubstituted pyranylene group, a substituted or unsubstituted chromenylene group, a substituted or unsubstituted furanylene group, a substituted or unsubstituted benzofuranylene group, a substituted or unsubstituted thiophenylene group, a substituted or unsubstituted benzothiophenylene group, a substituted or unsubstituted isothiazolylene group, a substituted or unsubstituted benzoimidazolylene group, a substituted or unsubstituted isoxazolylene group, a substituted or unsubstituted dibenzothiophenylene group, a substituted or unsubstituted dibenzopuranylene group, a substituted or unsubstituted triazinylene group, and a substituted or unsubstituted oxadiazolylene group, and a, b, and c are each independently an integers of 0 to 1.

In Formulae 2 and 3, when a is 0, $-(L_1)_a-$ indicates a single bond, when b is 0, $-(L_2)_b-$indicates a single bond, and when c is 0, $-(L_3)_c-$ indicates a single bond.

The compounds represented by Formulae 2 and 3 have a HOMO energy level in a range from -5.2 eV to -6.1 eV and a LUMO energy level in a range from -2.5 eV to -3.2 eV. A compound represented by Formula 2 includes a benzimidazole group in a molecular structure of the compound, and a compound represented by Formula 3 includes a pyridyl group in a molecular structure of the compound, and thus the compounds have an excellent electron mobility.

In the electron control layer 171 or 271 including at least one of the compounds represented by Formulae 2 and 3, injection and transportation of electrons may be accelerated at a high luminance region, and injection and transportation of electrons may be slowed down at a low luminance region.

For example, the electron control material may include at least one of Compounds 1 and 2 below:

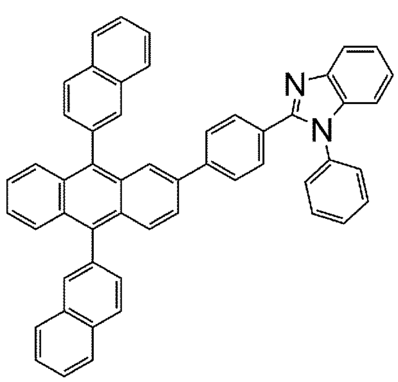 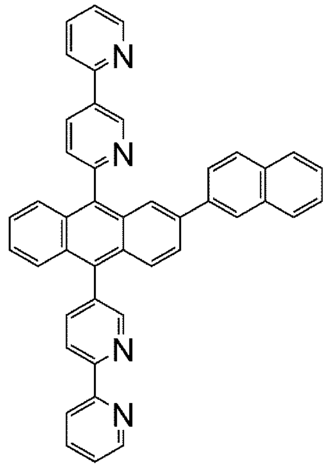

1 2

In this regard, the electron control layer 171 or 271 may include Compound 1, Compound 2, or a mixture of Compounds 1 and 2 with a content of 30 wt % to 100 wt % based on a total weight of the electron control layer 171 or 271.

FIG. 3 is a schematic cross-sectional view of an OLED 300 having a structure of a substrate 310 / a first electrode 330 / a hole injection layer 383 / a hole transport layer 385 / an emission layer 360 / an electron control layer 371 / an electron transport layer 373 / an electron injection layer 375 / a second electrode 390 according to an embodiment. Hereinafter, according to an embodiment, a structure of the OLED 300 and a method of manufacturing the OLED 300 will be described in detail.

The substrate 310, which may be any substrate that is used in a conventional OLED, may be a glass substrate or a transparent plastic substrate with excellent mechanical strength, thermal stability, transparency, surface smoothness, ease of handling, and waterproofness.

The first electrode 330 may be formed by depositing or sputtering a material that is used to form the first electrode 330 on the substrate 310. If the first electrode 330 is an anode, a material used for forming a first electrode may be a high work-function material so as to facilitate hole injection. The first electrode 330 may be a reflective electrode or a transmission electrode. As the material for forming a first electrode, transparent and conductive materials such as ITO, IZO, $SnO_2$, and ZnO may be used. The first electrode 330 may be formed as a reflective electrode using Mg, Al, Al-Li, Ca, Ag-ITO, Mg-In, Mg-Ag, or the like. The first electrode 330 may have a structure of a single layer or multiple layers of 2 or more layers. For example, the first electrode 330 may have a 3-layered structure of ITO/Ag/ITO, but is not limited thereto.

An organic layer 350 is formed on the first electrode 330. The organic layer 350 may include the hole injection layer 383, the hole transport layer 385, a buffer layer (not shown), the emission layer 360, the electron control layer 371, the electron transport layer 373, and the electron injection layer 375.

The hole injection layer 383 may be formed on the first electrode 330 by using a vacuum deposition, a spin coating, a casting, a Langmuir-Blodgett (LB) method, or the like. When the hole injection layer 383 is formed using vacuum deposition, the deposition conditions may vary according to the compound that is used as the material for forming the hole injection layer, and the structure and thermal properties of the hole injection layer 383 to be formed. In general, however, conditions for the vacuum deposition may include a deposition temperature in a range of 100 to 500°C, a pressure in a range of $10^{-8}$ to $10^{-3}$ torr, and a deposition rate in a range of 0.01 to 100 Å/sec. When the hole injection layer 383 is formed using spin-coating, the coating conditions may vary according to the compound that is used as the material for forming the hole injection layer, and the structure and thermal properties of the hole injection layer 383 to be formed. In general, however, the coating rate may be from about 2000 to about 5000 rpm, and the temperature for heat treatment which is performed to remove a solvent after coating maybe from 80 to 200°C.

As the material for forming a hole injection layer, a compound represented by Formula 6 below may be used, but is not limited thereto:

Formula 6

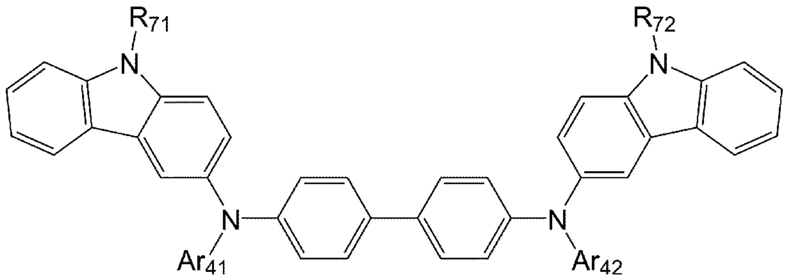

In Formula 6, $Ar_{41}$ and $Ar_{42}$ are each independently one of a substituted or unsubstituted $C_6$-$C_{30}$ arylene group and a substituted or unsubstituted $C_2$-$C_{30}$ heteroarylene group, $R_{71}$ and $R_{72}$ are each independently one of a hydrogen, a deuterium, a halogen, a hydroxy group, a cyano group, a nitro group, an amino group, an amidino group, a hydrazine, a hydrazone, a carboxyl group or a salt thereof, a sulfonic acid group or a salt thereof, a phosphoric acid group or a salt thereof, a substituted or unsubstituted $C_1$-$C_{30}$ alkyl group, a substituted or unsubstituted $C_2$-$C_{30}$ alkenyl group, a substituted or unsubstituted $C_2$-$C_{30}$ alkynyl group, a substituted or unsubstituted $C_1$-$C_{30}$ alkoxy group, a substituted or unsubstituted $C_3$-$C_{30}$ cycloalkyl group, a substituted or unsubstituted $C_6$-$C_{30}$ aryl group, a substituted or unsubstituted $C_6$-$C_{30}$ aryloxy group, and a substituted or unsubstituted $C_6$-$C_{30}$ arylthio group.

As the material for forming a hole injection layer, for example, the compound represented by Formula 6 above or a mixture of the compound represented by Formula 6 above and a commonly known material for forming a hole injection layer may be used.

The compound represented by Formula 6 above may be one of Compounds 301 to 308 below, but is not limited thereto.

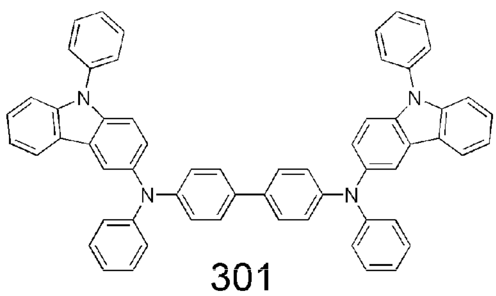
301

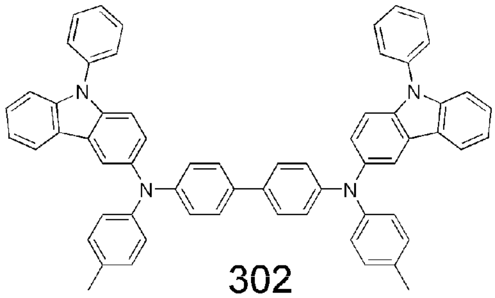
302

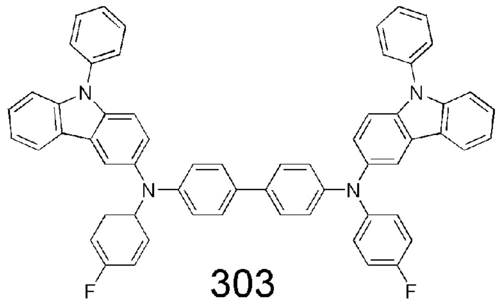
303

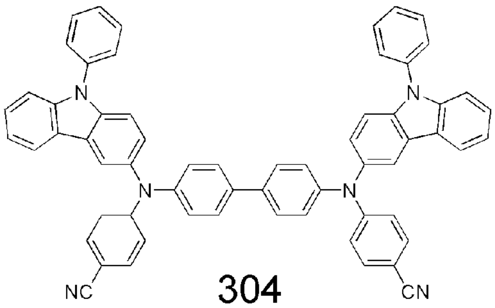
304

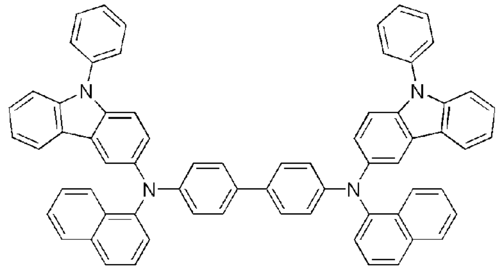

305

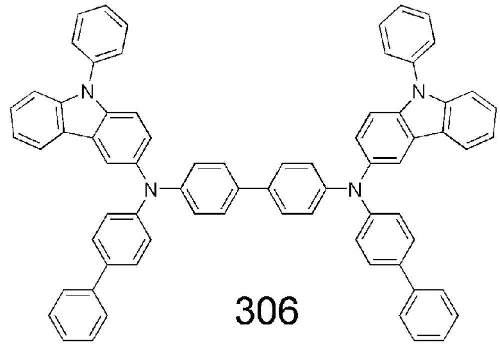

306

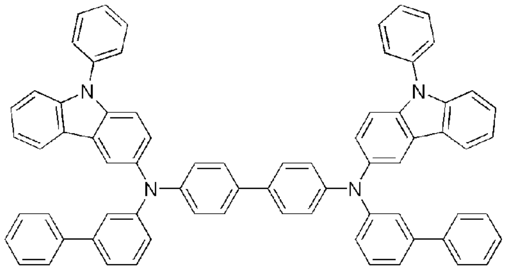

307

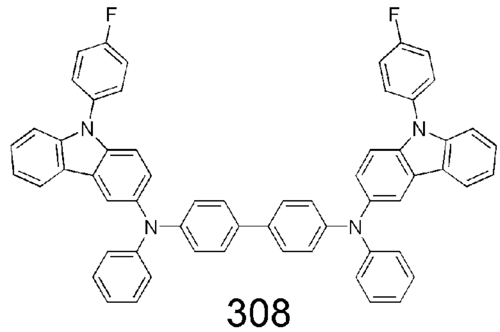

308

An example of the commonly known material for forming a hole injection layer may be N,N'-diphenyl-N,N'-bis-[4-(phenyl-m-tolyl-amino)-phenyl]-biphenyl-4,4'-diamine (DNTPD), a phthalocyanine compound such as copperphthalocyanine, 4,4',4"-tris (3-methylphenylphenylamino) triphenylamine (m-MTDATA), N,N'-di(1-naphthyl)-N,N'-diphenylbenzidine (NPB), TDATA, 2-TNATA, Polyaniline/Dodecylbenzenesulfonic acid (Pani/DBSA), Poly(3,4-ethylenedioxythiophene)/Poly(4-styrenesulfonate (PEDOT/PSS), Polyaniline/Camphor sulfonicacid (Pani/CSA), or Polyaniline)/Poly(4-styrenesulfonate) (PANI/PSS), but is not limited thereto.

The thickness of the hole injection layer 383 may be in the range of 100 Å to 10000 Å, for example, 100 Å to 1000 Å. If the thickness of the hole injection layer 383 is within the range described above, an excellent hole injecting ability may be obtained without a substantial increase of driving voltage.

Next, the hole transport layer 385 may be formed on the hole injection layer 383 by using vacuum deposition, spin coating, casting, a LB method, or the like. When the hole transport layer 385 is formed by vacuum deposition or spin coating, although the conditions for the deposition and coating may vary according to the material that is used for forming a hole transport layer, generally the conditions for deposition and coating may be similar to those for the formation of the hole injection layer 383.

For a material for forming a hole transport layer, a compound represented by Formula 5 below may be used, but is not limited thereto:

Formula 5

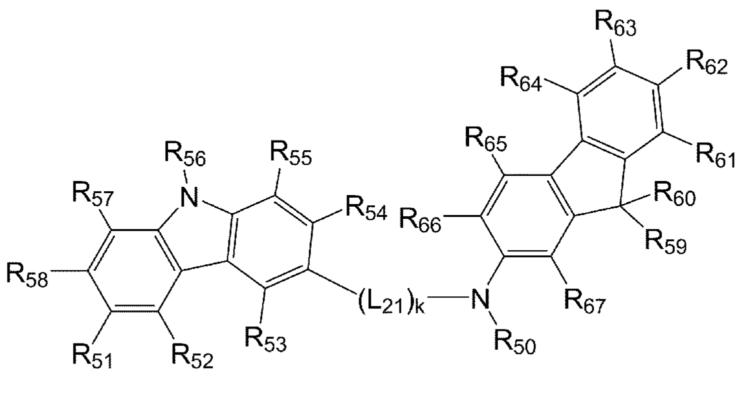

In Formula 5, $R_{50}$ is one of a substituted or unsubstituted phenyl group, a substituted or unsubstituted naphthyl

group, a substituted or unsubstituted anthryl group, a substituted or unsubstituted biphenyl group, and a substituted or unsubstituted pyridyl group; L21 is one of a substituted or unsubstituted $C_1$-$C_{30}$ alkylene group, a substituted or unsubstituted $C_2$-$C_{30}$ alkenylene group, a substituted or unsubstituted $C_6$-$C_{30}$ arylene group, and a substituted or unsubstituted $C_2$-$C_{30}$ heteroarylene group; $R_{51}$ to $R_{67}$ are each independently one of a hydrogen, a deuterium, a halogen, a hydroxy group, a cyano group, a nitro group, a carboxyl group, a substituted or unsubstituted $C_1$-$C_{30}$ alkyl group, a substituted or unsubstituted C2-$C_{30}$ alkenyl group, a substituted or unsubstituted $C_2$-$C_{30}$ alkynyl group, a substituted or unsubstituted $C_1$-$C_{30}$ alkoxy group, a substituted or unsubstituted $C_1$-$C_{30}$ alkylthiol group, a substituted or unsubstituted $C_3$-$C_{30}$ cycloalkyl group, a substituted or unsubstituted $C_3$-$C_{30}$ cycloalkenyl group, a substituted or unsubstituted $C_6$-$C_{30}$ aryl group, a substituted or unsubstituted $C_6$-$C_{30}$ aryloxy group, a substituted or unsubstituted $C_6$-$C_{30}$ arylthio group, a substituted or unsubstituted $C_2$-$C_{30}$ heteroaryl group, and a group represented by - $N(Q_{11})(Q_{12})$; and k is 0, 1, 2 or 3.

In -$N(Q_{11})(Q_{12})$, $Q_{11}$ and Q12 are each independently one of a hydrogen, a deuterium, a halogen, a hydroxy group, a cyano group, an amino group, a nitro group, a carboxyl group, a $C_1$-$C_{30}$ alkyl group, a $C_2$-$C_{30}$ alkenyl group, a $C_2$-$C_{30}$ alkynyl group, a $C_1$-$C_{30}$ alkoxy group, a $C_1$-$C_{30}$ alkylthiol group, a $C_3$-$C_{30}$ cycloalkyl group, a $C_3$-$C_{30}$ cycloalkenyl group, a $C_6$-$C_{30}$ aryl group, a $C_6$-$C_{30}$ aryloxy group, a $C_6$-$C_{30}$ arylthio group, and a $C_2$-$C_{30}$ heteroaryl group.

In Formula 5, when k is 0, -$(L_{21})_k$- indicates a single bond, and when k is 2 or greater, a plurality of L21 may be identical to or different from each other.

As the material for forming a hole transport layer, for example, the compound represented by Formula 5 above or a mixture of the compound represented by Formula 5 above and a commonly known material for forming a hole transport layer may be used.

The compound represented by Formula 5 above may be one of Compounds 309 to 320 below, but is not limited thereto:

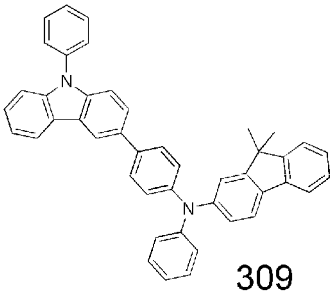
309

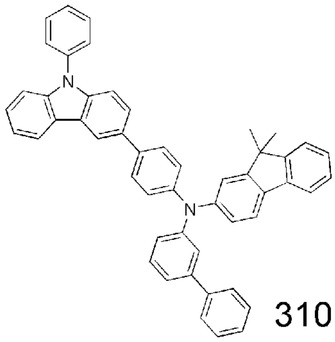
310

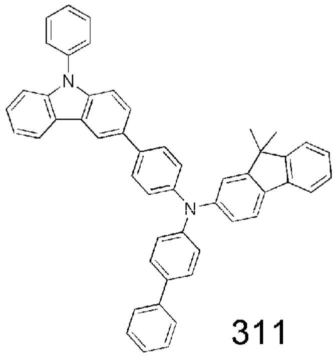
311

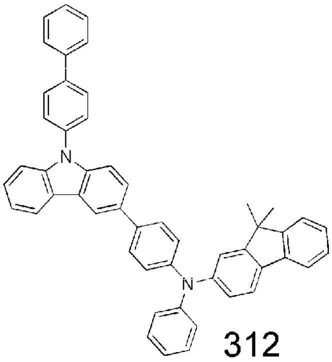
312

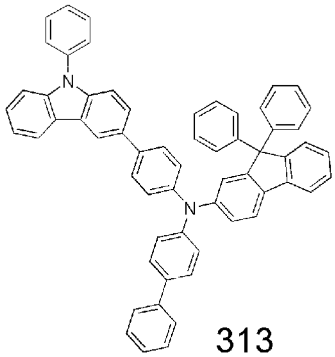
313

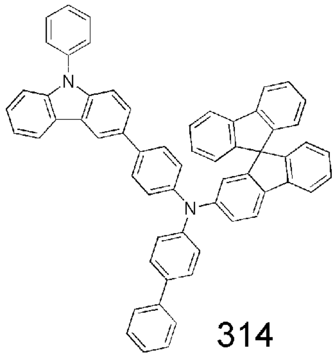
314

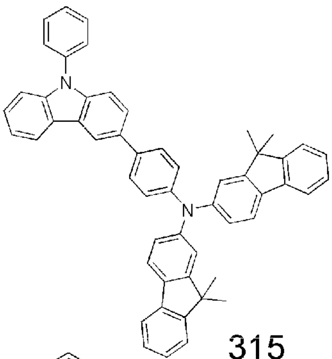
315

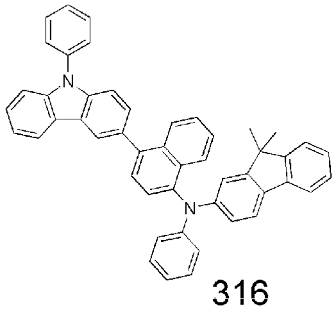
316

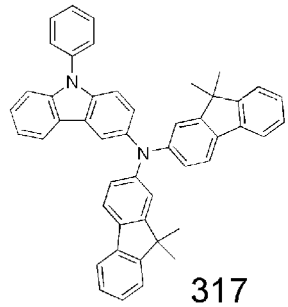
317

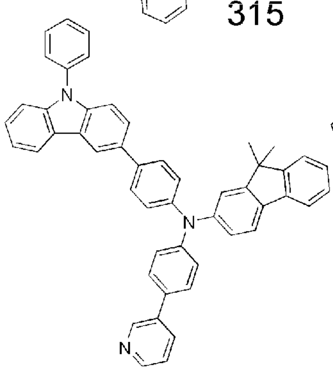
318

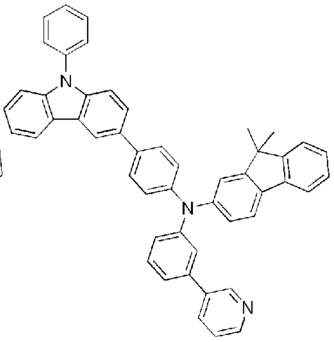
319

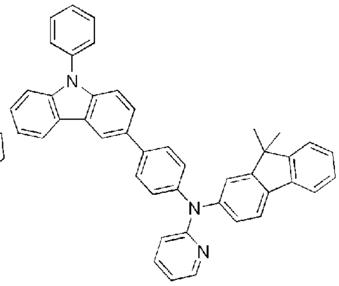
320

An example of the commonly known material for forming a hole transport layer may be a carbazole derivative such as N-phenylcarbazole, polyvinylcarbazole, or the like, N,N'-bis(3-methylphenyl)-N,N'-diphenyl-[1,1-biphenyl]-4,4'-diamine (TPD), 4,4',4"-tris(N-carbazolyl)triphenylamine (TCTA), N,N'-di(1-naphthyl)-N,N'-diphenylbenzidine (NPB), or the like, but is not limite thereto. The thickness of the hole transport layer 385 may be in a range from about 50 Å to about 2000 Å, for example, from about 100 Å to about 1500 Å. If the thickness of the hole transport layer 385 is within the range described above, an excellent hole transportation ability may be obtained without a substantial increase of driving voltage.

On the first electrode 330, one of the hole injection layer 383 and the hole transport layer 385 may be formed and the other may be omitted, or at least one of the hole injection layer 383 and the hole transport layer 385 may be formed in a form of multiple layers. Alternatively, a functional layer (not shown) having hole injection and transport ability

may be disposed on the first electrode 330 instead of a hole injection layer and a hole transport layer. The functional layer having hole injection and transport ability may be formed with at least one of the compound represented by Formula 5, a mixture of the compound represented by Formula 5 and the material for forming a hole transport layer, the compound represented by Formula 6, and a mixture of the compound represented by Formula 6 and the material for forming a hole injection layer. Also, the thickness of the functional layer may be in a range from 500 Å to 10000 Å, for example, from 100 Å to 1000 Å. If the thickness of the functional layer is within the range described above, an excellent hole injection and transportation ability may be obtained without a substantial increase of driving voltage.

The emission layer 360 may be formed on the hole transport layer 385 or the functional layer (not shown) having hole injection and transport ability by using vacuum deposition, spin coating, casting, a LB method, or the like. When the emission layer 360 is formed by using a vacuum deposition and a spin coating, although the conditions for the deposition and coating may vary according to the compound that is used for forming the emission layer 360, generally the conditions for deposition and coating may be similar to those for the formation of the hole injection layer 383.

As a host material of the emission layer 360, a bipolar compound having both a hole transport unit and an electron transport unit may be used. A "hole transport unit" refers to a unit including a functional group with an excellent hole transporting ability which may be, for example, a unit including a fluorine derivative, a unit including a carbazole derivative, a unit including a dibenzothiophene derivative, or a unit including a dibenzofuran derivative. An "electron transport unit" refers to a unit including a functional group with an excellent electron transporting ability which may be, for example, a unit including a pyridine derivative, a unit including a pyrimidine derivative, or a unit including a triazine derivative. If the bipolar compound having both a hole transport unit and an electron transport unit is used as the host material, a reduction of luminous efficiency may well occur as electrons and holes in the host material at a low luminance region are unbalanced due to the electron control layer 371.

Alternatively, as the host material of the emission layer 360, a mixture of a bipolar compound having both a hole transport unit and an electron transport unit and a compound having at least a hole transport unit may be used. If a compound having at least a hole transport unit is further added to the bipolar compound as the host material, a further reduction of luminous efficiency may well occur as electrons and holes in the host material at a low luminance region are further unbalanced since hole characteristics of the host material are further increased. A mixture ratio of the bipolar compound and the compound having at least a hole transport unit may be from 1:1 to 1:9. If the mixture ratio of the bipolar compound and the compound having at least a hole transport unit is in the range above, imbalance of electrons and holes in the host material may be further increased.

For example, the host material may be one of Compounds 501 to 509 below:

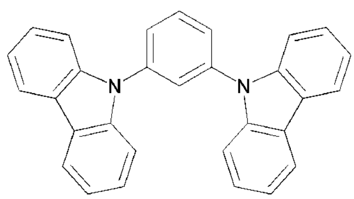

501

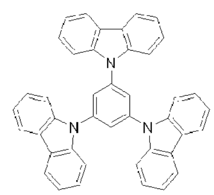

502

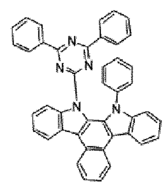

503

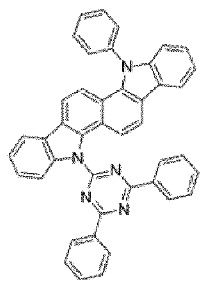

504

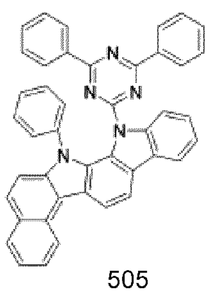

505

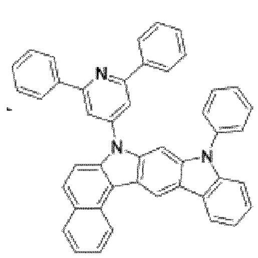

506

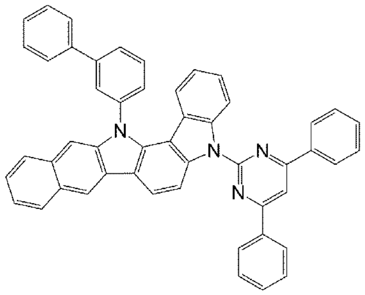
507

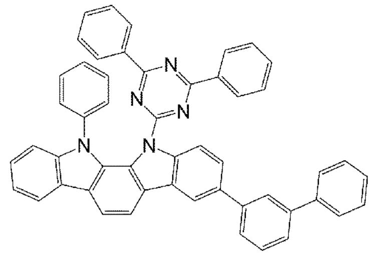
508

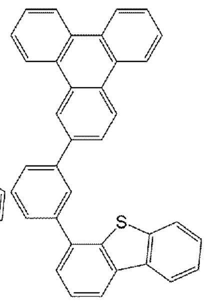
509

The emission layer 360 may be patterned to a red emission layer, a green emission layer, or a blue emission layer. At least one of a red emission layer, a green emission layer, and a blue emission layer may include a dopant, as below (ppy = phenylpyridine).

For example, the compounds below may be used as a blue dopant, but the invention is not limited thereto:

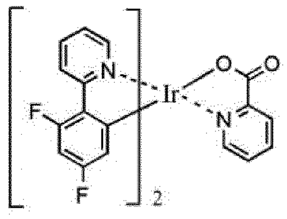
F2Irpic

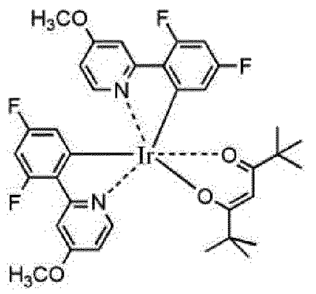
(F2ppy)2Ir(tmd)

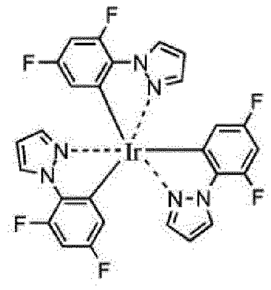
Ir(dfppz)3

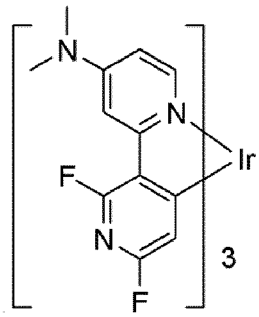

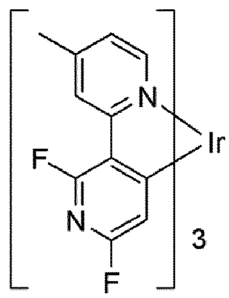

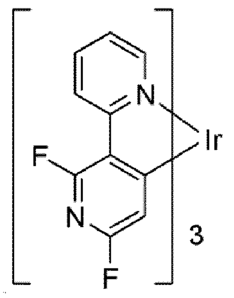

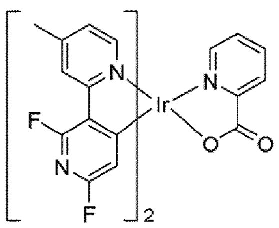

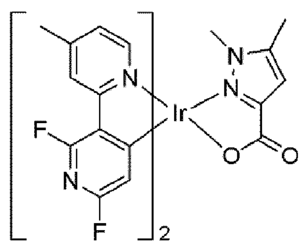

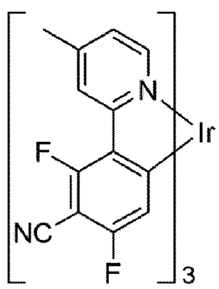

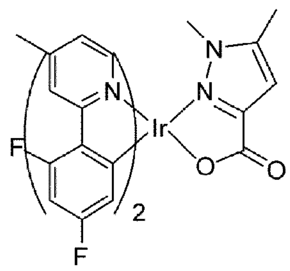

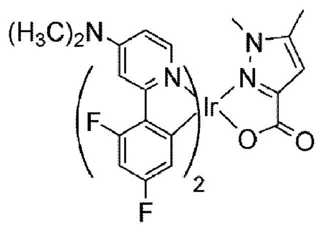

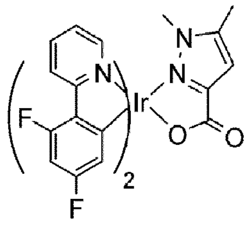

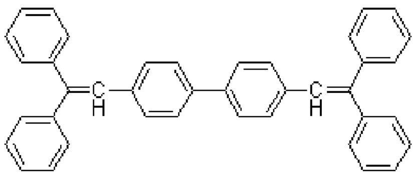

**DPVBi**

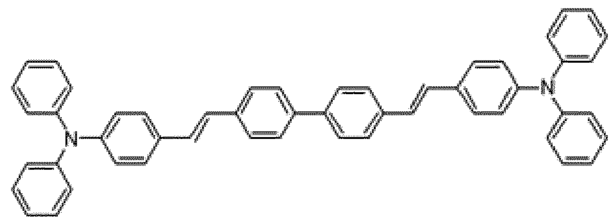

DPAVBi

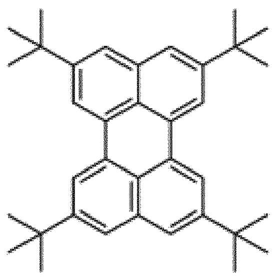

TBPe

For example, the compounds below may be used as a red dopant, but the invention is not limited thereto:

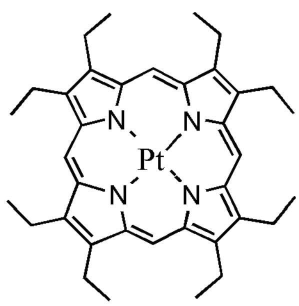

**PtOEP**

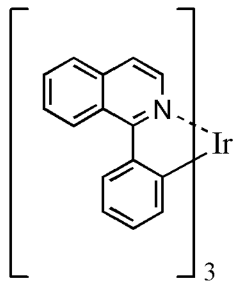

**$Ir(piq)_3$**

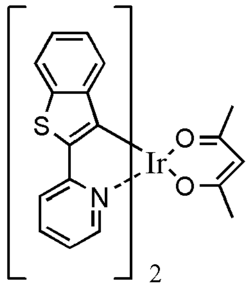

**$Btp_2Ir(acac)$**

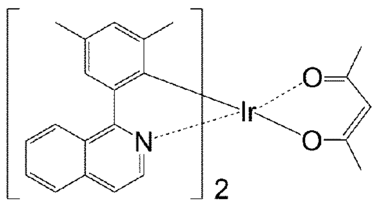

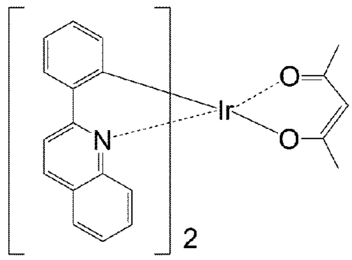

Ir(pq)$_2$(acac)

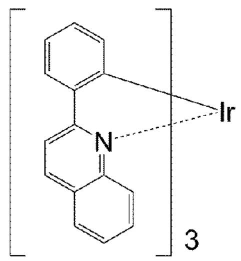

Ir(2-phq)$_3$

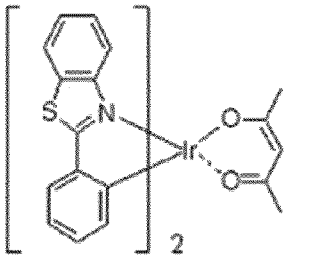

Ir(BT)$_2$(acac)

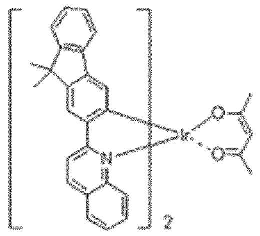

Ir(flq)$_2$(acac)

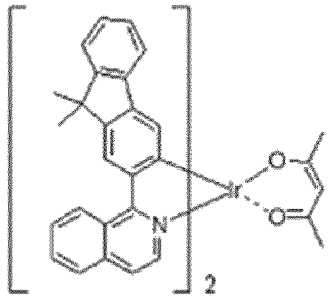

Ir(fliq)$_2$(acac)

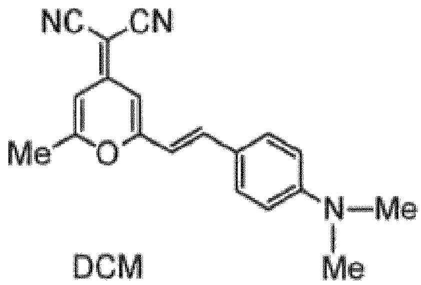

DCM

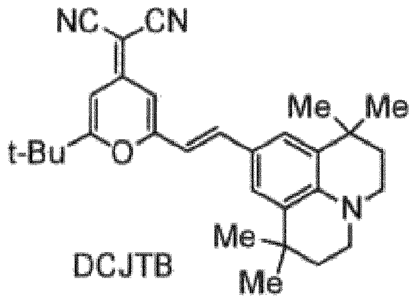

DCJTB

For example, the compounds below may be used as a green dopant, but the invention is not limited thereto:

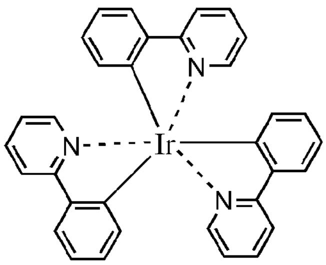

**Ir(ppy)$_3$**

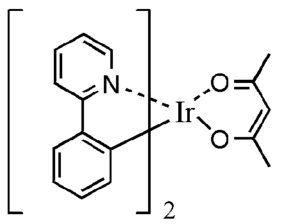

**Ir(ppy)$_2$(acac)**

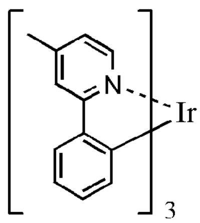

**Ir(mpyp)$_3$**

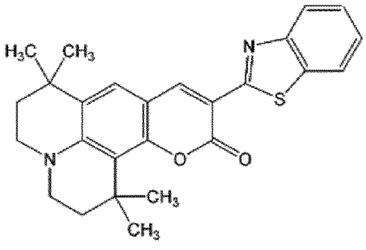

C545T

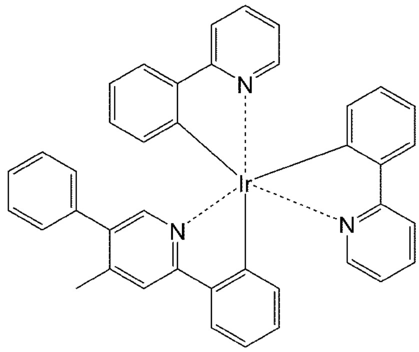

For example, a dopant that may be included in the emission layer 360 may be one of the Pt-complexes below, but is not limited thereto:

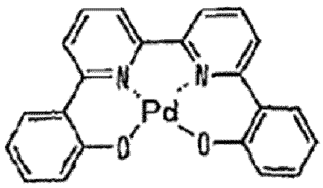

D1

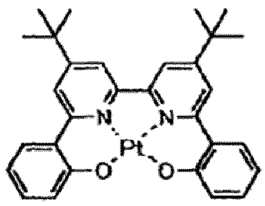

D2

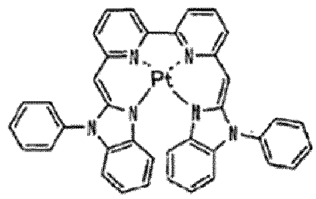

D3

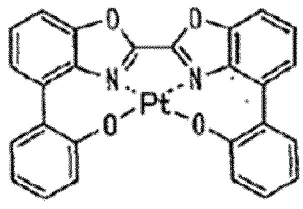

D4

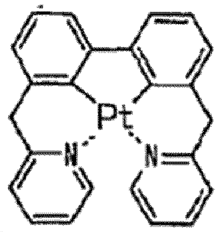

D5

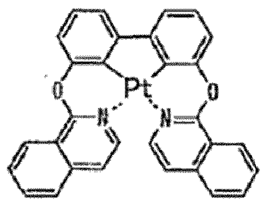

D6

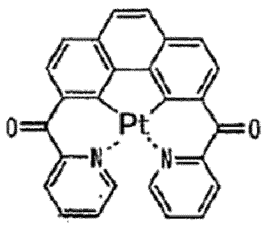

D7

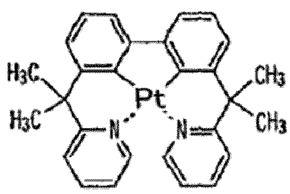

D8

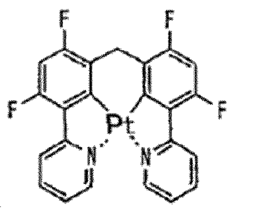

D9

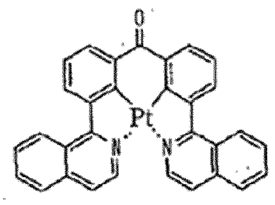

D10

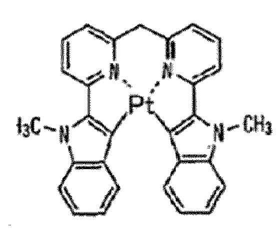

D11

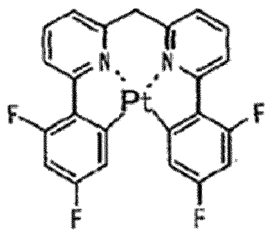

D12

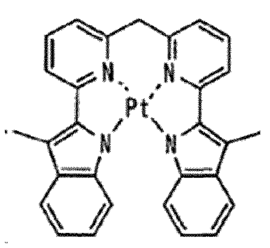

D13

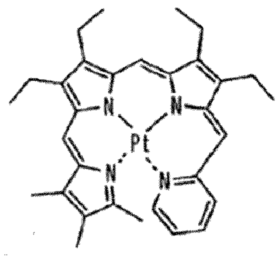

D14

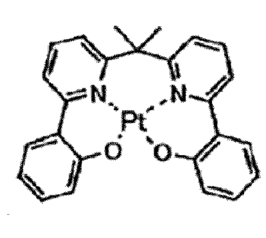

D15

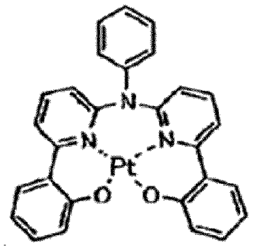

D16

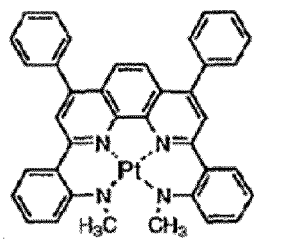

D17

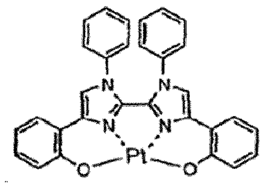

D18

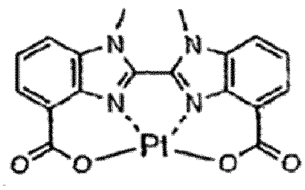

D19

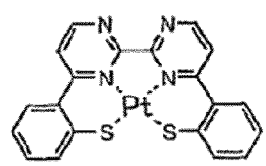

D20

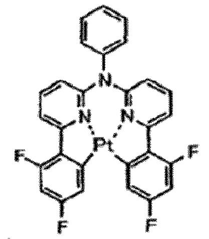

D21

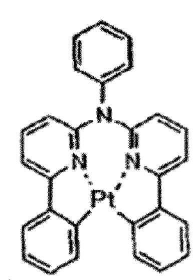

D22

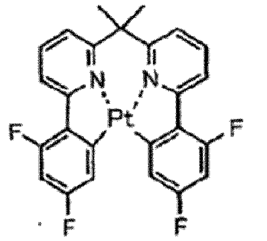

D23

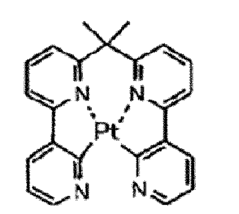

D24

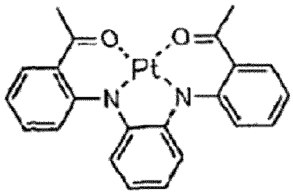

D25

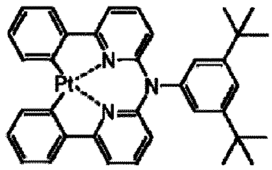

D26

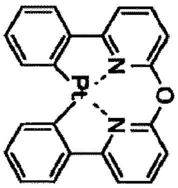

D27

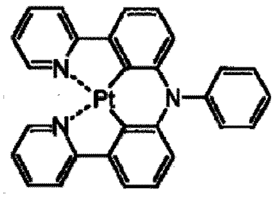

D28

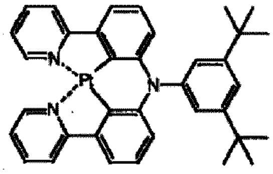

D29

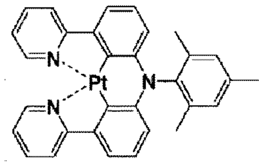

D30

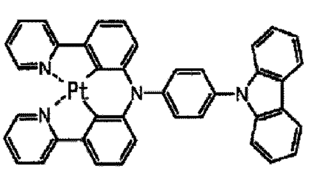

D31

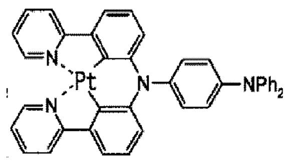

D32

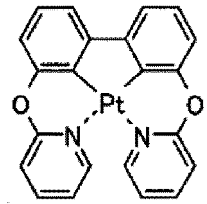

D33

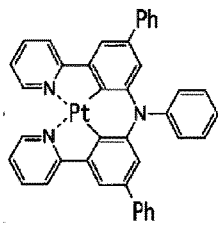

D34

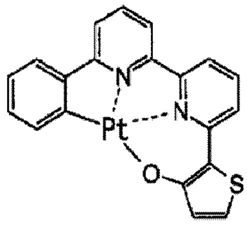

D35

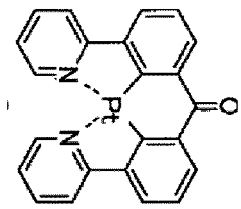

D36

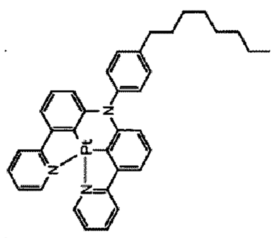

D37

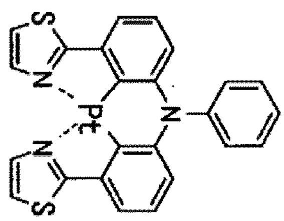

D38

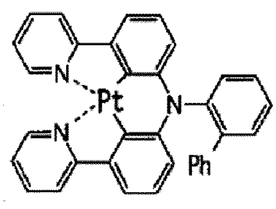

D39

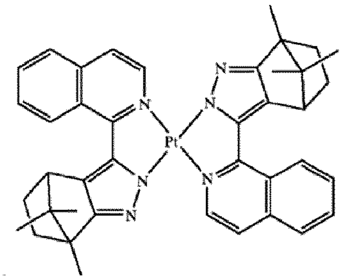

D40

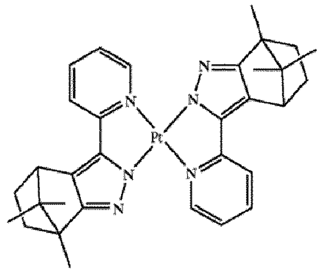

D41

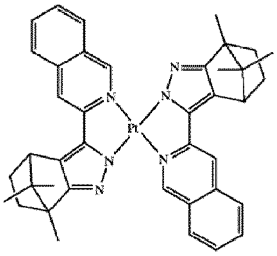

D42

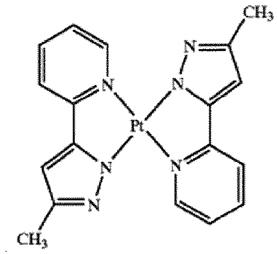

D43

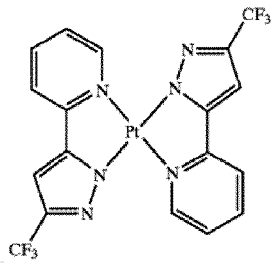

D44

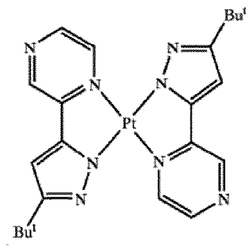

D45

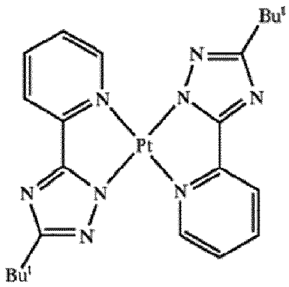

D46

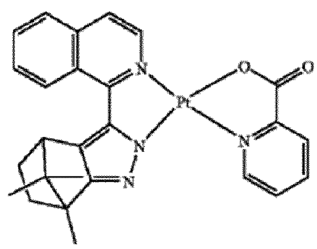

D47

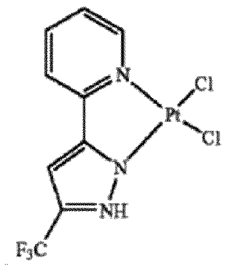

D48

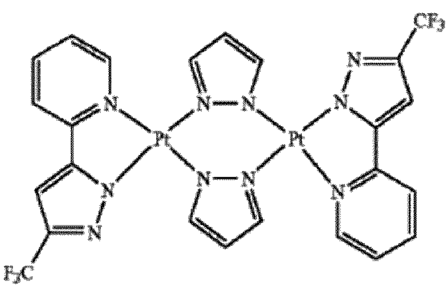

D49

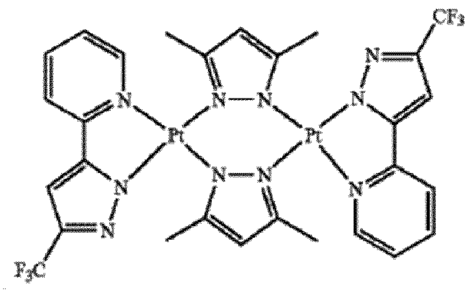

D50

Also, a dopant that may be included in the emission layer 360 may be one of the Os-complexes below, but is not limited thereto:

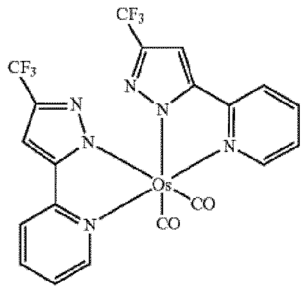

$Os(fppz)_2(CO)_2$

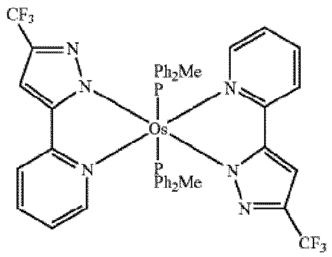

$Os(fppz)_2(PPh_2Me)_2$

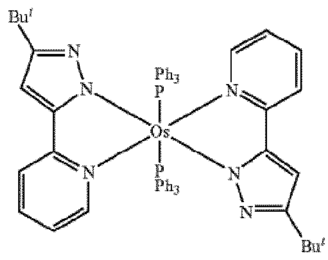

$Os(bppz)_2(PPh_3)_2$

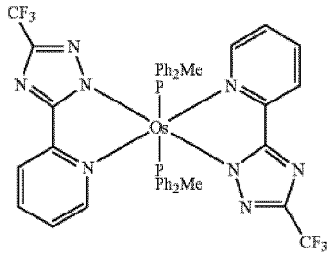

$Os(fptz)_2(PPh_2Me)_2$

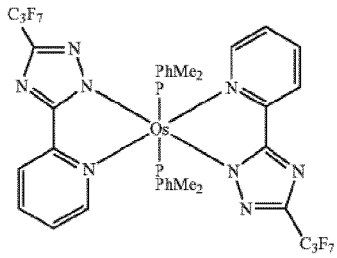

$Os(hptz)_2(PPhMe_2)_2$

If the emission layer 360 includes a host material and a dopant material, the content of the dopant material may be in the range from 0.01 to 25 parts by weight based on 100 parts by weight of the host material, but is not limited thereto.

The thickness of the emission layer may be in the range from 100 Å to 1000 Å, for example, from 200 Å to 600 Å. For example, if the thickness of the emission layer 360 is in the range above, an excellent light-emitting ability may be obtained without a substantial increase of driving voltage.

Next, the electron control layer 371 may be formed on the emission layer 360 by using vacuum deposition, spin coating, casting, or the like. When the electron control layer 371 is formed by using vacuum deposition or spin coating, although the conditions for the deposition and coating may vary according to the compound that is used for forming the electron control layer 371, generally the conditions for deposition and coating may be similar to those for the formation of the hole injection layer 383. As a material for forming the electron control layer 371, the electron control material satisfying the molecular orbital energy level described above may be used. The thickness of the electron control layer 371 may be in the range from 50 Å to 450 Å, and the thickness ratio of the electron transport layer 373 and the electron control layer 371 maybe selected in the range from 5:1 to 5:10.

The electron transport layer 373 is formed on the electron control layer 371 by using vacuum deposition, spin coating, casting, or the like. When the electron transport layer 373 is formed by using vacuum deposition or spin coating, although conditions for the deposition and coating may vary according to the compound that is used for forming the electron transport layer 373, generally the conditions for deposition and coating may be similar to those for the formation of the hole injection layer 383. As a material for forming an electron transport layer, a compound represented by Formula 4 below which serves to stably transport the electrons injected from an electron injection electrode (cathode) may be used, but is not limited thereto:

Formula 4

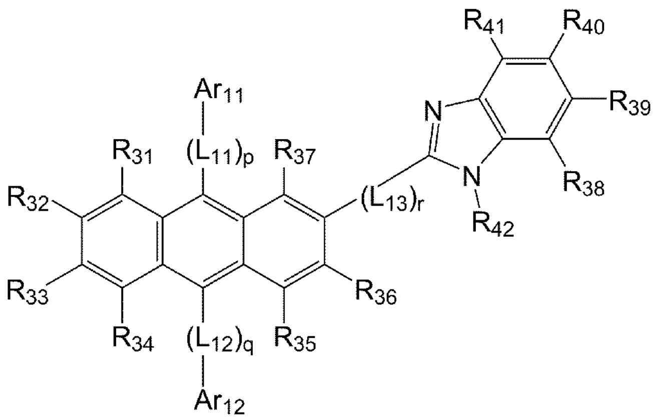

In Formula 4, $R_{31}$ to $R_{42}$ are each independently one of a hydrogen, a deuterium, a substituted or unsubstituted methyl group, a substituted or unsubstituted ethyl group, a substituted or unsubstituted propyl group, a substituted or unsubstituted butyl group, a substituted or unsubstituted phenyl group, a substituted or unsubstituted biphenyl group, a substituted or unsubstituted naphthyl group, a substituted or unsubstituted anthryl, a substituted or unsubstituted phenanthrenyl, a substituted or unsubstituted pyrenyl group, $Ar_{11}$ and $Ar_{12}$ are each independently one of a substituted or unsubstituted phenyl group, a substituted or unsubstituted pentalenyl group, a substituted or unsubstituted indenyl group, a substituted or unsubstituted naphtyl group, a substituted or unsubstituted azulenyl group, a substituted or unsubstituted heptalenyl group, a substituted or unsubstituted indacenyl group, a substituted or unsubstituted acenaphtyl group, a substituted or unsubstituted fluorenyl group, a substituted or unsubstituted spirofluorenyl group, a substituted or unsubstituted phenalenyl group, a substituted or unsubstituted phenanthrenyl group, a substituted or unsubstituted anthryl group, a substituted or unsubstituted fluoranthenyl group, a substituted or unsubstituted triphenylenyl group, a substituted or unsubstituted pyrenyl group, a substituted or unsubstituted chrysenyl group, a substituted or unsubstituted naphthacenyl group. a substituted or unsubstituted picenyl group, a substituted or unsubstituted perylenyl group, a substituted or unsubstituted pentaphenyl group, a substituted or unsubstituted hexacenyl group, a substituted or unsubstituted pyrrolyl group, a substituted or unsubstituted imidazolyl group, a substituted or unsubstituted pyrazolyl group, a substituted or unsubstituted pyridinyl group, a substituted or unsubstituted bipyridinyl group, a substituted or unsubstituted pyrazinyl group, a substituted or unsubstituted pyrimidinyl group, a substituted or unsubstituted pyridazinyl group, a substituted or unsubstituted isoindolyl group, a substituted or unsubstituted indolyl group, a substituted or unsubstituted indazolyl group, a substituted or unsubstituted purinyl group, a substituted or unsubstituted quinolinyl group, a substituted or unsubstituted benzoquinolinyl group, a substituted or unsubstituted phthalazinyl group, a substituted or unsubstituted naphthyridinyl group, a substituted or unsubstituted quinoxalinyl group, a substituted or unsubstituted quinazolinyl group, a substituted or unsubstituted cinnolinyl group, a substituted or unsubstituted carbazolyl group, a substituted or unsubstituted phenanthridinyl group, a substituted or unsubstituted acridinyl group, a substituted or unsubstituted phenanthrolinyl group, a substituted or unsubstituted phenazinyl group, a substituted or unsubstituted benzooxazolyl group, a substituted or unsubstituted benzoimidazolyl group, a substituted or unsubstituted furanyl group, a substituted or unsubstituted benzofuranyl group, a substituted or unsubstituted thiophenyl group, a substituted or unsubstituted benzothiophenyl group, a substituted or unsubstituted thiazolyl group, a substituted or unsubstituted isothiazolyl group, a substituted or unsubstituted benzothiazolyl group, a substituted or unsubstituted isoxazolyl group, a substituted or unsubstituted oxazolyl group, a substituted or unsubstituted triazolyl group, a substituted or unsubstituted tetrazolyl group, a substituted or unsubstituted oxadiazolyl group, a substituted or unsubstituted triazinyl group, a substituted or unsubstituted benzooxazolyl group, a substituted or unsubstituted dibenzopuranyl group, a substituted or unsubstituted dibenzothiophenyl group, and a substituted or unsubstituted bezocarbazolyl group, $L_{11}$, L12 ,and $L_{13}$ are each independently one of a substituted or unsubstituted phenylene group, a substituted or unsubstituted pentalenylene group, a substituted or unsubstituted indenylene group, a substituted or unsubstituted naphthylene group, a substituted or unsubstituted azulenylene group, a substituted or unsubstituted heptalenylene group, a substituted or unsubstituted indacenylene group, a substituted or unsubstituted acenaphthylene group, a substituted or unsubstituted fluorenylene group, a substituted or unsubstituted phenalenylene group, a substituted or unsubstituted phenanthrenylene group, a substituted or unsubstituted anthrylene group, a substituted or unsubstituted fluoranthenylene group, a substituted or unsubstituted triphenylenylene group, a substituted or unsubstituted pyrenylene group, a substituted or unsubstituted chrysenylene group, a substituted or unsubstituted naphthacenylene group, a substituted or unsubstituted picenylene group, a substituted or unsubstituted perylenylene group, a substituted or unsubstituted pentaphenylene group, a substituted or unsubstituted hexacenylene group, a substituted or unsubstituted pyrrolylene group, a substituted or unsubstituted

pyrazolylene group, a substituted or unsubstituted imidazolylene group, a substituted or unsubstituted imidazolinylene group, a substituted or unsubstituted imidazopyridinylene group, a substituted or unsubstituted imidazopyrimidinylene group, a substituted or unsubstituted pyridinylene group, a substituted or unsubstituted pyrazinylene group, a substituted or unsubstituted pyrimidinylene group, a substituted or unsubstituted indolylene group, a substituted or unsubstituted purinylene group, a substituted or unsubstituted quinolinylene group, a substituted or unsubstituted phthalazinylene group, a substituted or unsubstituted indolizinylene group, a substituted or unsubstituted naphthyridinylene group, a substituted or unsubstituted quinazolinylene group, a substituted or unsubstituted cinnolinylene group, a substituted or unsubstituted indazolylene group, a substituted or unsubstituted carbazolylene group, a substituted or unsubstituted phenazinylene group, a substituted or unsubstituted phenanthridinylene group, a substituted or unsubstituted pyranylene group, a substituted or unsubstituted chromenylene group, a substituted or unsubstituted furanylene group, a substituted or unsubstituted benzofuranylene group, a substituted or unsubstituted thiophenylene group, a substituted or unsubstituted benzothiophenylene group, a substituted or unsubstituted isothiazolylene group, a substituted or unsubstituted benzoimidazolylene group, a substituted or unsubstituted isoxazolylene group, a substituted or unsubstituted dibenzothiophenylene group, a substituted or unsubstituted dibenzopuranylene group, a substituted or unsubstituted triazinylene group, and a substituted or unsubstituted oxadiazolylene group, and p, q, and r are each independently 0 or 1.

In Formula 4, when p, q, and r are each independently 0, $-(L_{11})_p-$, $-(L_{12})_q-$ , and $-(L_{13})_r-$ each independently represents a single bond.

For example, as the material for forming an electron transport layer, the compound represented by Formula 4 above or a mixture of the compound represented by Formula 4 above and a commonly known material for forming an electron transport layer may be used.

The compound represented by Formula 4 above may be Compound 201 below, but is not limited thereto:

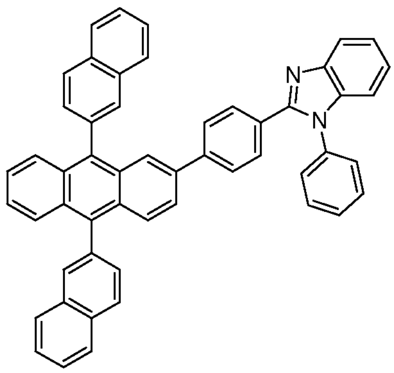

An example of the commonly known material for an electron transport layer may be a material such as a quinoline derivative, particularly tris(8-quinolinolato)aluminum ($Alq_3$), TAZ, Balq, beryllium bis(benzoquinolin-10-olate (Bebq2), or ADN, but is not limited thereto.

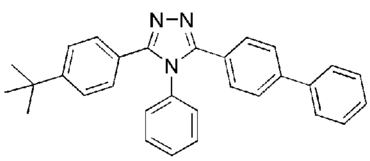

TAZ

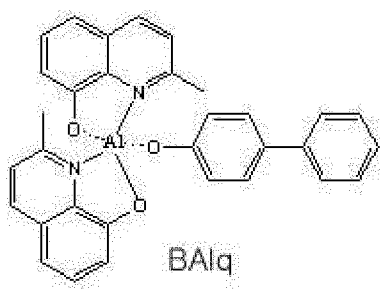

BAlq

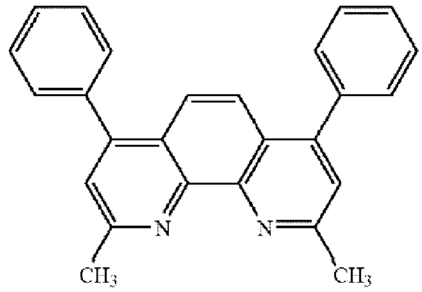

BCP

In some embodiments, the thickness of the electron transport layer 373 may be in the range from 50 Å to 1000 Å, for example, from 100 Å to 500 Å. If the thickness of the electron transport layer 373 is within the range above, an excellent electron transporting ability may be obtained without a substantial increase of driving voltage.
The electron transport layer 373 may further include a metal-containing compound as well as the compound represented by Formula 4 above.
The metal-containing compound may be a Li-complex. The Li-complex may be, for example, a lithium quinolate (LiQ), Compound 101 below, or the like:

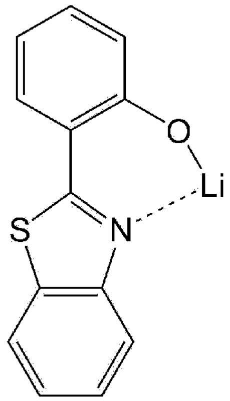

101

The electron transport layer 373 may further include at least one selected from 1,4,5,8,9,12-hexaazatriphenylene hexacarbonitrile, tetracyanoquinodimethane, anthraquinone, perylenebisimide, and tetracyanoanthraquinodimethane as well as the compound represented by Formula 4.
The electron transport layer 373 may further include at least one selected from at least one metal selected from Li, Cs, Na, K, Ca, Mg, Ba, and Ra; a carbonate, acetate, benzoate, acetoacetate, aceetylacetonate and a stearate thereof; as well as the compound represented by Formula 4.
If the electron transport layer 373 includes one or more of the materials described above as well as the compound represented by Formula 4, electron injection and transportation ability may be improved.
The electron injection layer 375 which serves to accelerate injection of electrons from the cathode may be disposed on the electron transport layer 373, and the material for the electron injection layer 375 is not particularly limited.
As a material for forming an electron injection layer, a commonly known material such as LiF, NaCl, CsF, $Li_2O$, BaO, or the like may be used. Although conditions for deposition and coating may vary according to the compound that is used for forming the electron injection layer 375, generally the conditions for deposition and coating may be similar to those for the formation of the hole injection layer 383.
The thickness of the electron injection layer 375 may be in the range from 1 Å to 100 Å, for example, from 3 Å to 90 Å. If the thickness of the electron injection layer 375 is within the range above, an excellent electron injecting ability may be obtained without a substantial increase of driving voltage.
The second electrode 390 is disposed on the organic layer 350. The second electrode 390 may be the cathode which is an electron injecting electrode, and a material used for forming a second electrode may be a metal, an alloy, a conductive compound, or a mixture thereof which has a low work-function. For example, a Li, Mg, Al, Al-Li, Ca, Mg-In, or Mg-Ag material may be formed as a thin film to obtain a transparent electrode. Meanwhile, various modifications

such as forming a transmissive electrode using ITO or IZO in order to obtain a top-emission device are possible.

The OLED 300 having such construction may have an excellent luminous efficiency at a high luminance region and a low luminous efficiency at a low luminance region since the flow of electrons injected from the electron transport layer 373 to the emission layer 360 is controlled due to the effect of the electron control layer 371.

FIG. 4 is a schematic cross-sectional view of an OLED 400 having a structure of a substrate 410 / a first electrode 430 / a hole injection layer 483 / a hole transport layer 485 / an electron blocking layer 481 / an emission layer 460 / an electron control layer 471 / an electron transport layer 473 / an electron injection layer 475 / a second electrode 490 according to an embodiment.

The detailed description of the substrate 410, the first electrode 430, the hole injection layer 483, the hole transport layer 485, the emission layer 460, the electron control layer 471, the electron transport layer 473, the electron injection layer 475, and the second electrode 490 may be referred to the description of FIG. 3.

The electron blocking layer 481 may be disposed between at least one of the hole injection layer 483, the hole transport layer 485, and a functional layer (not shown) having hole injection and transport ability, and the emission layer 460. The electron blocking layer 481 may serve to prevent electrons that are not combined with holes in the emission layer 460 from moving in a direction to the first electrode 430. The electron blocking layer 481 may be formed using the electron blocking material, and the electron blocking material may be, for example, at least one of a triphenylamine derivative, a carbazole derivative, or a spirobifluorene derivative.

In some embodiments, the thickness of the electron blocking layer 481 may be in the range from 10 Å to 1000 Å, for example, from 50 Å to 800 Å. If the thickness of the electron blocking layer 481 is within the range above, an excellent electron blocking ability may be obtained without a substantial increase of driving voltage.

The OLED 400 having such construction may have an excellent luminous efficiency at a high luminance region and a low luminous efficiency at a low luminance region since a flow of electrons injected from the electron transport layer 473 to the emission layer 460 is controlled due to an effect of the electron control layer 471 and the electron blocking layer 481.

FIG. 5 schematically illustrates HOMO energy level and LUMO energy level of each layer in the OLED 300 shown in FIG. 3.

The HOMO energy level of the electron control layer 371 including the electron control material is lower than HOMO energy level of the emission layer 360 including the host material, and the difference therebetween is about 0.3 eV or less. Also, the LUMO energy level of the emission layer 360 is lower than the HOMO energy level of the emission layer 360, and the difference therebetween is about 0.5 eV or less.

Due to such relationships, luminance of a device is improved by the electron control layer 371 blocking holes from passing through the electron control layer 371 from the emission layer 360 at a high luminance region, and luminance of a device is lowered by the electron control layer 371 facilitating the passage of holes from the emission layer 360 to the electron transport layer 371 through the electron control layer 371 at a low luminance region.

FIG. 6 schematically illustrates the HOMO energy level and LUMO energy level of each layer in the OLED 400 shown in FIG. 4.

The HOMO energy level of the electron control layer 471 including the electron control material is lower than the HOMO energy level of the emission layer 460 including the host material, and the difference therebetween is 0.3 eV or less. Also, the LUMO energy level of the emission layer 460 is lower than the HOMO energy level of the emission layer 460, and the difference therebetween is 0.5 eV or less.

In some embodiments, the electron blocking layer 481 including the electron blocking material is disposed between the emission layer 460 and the first electrode 430 and, in this case, is close to the emission layer 460. The LUMO energy level of the electron blocking layer 481 is higher than the LUMO energy of the emission layer 460.

Due to such relationships, luminance of a device is improved by the electron control layer 471 blocking holes from passing through the electron control layer 471 from the emission layer 460 and the electron blocking layer 481 blocking electrons that are not combined with holes in the emission layer 460 from moving in a direction to the first electrode 430 at a high luminance region and luminance of a device is lowered by the electron transport layer 471 facilitating electrons to move from the emission layer 460 to the electron control layer 471 through the electron control layer 471 at a low luminance region.

An organic light-emitting display apparatus according to an aspect includes a transistor including source, drain, gate, and an active layer, and an OLED as described above, and a first electrode of the OLED is electrically connected to the source or the drain.

The active layer of the transistor may be an amorphous silicon layer, a crystalline silicon layer, an organic semiconductor layer, or an oxide semiconductor layer.

Such an OLED may have improved luminous efficiency characteristics according to luminance as emission of red and green light is suppressed in a black state.

As used herein, an example of "an unsubstituted $C_1$-$C_{30}$ alkyl group" (or "a $C_1$-$C_{30}$ alkyl group") may be a linear or branched alkyl group with 1 to 30 carbon atoms such as methyl, ethyl, propyl, isobutyl, sec-butyl, pentyl, iso-amyl, or

hexyl, and a substituted $C_1$-$C_{30}$ alkyl group refers to the unsubstituted $C_1$-$C_{30}$ alkyl group in which at least one hydrogen is substituted with a deuterium, a halogen, a hydroxyl group, a nitro group, a cyano group, an amino group, an amidino group, a hydrazine, a hydrazone, a carboxylic group or a salt thereof, a sulfonic acid group or a salt thereof, a phosphoric acid group or a salt thereof, a $C_1$-$C_{30}$ alkyl group, a $C_2$-$C_{30}$ alkenyl group, a $C_2$-$C_{30}$ alkynyl group, a $C_6$-$C_{30}$ aryl group, a C2-$C_{30}$ heteroaryl group, -N($Q_{101}$)($Q_{102}$), or Si($Q_{103}$)($Q_{104}$)($Q_{105}$)($Q_{106}$)- (here, $Q_{101}$ to $Q_{106}$ are each independently selected from the group consisting of a hydrogen, a $C_1$-$C_{30}$ alkyl group, a C2-$C_{30}$ alkenyl group, a $C_2$-$C_{30}$ alkynyl group, a $C_6$-$C_{30}$ aryl group, and a $C_2$-$C_{30}$ heteroaryl group).

As used herein, an unsubstituted $C_1$-$C_{30}$ alkoxy group (or a $C_1$-$C_{30}$ alkoxy group) has a formula represented by -OA, where A is the unsubstituted $C_1$-$C_{30}$ alkyl group as defined above. An example of the unsubstituted $C_1$-$C_{50}$ alkoxy group may be methoxy, ethoxy, or isopropyloxy. The substituted $C_1$-$C_{30}$ alkoxy group refers to a $C_1$-$C_{30}$ alkoxy group in which at least one hydrogen is substituted with any one of the substituents presented in the case of the substituted $C_1$-$C_{30}$ alkyl group, which is described above.

As used herein, an unsubstituted $C_2$-$C_{30}$ alkenyl group (or a $C_2$-$C_{30}$ alkenyl group) refers to the unsubstituted $C_2$-$C_{30}$ alkenyl group having one or more carbon-carbon double bonds at the center or at a terminal of the unsubstituted $C_2$-$C_{30}$ alkyl group. An example of the unsubstituted $C_2$-$C_{50}$ alkenyl group may be an ethenyl group, a propenyl group, or a butenyl group. The substituted $C_2$-$C_{30}$ alkenyl group refers to a $C_2$-$C_{30}$ alkenyl group in which at least one hydrogen is substituted with any one of the substituents presented in the case of the substituted $C_1$-$C_{30}$ alkyl group, which is described above.

As used herein, an unsubstituted $C_2$-$C_{30}$ alkynyl group (or a $C_2$-$C_{30}$ alkynyl group) refers to the unsubstituted $C_2$-$C_{30}$ alkynyl group having at least one carbon-carbon triple bond at the center or at a terminal of the substituted and unsubstituted $C_2$-$C_{30}$ alkyl group. The substituted $C_2$-$C_{30}$ alkynyl group refers to a $C_2$-$C_{30}$ alkynyl group in which at least one hydrogen is substituted with any one of the substituents presented in the case of the substituted $C_1$-$C_{30}$ alkyl group, which is described above.

As used herein, the unsubstituted $C_6$-$C_{30}$ aryl group refers to a monovalent group having a carbocyclic aromatic system in which the number of carbon atoms is 6 to 30, and the unsubstituted $C_6$-$C_{30}$ arylene group refers to a divalent group having a carbocyclic aromatic system in which the number of carbon atoms is 6 to 30. If the unsubstituted $C_6$-$C_{30}$ aryl group and the unsubstituted $C_6$-$C_{30}$ arylene group include two or more rings, the rings may be fused to one another. The substituted $C_6$-$C_{30}$ aryl group refers to a $C_6$-$C_{30}$ aryl group in which at least one hydrogen is substituted with any one of the substituents presented in the case of the substituted $C_1$-$C_{30}$ alkyl group, which is described above, and the substituted $C_6$-$C_{30}$ arylene group refers to a $C_6$-$C_{30}$ arylene group in which at least one hydrogen is substituted with any one of the substituents presented in the case of the substituted $C_1$-$C_{30}$ alkyl group, which is described above.

As used herein, the unsubstituted $C_2$-$C_{30}$ heteroaryl group refers to a monovalent group having a carbocyclic aromatic system with at least one ring having one or more heteroatoms selected from the group consisting of nitrogen (N), oxygen (O), phosphorous (P), and sulfur (S), and the rest of the ring atoms are C. The unsubstituted $C_2$-$C_{30}$ heteroarylene group refers to a divalent group having a carbocyclic aromatic system with at least one ring having one or more heteroatoms selected from the group consisting of N, O, P, and S, and the rest of the ring atoms are C. Here, if the unsubstituted $C_2$-$C_{30}$ heteroaryl group and the unsubstituted $C_2$-$C_{30}$ heteroarylene group include two or more rings, the rings may be fused to one another. The substituted $C_2$-$C_{30}$ heteroaryl group refers to a $C_2$-$C_{30}$ heteroaryl group in which at least one hydrogen is substituted with any one of the substituents presented in the case of the substituted $C_1$-$C_{30}$ alkyl group, which is described above, and the substituted $C_2$-$C_{30}$ heteroarylene group refers to a $C_2$-$C_{30}$ heteroarylene group in which at least one hydrogen is substituted with any one of the substituents presented in the case of the substituted $C_1$-$C_{30}$ alkyl group, which is described above.

As used herein, an unsubstituted $C_6$-$C_{30}$ aryloxy group refers to -OA2 (here, A2 is a substituted or unsubstituted $C_6$-$C_{30}$ aryl group), and the substituted $C_6$-$C_{30}$ aryloxy group refers to a $C_6$-$C_{30}$ aryloxy group in which at least one hydrogen is substituted with any one of the substituents presented in the case of the substituted $C_1$-$C_{30}$ alkyl group, which is described above.

As used herein, an unsubstituted $C_6$-$C_{30}$ arylthio group refers to -$SA_3$ (here, $A_3$ is a substituted or unsubstituted $C_6$-$C_{30}$ aryl group), and the substituted $C_6$-$C_{30}$ arylthio group refers to a $C_6$-$C_{30}$ arylthio group in which at least one hydrogen is substituted with any one of the substituents presented in the case of the substituted $C_1$-$C_{30}$ alkyl group, which is described above.

Hereinafter, an OLED according to an embodiment will be described in detail with reference to the following illustrative Examples.

HOMO and LUMO values are measured by cyclic voltammetry using cyclic voltammetry equipment available from Wonatech (model name ZIVE SP2).

Each of the host material and the electron control material were dissolved with dichloromethane. Ferrocene and NPB, which are reference materials, were dissolved with dichloromethane. The concentration of each sample and reference solution was 5 x $10^{-3}$ M. The electrolytic acetonitrile solution contains $(Bu)_4NPF_6$ as an electrolyte, which has a concentration of 0.1 M.

The method of data analysis is as follows:

1) Draw $E_{we}$-I graph of the reference and the sample.
2) Draw linear fitting line before and after the point at which current increases rapidly. Onset potential is intersection point of two linear fitting lines.
3) Calculate (HOMO level of sample) = (HOMO level of reference) + $\Delta$E.
4) If onset potential of each cycle is different, use onset potential of the first cycle.

HOMO level of reference:

Ferrocene: -4.8 eV
NPB: -5.4 eV.

Example 1

As an anode, an ITO(7nm)/Ag(100nm)/ITO(7nm) substrate of Samsung Mobile Display (SMD) using glass manufactured by Corning Co., Ltd was cut to a size of 50mm×50mm×0.7mm, sonicated with pure water and isopropyl alcohol each for 30 minutes, exposed to a ultraviolet ray and ozone for 10 minutes, and then the resultant was installed in a vacuum deposition device.
Compound 301 was vacuum deposited on the glass substrate to form a hole injection layer having a thickness of 750 Å, and then Compound 311 was vacuum deposited on the hole injection layer to form a hole transport layer having a thickness of 1300 Å.
Compound 507 as a host and Compound 401 as a phosphorescent dopant at a weight ratio of 98:2 were co-deposited on the hole transport layer to form a red emission layer having a thickness of 400 Å.
Subsequently, Compound 1 was vacuum deposited on the emission layer to form an electron control layer having a thickness of 50 Å.
Compound 201 (same as Compound 1) and LiQ were vacuum co-deposited on the electron control layer at a weight ratio of 1:1 to form an electron transport layer having a thickness of 100 Å.
LiQ was vacuum deposited on the electron transport layer to form an electron injection layer having a thickness of 5 Å, and then Mg and Ag were vacuum deposited on the electron injection layer at a weight ratio of 10:1 to form a cathode having a thickness of 130 Å, thereby an OLED was manufactured.

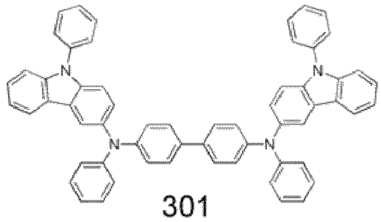
301

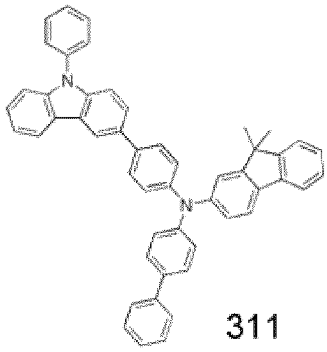
311

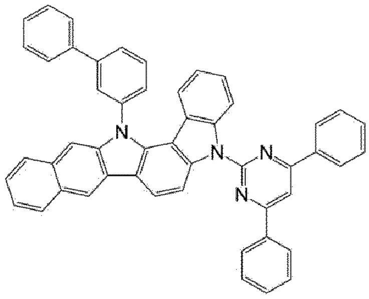
507

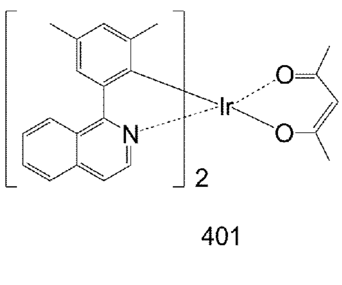
401

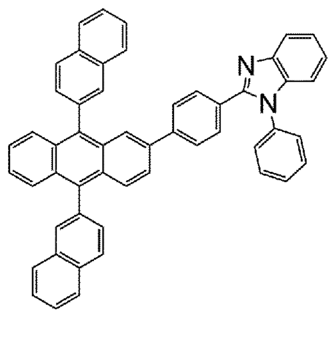
1

Example 2

An OLED was manufactured in the same manner as in Example 1, except that an electron control layer was formed to have a thickness of 100 Å instead of 50 Å.

Example 3

An OLED was manufactured in the same manner as in Example 1, except that an electron control layer was formed to have a thickness of 200 Å instead of 50 Å.

Example 4

An OLED was manufactured in the same manner as in Example 1, except that an electron control layer was formed to have a thickness of 450 Å instead of 50 Å.

Example 5

An OLED was manufactured in the same manner as in Example 1, except that Compound 701 below was vacuum deposited between the hole transport layer and the emission layer to form an electron blocking layer having a thickness of 300 Å, and the electron control layer was formed to have a thickness of 100 Å instead of 50 Å.

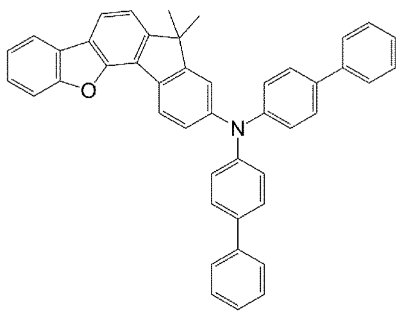

701

Example 6

An OLED was manufactured in the same manner as in Example 1, except that Compound 701 was vacuum deposited between the hole transport layer and the emission layer to form an electron blocking layer having a thickness of 300 Å, and the electron control layer was formed to have a thickness of 200 Å instead of 50 Å.

Comparative Example 1

An OLED was manufactured in the same manner as in Example 1, except that an electron control layer was not formed.

Comparative Example 2

An OLED was manufactured in the same manner as in Example 5, except that an electron control layer was not formed.

Comparative Example 3

An OLED was manufactured in the same manner as in Example 3, except that Compound 601 below was used to form a layer having a thickness of 200 Å instead of vacuum depositing Compound 1 to form an electron control layer having a thickness of 200 Å.

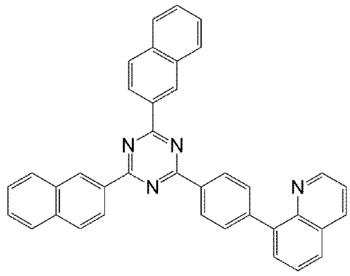

601

Comparative Example 4

An OLED was manufactured in the same manner as in Example 4, except that Compound 601 was used to form a layer having a thickness of 450 Å instead of vacuum depositing Compound 1 to form an electron control layer having a thickness of 450 Å.

Example 7

As an anode, an ITO(7nm)/Ag(100nm)/ITO(7nm) substrate of Samsung Mobile Display (SMD) using glass manufactured by Corning Co., Ltd was cut to a size of 50mm×50mm×0.7mm, sonicated with pure water and isopropyl alcohol each for 30 minutes, exposed to a ultraviolet ray and ozone for 10 minutes, and then the resultant was installed in a vacuum deposition device.

Compound 301 was vacuum deposited on the glass substrate to form a hole injection layer having a thickness of 750 Å, and then Compound 311 was vacuum deposited on the hole injection layer to form a hole transport layer having a thickness of 1300 Å.

Compound 701 was vacuum deposited on the hole transport layer to form an electron blocking layer having a thickness of 300 Å.

Compound 508 as a host and Compound 402 as a phosphorescent dopant at a weight ratio of 95:5 were co-deposited on the electron blocking layer to form a green emission layer having a thickness of 400 Å.

Subsequently, Compound 1 was vacuum deposited on the emission layer to form an electron control layer having a thickness of 50 Å.

Compound 201 (same as Compound 1) and LiQ at a weight ratio of 1:1 were vacuum co-deposited on the electron control layer to form an electron transport layer having a thickness of 100 Å.

LiQ was vacuum deposited on the electron transport layer to form an electron injection layer having a thickness of 5 Å, and then Mg and Ag were vacuum deposited on the electron injection layer at a weight ratio of 10:1 to form a cathode having a thickness of 130 Å, thereby an OLED was manufactured.

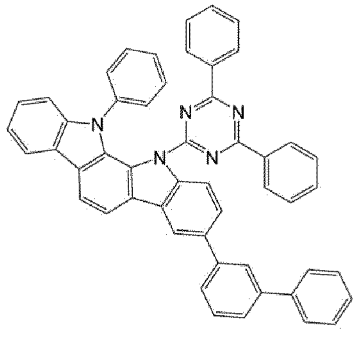

508

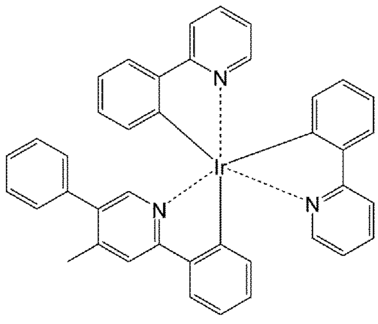

402

Example 8

An OLED was manufactured in the same manner as in Example 7, except that the electron control layer was formed to have a thickness of 100 Å instead of 50 Å.

Example 9

An OLED was manufactured in the same manner as in Example 7, except that the electron control layer was formed to have a thickness of 200 Å instead of 50 Å.

Example 10

An OLED was manufactured in the same manner as in Example 7, except that an electron blocking layer was not formed and the electron control layer was formed to have a thickness of 200 Å instead of 50 Å.

Comparative Example 5

An OLED was manufactured in the same manner as in Example 10, except that an electron control layer was not formed.

Comparative Example 6

An OLED was manufactured in the same manner as in Example 7, except that an electron control layer was not formed.

Comparative Example 7

An OLED was manufactured in the same manner as in Example 9, except that Compound 601 was used to form a layer having a thickness of 200 Å instead of vacuum depositing Compound 1 to form an electron control layer having a thickness of 200 Å.

Example 11

As an anode, an ITO(7nm)/Ag(100nm)/ITO(7nm) substrate of Samsung Mobile Display (SMD) using glass manufactured by Corning Co., Ltd was cut to a size of 50mm×50mm×0.7mm, sonicated with pure water and isopropyl alcohol each for 30 minutes, exposed to a ultraviolet ray and ozone for 10 minutes, and then the resultant was installed in a vacuum deposition device.

Compound 301 was vacuum deposited on the glass substrate to form a hole injection layer having a thickness of 750 Å, and then Compound 311 was vacuum deposited on the hole injection layer to form a hole transport layer having a thickness of 1300 Å.

A mixture of Compound 504 and Compound 509 at a weight ratio of 2:8 as a host, and Compound 402 as a phosphorescent dopant were co-deposited on the hole transport layer at a weight ratio of 85:15 to form a green emission layer having a thickness of 400 Å.

Subsequently, Compound 1 was vacuum deposited on the emission layer to form an electron control layer having a thickness of 50 Å.

Compound 201 (same as Compound 1) and LiQ were vacuum co-deposited on the electron control layer at a weight ratio of 1:1 to form an electron transport layer having a thickness of 100 Å.

LiQ was vacuum deposited on the electron transport layer to form an electron injection layer having a thickness of 5 Å, and then Mg and Ag were vacuum deposited on the electron injection layer at a weight ratio of 10:1 to form a cathode having a thickness of 130 Å, thereby an OLED was manufactured.

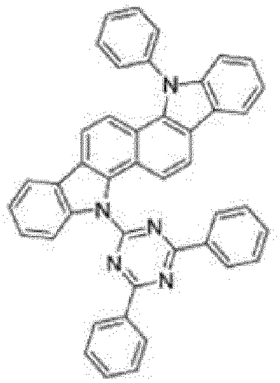

504

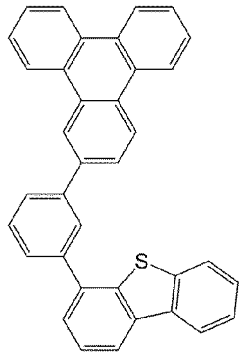

509

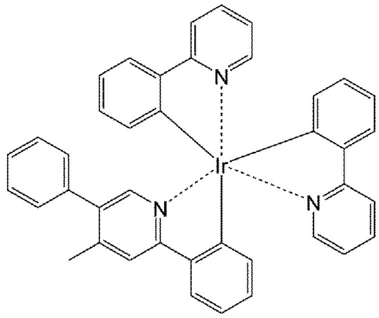

402

Example 12

An OLED was manufactured in the same manner as in Example 11, except that the electron control layer was formed to have a thickness of 100 Å instead of 50 Å.

Example 13

An OLED was manufactured in the same manner as in Example 11, except that the electron control layer was formed to have a thickness of 200 Å instead of 50 Å.

Example 14

An OLED was manufactured in the same manner as in Example 11, except that Compound 701 was vacuum deposited between the hole transport layer and the emission layer to form an electron blocking layer having a thickness of 300 Å, and the electron control layer was formed to have a thickness of 100 Å instead of 50 Å.

Comparative Example 8

An OLED was manufactured in the same manner as in Example 11, except that an electron control layer was not formed.

Comparative Example 9

An OLED was manufactured in the same manner as in Example 14, except that an electron control layer was not formed.

Comparative Example 10

An OLED was manufactured in the same manner as in Example 13, except that Compound 601 was used to form a layer having a thickness of 200 Å instead of vacuum depositing Compound 1 to form an electron control layer having a thickness of 200 Å.

Experimental conditions above were summarized and shown in Table 1 below.

Table 1

| Classification | Electron control layer | | | | Emission layer | | | Electron blocking layer | |
|---|---|---|---|---|---|---|---|---|---|
| | Electron control material | HOMO (eV) | LUMO (eV) | Thickness (Å) | Host Material | HOMO (eV) | LUMO (eV) | Electron blocking material | LUMO (eV) |
| Example 1 | Compound 1 | -5.6 | -2.8 | 50 | Compound 507 | -5.6 | -2.8 | - | - |
| Example 2 | Compound 1 | -5.6 | -2.8 | 100 | Compound 507 | -5.6 | -2.8 | - | - |
| Example 3 | Compound 1 | -5.6 | -2.8 | 200 | Compound 507 | -5.6 | -2.8 | - | - |
| Example 4 | Compound 1 | -5.6 | -2.8 | 450 | Compound 507 | -5.6 | -2.8 | - | - |
| Example 5 | Compound 1 | -5.6 | -2.8 | 100 | Compound 507 | -5.6 | -2.8 | Compound 701 | -2.1 |
| Example 6 | Compound 1 | -5.6 | -2.8 | 200 | Compound 507 | -5.6 | -2.8 | Compound 701 | -2.1 |
| Comparative Example 1 | - | - | - | - | Compound 507 | -5.6 | -2.8 | - | - |
| Comparative Example 2 | - | - | - | - | Compound 507 | -5.6 | -2.8 | Compound 701 | -2.1 |
| Comparative Example 3 | Compound 601 | -6.3 | -3.1 | 200 | Compound 507 | -5.6 | -2.8 | - | - |
| Comparative Example 4 | Compound 601 | -6.3 | -3.1 | 450 | Compound 507 | -5.6 | -2.8 | - | - |
| Example 7 | Compound 1 | -5.6 | -2.8 | 50 | Compound 508 | -5.7 | -2.6 | Compound 701 | -2.1 |
| Example 8 | Compound 1 | -5.6 | -2.8 | 100 | Compound 508 | -5.7 | -2.6 | Compound 701 | -2.1 |
| Example 9 | Compound 1 | -5.6 | -2.8 | 200 | Compound 508 | -5.7 | -2.6 | Compound 701 | -2.1 |
| Example 10 | Compound 1 | -5.6 | -2.8 | 200 | Compound 508 | -5.7 | -2.6 | - | - |
| Comparative Example 5 | - | - | - | - | Compound 508 | -5.7 | -2.6 | - | - |
| Comparative Example 6 | - | - | - | - | Compound 508 | -5.7 | -2.6 | Compound 701 | -2.1 |
| Comparative Example 7 | Compound 601 | -6.3 | -3.1 | 200 | Compound 508 | -5.7 | -2.6 | Compound 701 | -2.1 |
| Example 11 | Compound 1 | -5.6 | -2.8 | 50 | Compounds 504 and 509 | -5.9<br>-5.8 | -2.9<br>-2.1 | - | - |

(continued)

| Classification | Electron control layer | | | | Emission layer | | | Electron blocking layer | |
|---|---|---|---|---|---|---|---|---|---|
| | Electron control material | HOMO (eV) | LUMO (eV) | Thickness (Å) | Host Material | HOMO (eV) | LUMO (eV) | Electron blocking material | LUMO (eV) |
| Example 12 | Compound 1 | -5.6 | -2.8 | 100 | Compounds 504 and 509 | -5.9<br>-5.8 | -2.9<br>-2.1 | - | - |
| Example 13 | Compound 1 | -5.6 | -2.8 | 200 | Compounds 504 and 509 | -5.9<br>-5.8 | -2.9<br>-2.1 | - | - |
| Example 14 | Compound 1 | -5.6 | -2.8 | 100 | Compounds 504 and 509 | -5.9<br>-5.8 | -2.9<br>-2.1 | Compound 701 | -2.1 |
| Comparative Example 8 | - | - | - | - | Compounds 504 and 509 | -5.9<br>-5.8 | -2.9<br>-2.1 | - | - |
| Comparative Example 9 | - | - | - | - | Compounds 504 and 509 | -5.9<br>-5.8 | -2.9<br>-2.1 | Compound 701 | -2.1 |
| Comparative Example 10 | Compound 601 | -6.3 | -3.1 | 200 | Compounds 504 and 509 | -5.9<br>-5.8 | -2.9<br>-2.1 | - | - |

Evaluation Example

Red light-emitting efficiencies of the OLEDs manufactured according to Examples 1 to 6 and Comparative Examples 1 to 4 were measured while changing a luminance in a range from 0.1cd/$m^2$ to 10,000cd/$m^2$. The results are shown in FIG. 7, and the normalized results are shown in FIG. 8.

Referring to FIG. 7, the OLEDs manufactured in Examples 1 to 6 generally showed lower light-emitting efficiencies than the OLEDs manufactured in Comparative Example 1 to 4 at a low luminance.

Referring to FIG. 8 which is a normalized graph of the graph shown in FIG. 7, the OLEDs manufactured in Examples 1 to 6 showed similar level of light-emitting efficiencies with the OLEDs manufactured in Comparative Examples 1 to 4 at a high luminance region of about 100 cd/$m^2$ or higher. However, the OLEDs manufactured in Examples 1 to 6 showed very low level of light-emitting efficiencies compared to the OLEDs manufactured in Comparative Examples 1 to 4 at a low luminance region of around about 1 cd/$m^2$. The arrow on the graph is to indicate reduction of light-emitting efficiencies.

S-ratios were calculated, and the results were shown in Table 2 in order to confirm a degree of improvement of luminous efficiency characteristics of the OLEDs manufactured in Examples 1 to 6 and Comparative Examples 1 to 4 according to luminance.

Table 2

| | Ex. 1 | Ex. 2 | Ex. 3 | Ex. 4 | Ex. 5 | Ex. 6 | Comp. Ex. 1 | Comp. Ex. 2 | Comp. Ex. 3 | Comp.E x. 4 |
|---|---|---|---|---|---|---|---|---|---|---|
| Efficiency @ 1cd/$m^2$ | 32.2 | 21.8 | 18.6 | 13.6 | 19.8 | 17.5 | 38.7 | 42.8 | 34.4 | 25.9 |
| Efficiency @ 1,000cd/ $m^2$ | 32.8 | 33.0 | 31.7 | 22.0 | 35.5 | 33.1 | 33.1 | 38.9 | 34.4 | 23.7 |
| S-ratio | 1.02 | 1.51 | 1.70 | 1.62 | 1.79 | 1.90 | 0.85 | 0.91 | 1.00 | 0.91 |

An S-ratio is defined as a ratio of a current efficiency value at 1,000 cd/$m^2$ divided by a current efficiency value at 1 cd/$m^2$. As the S-ratio is increased, the shape of a luminance vs. efficiency graph is closer to S which indicates that the OLEDs have a great tendency to have a high luminous efficiency at a high luminance region and a low luminous efficiency at a low luminance region.

Referring to Table 2, unlike the S-ratios of the OLEDs manufactured in Examples 1 to 6 which were all greater than 1 and reached almost 2 in the case of Example 6, the S-ratios of the OLEDs manufactured in Comparative Examples 1 to 4 were 1 or lower. That is, the shape of the luminance vs. efficiency graph of the OLEDs manufactured in Examples 1 to 6 is closer to S than that of the OLEDs manufactured in Comparative Examples 1 to 4.

In the regard, it may be confirmed that the OLEDs manufactured in Examples 1 to 6 have improved luminous efficiency characteristics according to luminance as the OLEDs show high red light-emitting efficiencies at a high luminance region and very low red light-emitting efficiencies at a low luminance region.

Green light-emitting efficiencies of the OLEDs manufactured according to Examples 7 to 10 and Comparative Examples 5 to 7 were measured while changing the luminance in a range from 0.1cd/$m^2$ to 10,000cd/$m^2$. The results are shown in FIG. 9, and the normalized results are shown in FIG. 10.

Referring to FIG. 9, the OLEDs manufactured in Examples 8 to 10 generally showed lower light-emitting efficiencies than the OLEDs manufactured in Comparative Example 5 to 7 at a low luminance. The OLED manufactured in Example 7 showed a similar level of luminous efficiency with the OLEDs manufactured in Comparative Examples 5 to 7.

Referring to FIG. 10 which is a normalized graph of the graph shown in FIG. 9, the OLEDs manufactured in Examples 8 to 10 showed similar levels of light-emitting efficiencies with the OLEDs manufactured in Comparative Examples 5 to 7 at a high luminance region of about 100 cd/$m^2$ or higher. However, the OLEDs manufactured in Examples 8 to 10 showed low level of light-emitting efficiencies compared to the OLEDs manufactured in Comparative Examples 5 to 7 at a low luminance region of around about 1 cd/$m^2$. The arrow on the graph is to indicate reduction of light-emitting efficiencies.

S-ratios were calculated, and the results were shown in Table 3 in order to confirm the degree of improvement of luminous efficiency characteristics of the OLEDs manufactured in Examples 7 to 10 and Comparative Examples 5 to 7 according to luminance.

Table 3

| | Ex. 7 | Ex. 8 | Ex. 9 | Ex. 10 | Comp. Ex. 5 | Comp. Ex. 6 | Comp. Ex. 7 |
|---|---|---|---|---|---|---|---|
| Efficiency @ 1cd/$m^2$ | 98.2 | 71.2 | 45.7 | 38.1 | 97.3 | 103.1 | 75.3 |
| Efficiency @ 1,000cd/$m^2$ | 102.3 | 92.8 | 80.7 | 56.6 | 80.1 | 111.3 | 74.5 |
| S-ratio | 1.04 | 1.30 | 1.76 | 1.49 | 0.82 | 1.08 | 0.99 |

Referring to Table 3, unlike the S-ratios of the OLEDs manufactured in Examples 7 to 10 which were all greater than 1 and 1.7 or greater in the case of Example 9, the S-ratios of the OLEDs manufactured in Comparative Examples 5 to 7 were around 1 or lower. That is, the shape of the luminance vs. efficiency graph of the OLEDs manufactured in Examples 7 to 10 is closer to S than that of the OLEDs manufactured in Comparative Examples 5 to 7.

In the regard, it may be confirmed that the OLEDs manufactured in Examples 7 to 10 have improved luminous efficiency characteristics according to luminance as the OLEDs show high green light-emitting efficiencies at a high luminance region and very low green light-emitting efficiencies at a low luminance region.

Green light-emitting efficiencies of the OLEDs manufactured according to Examples 11 to 14 and Comparative Examples 8 to 10 were measured while changing a luminance in a range from 0.1cd/$m^2$ to 10,000cd/$m^2$. The results are shown in FIG. 11, and the normalized results are shown in FIG. 12.

Referring to FIG. 11, the OLEDs manufactured in Examples 11 to 14 generally showed lower light-emitting efficiencies than the OLEDs manufactured in Comparative Example 8 to 10 at a low luminance.

Referring to FIG. 12 which is a normalized graph of the graph shown in FIG. 11, the OLEDs manufactured in Examples 11 to 14 showed similar levels of light-emitting efficiencies with the OLEDs manufactured in Comparative Examples 8 to 10 at a high luminance region of about 100 cd/$m^2$ or higher. However, the OLEDs manufactured in Examples 11 to 14 showed very low level of light-emitting efficiencies compared to the OLEDs manufactured in Comparative Examples 8 to 10 at a low luminance region of around about 1 cd/$m^2$. The arrow on the graph is to indicate reduction of light-emitting efficiencies.

S-ratios were calculated, and the results were shown in Table 4 in order to confirm the degree of improvement of luminous efficiency characteristics of the OLEDs manufactured in Examples 11 to 14 and Comparative Examples 8 to 10 according to luminance.

Table 4

| | Ex. 11 | Ex. 12 | Ex. 13 | Ex. 14 | Comp. Ex. 8 | Comp. Ex. 9 | Comp. Ex. 10 |
|---|---|---|---|---|---|---|---|
| Efficiency @ 1cd/$m^2$ | 49.5 | 28.5 | 23.0 | 17.00 | 91.54 | 104.13 | 75.30 |
| Efficiency @ 1,000cd/m 2 | 92.8 | 88.2 | 82.1 | 90.06 | 91.02 | 102.20 | 74.51 |
| S-ratio | 1.88 | 3.1 | 3.57 | 5.30 | 0.99 | 0.98 | 0.99 |

Referring to Table 4, the S-ratios of the OLEDs manufactured in Examples 11 to 14 were all greater than 1; were 3 or greater in the case of Examples 12 and 13, and in particular, were 5 or greater in the case of Example 14. However, the S-ratios of the OLEDs manufactured in Comparative Examples 8 to 10 were 1 or lower. That is, the shape of the luminance vs. efficiency graph of the OLEDs manufactured in Examples 11 to 14 is closer to S than that of the OLEDs manufactured in Comparative Examples 8 to 10.

The OLEDs manufactured in Examples 11 to 14 had significantly greater values of the S-ratios than other cases. This is considered as caused due to using a mixture of Compound 504, which is a bipolar compound having both a hole transport unit and an electron transport unit, and Compound 509 which is a compound having a hole transport unit as a host material.

In this regard, it may be confirmed that the OLEDs manufactured in Examples 11 to 14 have improved luminous efficiency characteristics according to luminance as the OLEDs show high red light-emitting efficiencies at a high luminance region and very low red light-emitting efficiencies at a low luminance region. A full color organic light-emitting display apparatus including red light-emitting devices, green light-emitting devices, and blue light-emitting devices has a high light-emitting efficiency at a high luminance region and has an excellent luminous efficiency characteristics as the emission of red and green light is suppressed in a black state.

As described above, an OLED according to an embodiment has improved luminous efficiency characteristics according to luminance by having an excellent luminous efficiency at a high luminance region and a low luminous efficiency at a low luminance region as the OLED includes an electron control layer and controls the flow of electrons

that are injected to an emission layer.

An OLED according to an embodiment has improved luminous efficiency characteristics according to luminance by having an excellent luminous efficiency at a high luminance region and a low luminous efficiency at a low luminance region as the OLED includes an electron control layer and an electron blocking layer, and controls the flow of electrons that are injected to an emission layer.

An organic light-emitting display apparatus according to an embodiment has improved luminous efficiency characteristics according to luminance by including the OLED and suppressing emission of red and green light in the black state.

## Claims

**1.** An organic light-emitting device (OLED) comprising:

a first electrode;
a second electrode opposite to the first electrode;
a phosphorescent emission layer disposed between the first electrode and the second electrode;
an electron transport layer disposed between the phosphorescent emission layer and the second electrode; and
an electron control layer disposed between the phosphorescent emission layer and the electron transport layer,
wherein the phosphorescent emission layer comprises a host material and a dopant material, and the electron control layer comprises an electron control material, wherein the highest occupied molecular orbital (HOMO) energy level of the host material ($EH_H$), the lowest unoccupied molecular orbital (LUMO) energy level of the host material ($EL_H$), the HOMO energy level of the electron control material (EHc), and the LUMO energy level of the electron control material (ELc) satisfy both relationships of $|EH_H - EHc| \leq 0.3$ eV and $|EL_H - EL_C| \leq 0.5$eV, wherein a thickness of the electron control layer is from 50 Å to 450 Å (10 Å = 1 nm) and the electron control material comprises a compound represented by Formula 1 below:

Formula 1

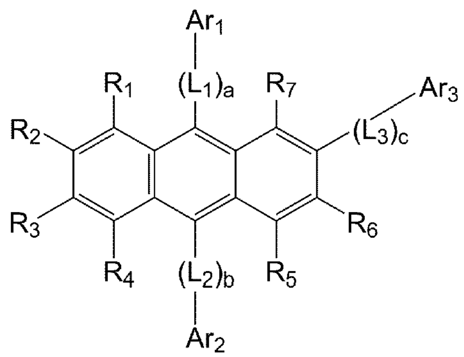

wherein $R_1$ to $R_7$ are each independently one of a hydrogen, a deuterium, a halogen, a hydroxy group, a cyano group, a nitro group, an amino group, a carboxyl group, a substituted or unsubstituted $C_1$-$C_{30}$ alkyl group, a substituted or unsubstituted $C_2$-$C_{30}$ alkenyl group, a substituted or unsubstituted $C_2$-$C_{30}$ alkynyl group, a substituted or unsubstituted $C_1$-$C_{30}$ alkoxy group, a substituted or unsubstituted $C_3$-$C_{30}$ cycloalkyl group, a substituted or unsubstituted $C_3$-$C_{30}$ cycloalkenyl group, and a substituted or unsubstituted $C_6$-$C_{30}$ aryl group,
$Ar_1$, $Ar_2$, and $Ar_3$ are each independently one of a substituted or unsubstituted $C_6$-$C_{30}$ aryl group, a substituted or unsubstituted $C_6$-$C_{30}$ aryloxy group, a substituted or unsubstituted $C_6$-$C_{30}$ arylthio group, a substituted or unsubstituted $C_2$-$C_{30}$ heteroaryl group, and a group represented by -N($Q_1$)($Q_2$), wherein at least one of $Ar_1$, $Ar_2$, and $Ar_3$ is a substituted or unsubstituted $C_2$-$C_{30}$ heteroaryl group, wherein $Q_1$ and $Q_2$ are each independently one of a hydrogen, a deuterium, a halogen, a hydroxy group, a cyano group, an amino group, a nitro group, a carboxyl group, a substituted or unsubstituted $C_1$-$C_{30}$ alkyl group, a substituted or unsubstituted $C_2$-$C_{30}$ alkenyl group, a substituted or unsubstituted $C_2$-$C_{30}$ alkynyl group, a substituted or unsubstituted $C_1$-$C_{30}$ alkoxy group, a substituted or unsubstituted $C_3$-$C_{30}$ cycloalkyl group, a substituted or unsubstituted $C_3$-$C_{30}$ cycloalkenyl group, a substituted or unsubstituted $C_6$-$C_{30}$ aryl group, a substituted or unsubstituted $C_6$-$C_{30}$ aryloxy group, a substituted or unsubstituted $C_6$-$C_{30}$ arylthio group, and a substituted or unsubstituted C2-$C_{30}$ heteroaryl group,
$L_1$, $L_2$, and $L_3$ are each independently one of a substituted or unsubstituted $C_6$-$C_{30}$ arylene group, and a substituted or unsubstituted $C_2$-$C_{30}$ heteroarylene group, and

a, b, and c are each independently 0, 1, 2 or 3.

2. The OLED according to claim 1, wherein $EH_H$, $EL_H$, EHc, and ELc satisfy both relationships of $0 \leq EH_H - EHc \leq 0.3$ eV and $0 \leq EL_H - ELc \leq 0.5$ eV.

3. The OLED according to claim 1 or claim 2, wherein the electron mobility of the electron control material is greater than or equal to the hole mobility of the electron control material.

4. The OLED according to any preceding claim, wherein EHc is from -5.2 eV to -6.1 eV, and/or wherein $EL_C$ is from -2.5 eV to -3.2 eV, wherein the HOMO and LUMO energy levels are measured by cyclic voltammetry.

5. The OLED of according to any preceding claim, wherein the content of the electron control material is from 30 weight % (wt %) to 100 wt % based on the total weight of the electron control layer.

6. The OLED according to any preceding claim, wherein the thickness ratio of the electron transport layer and the electron control layer is from 5:1 to 5:10.

7. The OLED according to any preceding claim, comprising

an electron blocking layer disposed between the phosphorescent emission layer and the first electrode, wherein the electron blocking layer comprises an electron blocking material, and the LUMO energy level of the electron blocking material $EL_B$ satisfies the relationship of $EL_B > EL_H$.

8. The OLED according to claim 7, wherein the electron blocking material comprises at least one of a triphenylamine derivative, a carbazole derivative, and a spirobifluorene derivative.

9. The OLED according to claim 7 or claim 8, wherein a thickness of the electron blocking layer is from 10 Å to 1000 Å.

10. The OLED according to any preceding claim, wherein the electron control material comprises at least one compound represented by Formulae 2 and 3 below:

Formula 2

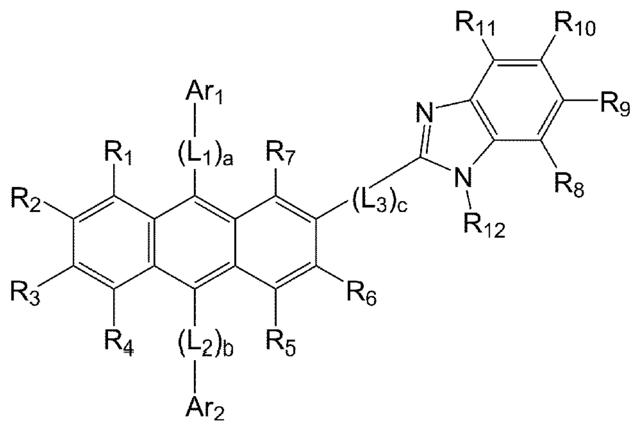

Formula 3

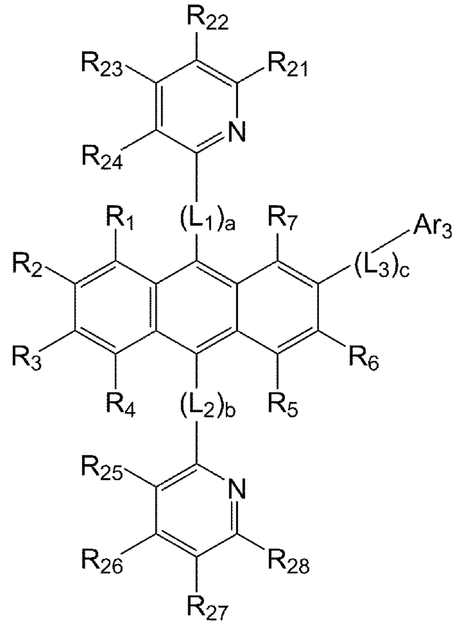

wherein In Formulae 2 and 3, $R_1$ to $R_{12}$ and $R_{21}$ to $R_{28}$ are each independently one of a hydrogen, a deuterium, a substituted or unsubstituted methyl group, a substituted or unsubstituted ethyl group, a substituted or unsubstituted propyl group, a substituted or unsubstituted butyl group, a substituted or unsubstituted phenyl group, a substituted or unsubstituted biphenyl group, a substituted or unsubstituted naphthyl group, a substituted or unsubstituted anthryl, a substituted or unsubstituted phenanthrenyl, a substituted or unsubstituted pyrenyl group,

$Ar_1$, $Ar_2$, and $Ar_3$ are each independently one of a substituted or unsubstituted phenyl group, a substituted or unsubstituted pentalenyl group, a substituted or unsubstituted indenyl group, a substituted or unsubstituted naphtyl group, a substituted or unsubstituted azulenyl group, a substituted or unsubstituted heptalenyl group, a substituted or unsubstituted indacenyl group, a substituted or unsubstituted acenaphtyl group, a substituted or unsubstituted fluorenyl group, a substituted or unsubstituted spirofluorenyl group, a substituted or unsubstituted phenalenyl group, a substituted or unsubstituted phenanthrenyl group, a substituted or unsubstituted anthryl group, a substituted or unsubstituted fluoranthenyl group, a substituted or unsubstituted triphenylenyl group, a substituted or unsubstituted pyrenyl group, a substituted or unsubstituted chrysenyl group, a substituted or unsubstituted naphthacenyl group, a substituted or unsubstituted picenyl group, a substituted or unsubstituted perylenyl group, a substituted or unsubstituted pentaphenyl group, a substituted or unsubstituted hexacenyl group, a substituted or unsubstituted pyrrolyl group, a substituted or unsubstituted imidazolyl group, a substituted or unsubstituted pyrazolyl group, a substituted or unsubstituted pyridinyl group, a substituted or unsubstituted bipyridinyl group, a substituted or unsubstituted pyrazinyl group, a substituted or unsubstituted pyrimidinyl group, a substituted or unsubstituted pyridazinyl group, a substituted or unsubstituted isoindolyl group, a substituted or unsubstituted indolyl group, a substituted or unsubstituted indazolyl group, a substituted or unsubstituted purinyl group, a substituted or unsubstituted quinolinyl group, a substituted or unsubstituted benzoquinolinyl group, a substituted or unsubstituted phthalazinyl group, a substituted or unsubstituted naphthyridinyl group, a substituted or unsubstituted quinoxalinyl group, a substituted or unsubstituted quinazolinyl group, a substituted or unsubstituted cinnolinyl group, a substituted or unsubstituted carbazolyl group, a substituted or unsubstituted phenanthridinyl group, a substituted or unsubstituted acridinyl group, a substituted or unsubstituted phenanthrolinyl group, a substituted or unsubstituted phenazinyl group, a substituted or unsubstituted benzooxazolyl group, a substituted or unsubstituted benzoimidazolyl group, a substituted or unsubstituted furanyl group, a substituted or unsubstituted benzofuranyl group, a substituted or unsubstituted thiophenyl group, a substituted or unsubstituted benzothiophenyl group, a substituted or unsubstituted thiazolyl group, a substituted or unsubstituted isothiazolyl group, a substituted or unsubstituted benzothiazolyl group, a substituted or unsubstituted isoxazolyl group, a substituted or unsubstituted oxazolyl group, a substituted or unsubstituted triazolyl group, a substituted or unsubstituted tetrazolyl group, a substituted or unsubstituted oxadiazolyl group, a substituted or unsubstituted triazinyl group, a substituted or unsubstituted benzooxazolyl group, a substituted or unsubstituted dibenzopuranyl group, a substituted or unsubstituted dibenzothiophenyl group, and a substituted or unsubstituted bezocarbazolyl group,

$L_1$, $L_2$, and $L_3$ are each independently one of a substituted or unsubstituted phenylene group, a substituted or

unsubstituted pentalenylene group, a substituted or unsubstituted indenylene group, a substituted or unsubstituted naphthylene group, a substituted or unsubstituted azulenylene group, a substituted or unsubstituted heptalenylene group, a substituted or unsubstituted indacenylene group, a substituted or unsubstituted acenaphthylene group, a substituted or unsubstituted fluorenylene group, a substituted or unsubstituted phenalenylene group, a substituted or unsubstituted phenanthrenylene group, a substituted or unsubstituted anthrylene group, a substituted or unsubstituted fluoranthenylene group, a substituted or unsubstituted triphenylenylene group, a substituted or unsubstituted pyrenylene group, a substituted or unsubstituted chrysenylene group, a substituted or unsubstituted naphthacenylene group, a substituted or unsubstituted picenylene group, a substituted or unsubstituted perylenylene group, a substituted or unsubstituted pentaphenylene group, a substituted or unsubstituted hexacenylene group, a substituted or unsubstituted pyrrolylene group, a substituted or unsubstituted pyrazolylene group, a substituted or unsubstituted imidazolylene group, a substituted or unsubstituted imidazolinylene group, a substituted or unsubstituted imidazopyridinylene group, a substituted or unsubstituted imidazopyrimidinylene group, a substituted or unsubstituted pyridinylene group, a substituted or unsubstituted pyrazinylene group, a substituted or unsubstituted pyrimidinylene group, a substituted or unsubstituted indolylene group, a substituted or unsubstituted purinylene group, a substituted or unsubstituted quinolinylene group, a substituted or unsubstituted phthalazinylene group, a substituted or unsubstituted indolizinylene group, a substituted or unsubstituted naphthyridinylene group, a substituted or unsubstituted quinazolinylene group, a substituted or unsubstituted cinnolinylene group, a substituted or unsubstituted indazolylene group, a substituted or unsubstituted carbazolylene group, a substituted or unsubstituted phenazinylene group, a substituted or unsubstituted phenanthridinylene group, a substituted or unsubstituted pyranylene group, a substituted or unsubstituted chromenylene group, a substituted or unsubstituted furanylene group, a substituted or unsubstituted benzofuranylene group, a substituted or unsubstituted thiophenylene group, a substituted or unsubstituted benzothiophenylene group, a substituted or unsubstituted isothiazolylene group, a substituted or unsubstituted benzoimidazolylene group, a substituted or unsubstituted isoxazolylene group, a substituted or unsubstituted dibenzothiophenylene group, a substituted or unsubstituted dibenzopuranylene group, a substituted or unsubstituted triazinylene group, and a substituted or unsubstituted oxadiazolylene group, and
a, b, and c are each independently one of integers of o to 1.

**11.** The OLED according to any preceding claim, wherein the electron control material comprises at least one of Compounds 1 and 2 below:

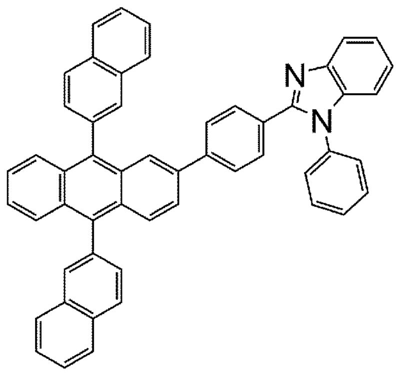

1

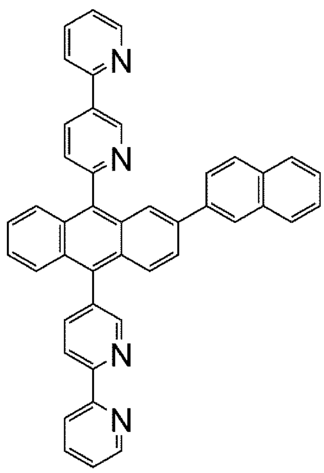

2

**12.** The OLED according to any preceding claim, wherein the host material comprises a bipolar compound having both a hole transport unit and an electron transport unit.

**13.** The OLED according to any preceding claim, wherein the host material comprises a mixture of a bipolar compound having both a hole transport unit and an electron transport unit and a compound having at least a hole transport unit.

**14.** The OLED according to any preceding claim, wherein the phosphorescent emission layer emits red or green light.

**15.** The OLED according to any preceding claim, wherein the electron transport layer comprises a compound represented by Formula 4 below:

Formula 4

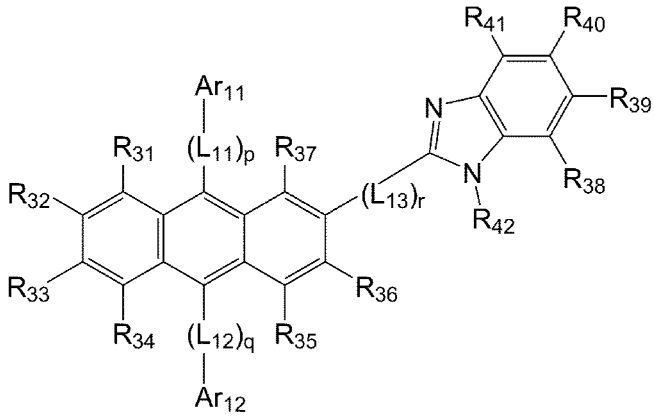

wherein $R_{31}$ to $R_{42}$ are each independently one of a hydrogen, a deuterium, a substituted or unsubstituted methyl group, a substituted or unsubstituted ethyl group, a substituted or unsubstituted propyl group, a substituted or unsubstituted butyl group, a substituted or unsubstituted phenyl group, a substituted or unsubstituted biphenyl group, a substituted or unsubstituted naphthyl group, a substituted or unsubstituted anthryl, a substituted or unsubstituted phenanthrenyl, a substituted or unsubstituted pyrenyl group,

$Ar_{11}$ and $Ar_{12}$ are each independently one of a substituted or unsubstituted phenyl group, a substituted or unsubstituted pentalenyl group, a substituted or unsubstituted indenyl group, a substituted or unsubstituted naphtyl group, a substituted or unsubstituted azulenyl group, a substituted or unsubstituted heptalenyl group, a substituted or unsubstituted indacenyl group, a substituted or unsubstituted acenaphtyl group, a substituted or unsubstituted fluorenyl group, a substituted or unsubstituted spirofluorenyl group, a substituted or unsubstituted phenalenyl group, a substituted or unsubstituted phenanthrenyl group, a substituted or unsubstituted anthryl group, a substituted or unsubstituted fluoranthenyl group, a substituted or unsubstituted triphenylenyl group, a substituted or unsubstituted pyrenyl group, a substituted or unsubstituted chrysenyl group, a substituted or unsubstituted naphthacenyl group. a substituted or unsubstituted picenyl group, a substituted or unsubstituted perylenyl group, a substituted or unsubstituted pentaphenyl group, a substituted or unsubstituted hexacenyl group, a substituted or unsubstituted pyrrolyl group, a substituted or unsubstituted imidazolyl group, a substituted or unsubstituted pyrazolyl group, a substituted or unsubstituted pyridinyl group, a substituted or unsubstituted bipyridinyl group, a substituted or unsubstituted pyrazinyl group, a substituted or unsubstituted pyrimidinyl group, a substituted or unsubstituted pyridazinyl group, a substituted or unsubstituted isoindolyl group, a substituted or unsubstituted indolyl group, a substituted or unsubstituted indazolyl group, a substituted or unsubstituted purinyl group, a substituted or unsubstituted quinolinyl group, a substituted or unsubstituted benzoquinolinyl group, a substituted or unsubstituted phthalazinyl group, a substituted or unsubstituted naphthyridinyl group, a substituted or unsubstituted quinoxalinyl group, a substituted or unsubstituted quinazolinyl group, a substituted or unsubstituted cinnolinyl group, a substituted or unsubstituted carbazolyl group, a substituted or unsubstituted phenanthridinyl group, a substituted or unsubstituted acridinyl group, a substituted or unsubstituted phenanthrolinyl group, a substituted or unsubstituted phenazinyl group, a substituted or unsubstituted benzooxazolyl group, a substituted or unsubstituted benzoimidazolyl group, a substituted or unsubstituted furanyl group, a substituted or unsubstituted benzofuranyl group, a substituted or unsubstituted thiophenyl group, a substituted or unsubstituted benzothiophenyl group, a substituted or unsubstituted thiazolyl group, a substituted or unsubstituted isothiazolyl group, a substituted or unsubstituted benzothiazolyl group, a substituted or unsubstituted isoxazolyl group, a substituted or unsubstituted oxazolyl group, a substituted or unsubstituted triazolyl group, a substituted or unsubstituted tetrazolyl group, a substituted or unsubstituted oxadiazolyl group, a substituted or unsubstituted triazinyl group, a substituted or unsubstituted benzooxazolyl group, a substituted or unsubstituted dibenzopuranyl group, a substituted or unsubstituted dibenzothiophenyl group, and a substituted or unsubstituted bezocarbazolyl group,

$L_{11}$, $L_{12}$, and $L_{13}$ are each independently one of a substituted or unsubstituted phenylene group, a substituted or unsubstituted pentalenylene group, a substituted or unsubstituted indenylene group, a substituted or unsubstituted naphthylene group, a substituted or unsubstituted azulenylene group, a substituted or unsubstituted heptalenylene group, a substituted or unsubstituted indacenylene group, a substituted or unsubstituted acenaphthylene group, a substituted or unsubstituted fluorenylene group, a substituted or unsubstituted phenalenylene group, a substituted or unsubstituted phenanthrenylene group, a substituted or unsubstituted anthrylene group, a substituted or unsubstituted fluoranthenylene group, a substituted or unsubstituted triphenylenylene group, a substituted or unsubstituted pyrenylene group, a substituted or unsubstituted chrysenylene group, a substituted or unsubstituted naphthacenylene group, a substituted or unsubstituted picenylene group, a substituted or unsubstituted perylenylene group, a substituted or unsubstituted pentaphenylene group, a substituted or unsubstituted hexacenylene group, a substituted or unsubstituted pyrrolylene group, a substituted or unsubstituted pyrazolylene group, a substituted or unsubstituted imidazolylene group, a substituted or unsubstituted imidazolinylene group, a substituted or unsubstituted imidazopyridinylene group, a substituted or unsubstituted imidazopyrimidinylene group, a substituted or unsubstituted pyridinylene group, a substituted or unsubstituted pyrazinylene group, a substituted or unsubstituted pyrimidinylene group, a substituted or unsubstituted indolylene group, a substituted or unsubstituted purinylene group, a substituted or unsubstituted quinolinylene group, a substituted or unsubstituted phthalazinylene group, a substituted or unsubstituted indolizinylene group, a substituted or unsubstituted naphthyridinylene group, a substituted or unsubstituted quinazolinylene group, a substituted or unsubstituted cinnolinylene group, a substituted or unsubstituted indazolylene group, a substituted or unsubstituted carbazolylene group, a substituted or unsubstituted phenazinylene group, a substituted or unsubstituted phenanthridinylene group, a substituted or unsubstituted pyranylene group, a substituted or unsubstituted chromenylene group, a substituted or unsubstituted furanylene group, a substituted or unsubstituted benzofuranylene group, a substituted or unsubstituted thiophenylene group, a substituted or unsubstituted benzothiophenylene group, a substituted or unsubstituted isothiazolylene group, a substituted or unsubstituted benzoimidazolylene group, a substituted or unsubstituted isoxazolylene group, a substituted or unsubstituted dibenzothiophenylene group, a substituted or unsubstituted dibenzopuranylene group, a substituted or unsubstituted triazinylene group, and a substituted or unsubstituted oxadiazolylene group, and
p, q, and r are each independently an integer of 0 to 1.

**16.** The OLED according to claim 15, wherein the electron transport layer further comprises at least one selected from a lithium quinolate (LiQ) and Compound 101 below:

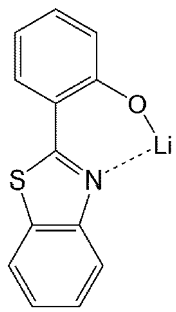

101

**17.** The OLED according to claim 15 or claim 16, wherein the electron transport layer further comprises at least one selected from 1,4,5,8,9,12-hexaazatriphenylene hexacarbonitrile, tetracyanoquinodimethane, anthraquinone, perylenebisimide, and tetracyanoanthraquinodimethane.

**18.** The OLED according to any one of claims 15 to 17, wherein the electron transport layer further comprises at least one selected from at least one metal selected from Li, Cs, Na, K, Ca, Mg, Ba, and Ra; metal carbonate; metal acetate; metal benzoate; metal acetoacetate; metal acetylacetonate; and metal stearate.

**19.** The OLED according to any preceding claim, wherein the OLED further comprises a hole transport layer disposed between the phosphorescent emission layer and the first electrode, wherein the hole transport layer comprises a compound represented by Formula 5 below:

Formula 5

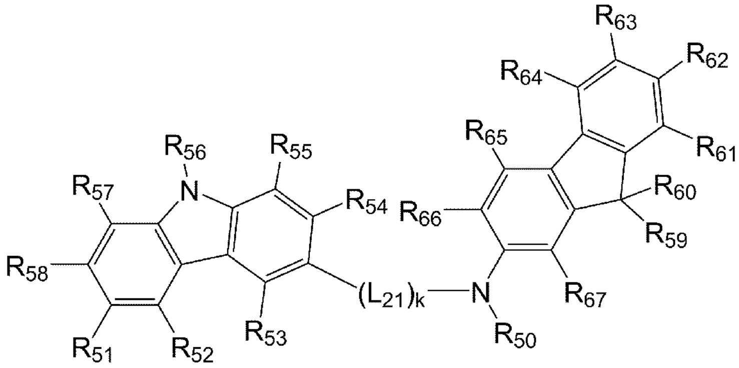

wherein $R_{50}$ is one of a substituted or unsubstituted phenyl group, a substituted or unsubstituted naphthyl group, a substituted or unsubstituted anthryl group, a substituted or unsubstituted biphenyl group, and a substituted or unsubstituted pyridyl group;

$L_{21}$ is one of a substituted or unsubstituted $C_1$-$C_{30}$ alkylene group, a substituted or unsubstituted $C_2$-$C_{30}$ alkenylene group, a substituted or unsubstituted $C_6$-$C_{30}$ arylene group, and a substituted or unsubstituted $C_2$-$C_{30}$ heteroarylene group;

$R_{51}$ to $R_{67}$ are each independently one of a hydrogen, a deuterium, a halogen, a hydroxy group, a cyano group, a nitro group, a carboxyl group, a substituted or unsubstituted $C_1$-$C_{30}$ alkyl group, a substituted or unsubstituted $C_2$-$C_{30}$ alkenyl group, a substituted or unsubstituted $C_2$-$C_{30}$ alkynyl group, a substituted or unsubstituted $C_1$-$C_{30}$ alkoxy group, a substituted or unsubstituted $C_1$-$C_{30}$ alkylthiol group, a substituted or unsubstituted $C_3$-$C_{30}$ cycloalkyl group, a substituted or unsubstituted $C_3$-$C_{30}$ cycloalkenyl group, a substituted or unsubstituted $C_6$-$C_{30}$ aryl group, a substituted or unsubstituted $C_6$-$C_{30}$ aryloxy group, a substituted or unsubstituted $C_6$-$C_{30}$ arylthio group, a substituted or unsubstituted $C_2$-$C_{30}$ heteroaryl group, and a group represented by -N($Q_{11}$)($Q_{12}$); $Q_{11}$ and $Q_{12}$ are each independently one of a hydrogen, a deuterium, a halogen, a hydroxy group, a cyano group, an amino group, a nitro group, a carboxyl group, a $C_1$-$C_{30}$ alkyl group, a $C_2$-$C_{30}$ alkenyl group, a $C_2$-$C_{30}$ alkynyl group, a $C_1$-$C_{30}$ alkoxy group, a $C_1$-$C_{30}$ alkylthiol group, a $C_3$-$C_{30}$ cycloalkyl group, a $C_3$-$C_{30}$ cycloalkenyl group, a $C_6$-$C_{30}$ aryl group, a $C_6$-$C_{30}$ aryloxy group, a $C_6$-$C_{30}$ arylthio group, and a $C_2$-$C_{30}$ heteroaryl group; and

k is 0, 1, 2 or 3.

**20.** The OLED according to any preceding claim, wherein the OLED further comprises a hole injection layer disposed between the hole transport layer and the first electrode, wherein the hole injection layer comprises a compound represented by Formula 6 below:

Formula 6

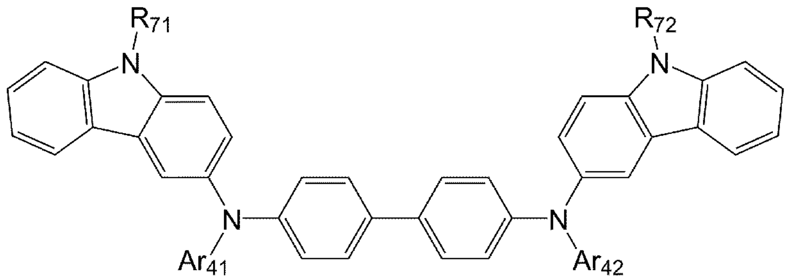

wherein $Ar_{41}$ and $Ar_{42}$ are each independently one of a substituted or unsubstituted $C_6$-$C_{30}$ arylene group and a substituted or unsubstituted $C_2$-$C_{30}$ heteroarylene group,

$R_{71}$ and $R_{72}$ are each independently one of a hydrogen, a deuterium, a halogen, a hydroxy group, a cyano group, a nitro group, an amino group, an amidino group, a hydrazine, a hydrazone, a carboxyl group or a salt thereof, a sulfonic acid group or a salt thereof, a phosphoric acid group or a salt thereof, a substituted or unsubstituted $C_1$-$C_{30}$ alkyl group, a substituted or unsubstituted $C_2$-$C_{30}$ alkenyl group, a substituted or unsubstituted $C_2$-$C_{30}$ alkynyl group, a substituted or unsubstituted $C_1$-$C_{30}$ alkoxy group, a substituted or unsubstituted $C_3$-$C_{30}$ cycloalkyl group, a substituted or unsubstituted $C_6$-$C_{30}$ aryl group, a substituted or unsubstituted $C_6$-$C_{30}$ aryloxy group, and a substituted

or unsubstituted $C_6$-$C_{30}$ arylthio group.

**21.** An organic light-emitting display apparatus comprising a transistor comprising source, drain, gate, and an active layer, and the OLED according to any preceding claim, wherein a first electrode of the OLED is electrically connected to the source or the drain.

**Patentansprüche**

**1.** Organische lichtemittierende Vorrichtung (OLED), umfassend:

eine erste Elektrode;
eine zweite Elektrode gegenüber der ersten Elektrode; eine phosphoreszierende Emissionsschicht, angeordnet zwischen der ersten Elektrode und der zweiten Elektrode;
eine Elektronentransportschicht, angeordnet zwischen der phosphoreszierenden Emissionsschicht und der zweiten Elektrode; und
eine Elektronensteuerschicht, angeordnet zwischen der phosphoreszierenden Emissionsschicht und der Elektronentransportschicht,
wobei die phosphoreszierende Emissionsschicht ein Hostmaterial und ein Dotantenmaterial umfasst, und die Elektronensteuerschicht ein Elektronensteuermaterial umfasst, wobei das Energieniveau des höchsten besetzten Molekülorbitals (HOMO) des Hostmaterials ($EH_H$), das Energieniveau des niedrigsten unbesetzten Molekülorbitals (LUMO) des Hostmaterials ($EL_H$), das HOMO-Energieniveau des Elektronensteuermaterials (EHc) und das LUMO-Energieniveau des Elektronensteuermaterials ($EL_C$) den beiden Beziehungen $|EH_H - EH_C| \leq 0{,}3$ eV und $|EL_H - EL_C| \leq 0{,}5$ eV genügen, wobei eine Dicke der Elektronensteuerschicht von 50 Å bis 450 Å (10 Å = 1 nm) beträgt und das Elektronensteuermaterial eine Verbindung, dargestellt durch nachstehende Formel 1, umfasst:

Formel 1

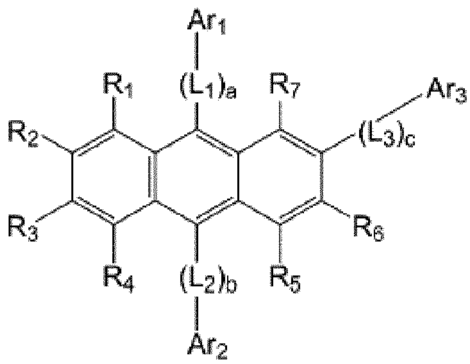

wobei $R_1$ bis $R_7$ jeweils unabhängig voneinander eines von einem Wasserstoffatom, einem Deuteriumatom, einem Halogenatom, einer Hydroxygruppe, einer Cyanogruppe, einer Nitrogruppe, einer Aminogruppe, einer Carboxylgruppe, einem substituierten oder unsubstituierten $C_1$-$C_{30}$-Alkylrest, einem substituierten oder unsubstituierten $C_2$-$C_{30}$-Alkenylrest, einem substituierten oder unsubstituierten $C_2$-$C_{30}$-Alkinylrest, einem substituierten oder unsubstituierten $C_1$-$C_{30}$-Alkoxyrest, einem substituierten oder unsubstituierten $C_3$-$C_{30}$-Cycloalkylrest, einem substituierten oder unsubstituierten $C_3$-$C_{30}$-Cycloalkenylrest und einem substituierten oder unsubstituierten $C_6$-$C_{30}$-Arylrest sind,
$Ar_1$, $Ar_2$ und $Ar_3$ jeweils unabhängig voneinander eines von einem substituierten oder unsubstituierten $C_6$-$C_{30}$-Arylrest, einem substituierten oder unsubstituierten $C_6$-$C_{30}$-Aryloxy-rest, einem substituierten oder unsubstituierten $C_6$-$C_{30}$-Arylthiorest, einem substituierten oder unsubstituierten $C_2$-$C_{30}$-Heteroarylrest und einem durch -N($Q_1$)($Q_2$) dargestellten Rest sind, wobei mindestens eines von $Ar_1$, $Ar_2$ und $Ar_3$ ein substituierter oder unsubstituierter $C_2$-$C_{30}$-Heteroarylrest ist, wobei $Q_1$ und $Q_2$ jeweils unabhängig voneinander eines von einem Wasserstoffatom, einem Deuteriumatom, einem Halogenatom, einer Hydroxygruppe, einer Cyanogruppe, einer Aminogruppe, einer Nitrogruppe, einer Carboxylgruppe, einem substituierten oder unsubstituierten $C_1$-$C_{30}$-Alkylrest, einem substituierten oder unsubstituierten $C_2$-$C_{30}$-Alkenylrest, einem substituierten oder unsubstituierten $C_2$-$C_{30}$-Alkinylrest, einem substituierten oder unsubstituierten $C_1$-$C_{30}$-Alkoxyrest, einem substituierten oder

unsubstituierten $C_3$-$C_{30}$-Cycloalkylrest, einem substituierten oder unsubstituierten $C_3$-$C_{30}$-Cycloalkenylrest, einem substituierten oder unsubstituierten $C_6$-$C_{30}$-Arylrest, einem substituierten oder unsubstituierten $C_6$-$C_{30}$-Aryloxyrest, einem substituierten oder unsubstituierten $C_6$-$C_{30}$-Arylthiorest und einem substituierten oder unsubstituierten $C_2$-$C_{30}$-Heteroarylrest sind, $L_1$, $L_2$ und $L_3$ jeweils unabhängig voneinander eines von einem substituierten oder unsubstituierten $C_6$-$C_{30}$-Arylenrest und einem substituierten oder unsubstituierten $C_2$-$C_{30}$-Heteroarylenrest sind, und

a, b und c jeweils unabhängig voneinander 0, 1, 2 oder 3 sind.

**2.** OLED nach Anspruch 1, wobei $EH_H$, $EL_H$, $EH_C$ und $EL_C$ den beiden Beziehungen $0 \leq EH_H - EH_C \leq 0{,}3$ eV und $0 \leq EL_H - EL_C \leq 0{,}5$ eV genügen.

**3.** OLED nach Anspruch 1 oder Anspruch 2, wobei die Elektronenbeweglichkeit des Elektronensteuermaterials größer als die oder gleich der Löcherbeweglichkeit des Elektronensteuermaterials ist.

**4.** OLED nach einem vorangehenden Anspruch, wobei $EH_C$ von -5,2 eV bis -6,1 eV beträgt, und/oder wobei $EL_C$ von -2,5 eV bis -3,2 eV beträgt, wobei die HOMO- und LUMO-Energieniveaus mittels zyklischer Voltammetrie gemessen werden.

**5.** OLED nach einem vorangehenden Anspruch, wobei der Gehalt an dem Elektronensteuermaterial von 30 Gewichtsprozent (Gew.-%) bis 100 Gew.-%, bezogen auf das Gesamtgewicht der Elektronensteuerschicht, beträgt.

**6.** OLED nach einem vorangehenden Anspruch, wobei das Dickenverhältnis der Elektronentransportschicht und der Elektronensteuerschicht von 5:1 bis 5:10 beträgt.

**7.** OLED nach einem vorangehenden Anspruch, umfassend

eine Elektronenblockierschicht, angeordnet zwischen der phosphoreszierenden Emissionsschicht und der ersten Elektrode,

wobei die Elektronenblockierschicht ein Elektronenblockiermaterial umfasst, und das LUMO-Energieniveau des Elektronenblockiermaterials $EL_B$ der Beziehung $EL_B > EL_H$ genügt.

**8.** OLED nach Anspruch 7, wobei das Elektronenblockiermaterial mindestens eines von einem Triphenylaminderivat, einem Carbazolderivat und einem Spirobifluorenderivat umfasst.

**9.** OLED nach Anspruch 7 oder Anspruch 8, wobei eine Dicke der Elektronenblockierschicht von 10 Å bis 1000 Å beträgt.

**10.** OLED nach einem vorangehenden Anspruch, wobei das Elektronensteuermaterial mindestens eine Verbindung, dargestellt durch nachstehende Formeln 2 und 3, umfasst:

Formel 2

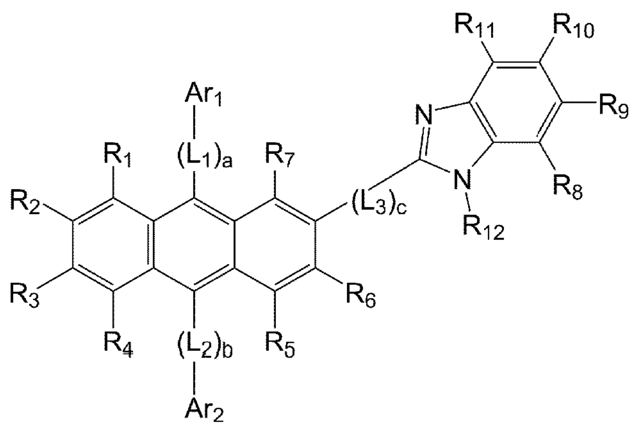

Formel 3

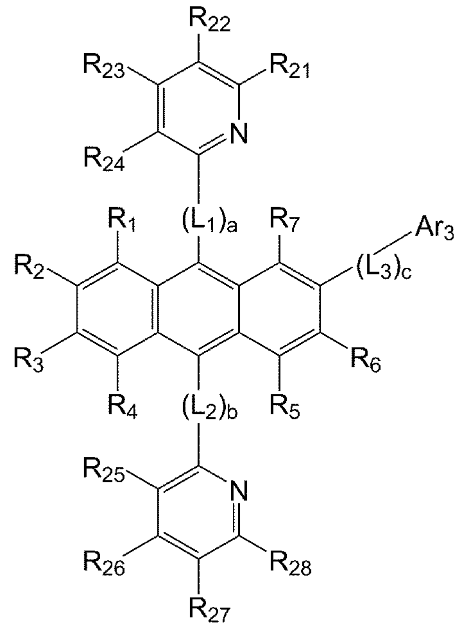

wobei, in den Formeln 2 und 3, $R_1$ bis $R_{12}$ und $R_{21}$ bis $R_{28}$ jeweils unabhängig voneinander eines von einem Wasserstoffatom, einem Deuteriumatom, einer substituierten oder unsubstituierten Methylgruppe, einer substituierten oder unsubstituierten Ethylgruppe, einer substituierten oder unsubstituierten Propylgruppe, einer substituierten oder unsubstituierten Butylgruppe, einer substituierten oder unsubstituierten Phenylgruppe, einer substituierten oder unsubstituierten Biphenylgruppe, einer substituierten oder unsubstituierten Naphthylgruppe, einer substituierten oder unsubstituierten Anthrylgruppe, einer substituierten oder unsubstituierten Phenanthrenylgruppe, einer substituierten oder unsubstituierten Pyrenylgruppe sind, $Ar_1$, $Ar_2$ und $Ar_3$ jeweils unabhängig voneinander eines von einer substituierten oder unsubstituierten Phenylgruppe, einer substituierten oder unsubstituierten Pentalenylgruppe, einer substituierten oder unsubstituierten Indenylgruppe, einer substituierten oder unsubstituierten Naphthylgruppe, einer substituierten oder unsubstituierten Azulenylgruppe, einer substituierten oder unsubstituierten Heptalenylgruppe, einer substituierten oder unsubstituierten Indacenylgruppe, einer substituierten oder unsubstituierten Acenaphthylgruppe, einer substituierten oder unsubstituierten Fluorenylgruppe, einer substituierten oder unsubstituierten Spirofluorenylgruppe, einer substituierten oder unsubstituierten Phenalenylgruppe, einer substituierten oder unsubstituierten Phenanthrenylgruppe, einer substituierten oder unsubstituierten Anthrylgruppe, einer substituierten oder unsubstituierten Fluoranthenylgruppe, einer substituierten oder unsubstituierten Triphenylenylgruppe, einer substituierten oder unsubstituierten Pyrenylgruppe, einer substituierten oder unsubstituierten Chrysenylgruppe, einer substituierten oder unsubstituierten Naphthacenylgruppe, einer substituierten oder unsubstituierten Picenylgruppe, einer substituierten oder unsubstituierten Perylenylgruppe, einer substituierten oder unsubstituierten Pentaphenylgruppe, einer substituierten oder unsubstituierten Hexacenylgruppe, einer substituierten oder unsubstituierten Pyrrolylgruppe, einer substituierten oder unsubstituierten Imidazolylgruppe, einer substituierten oder unsubstituierten Pyrazolylgruppe, einer substituierten oder unsubstituierten Pyridinylgruppe, einer substituierten oder unsubstituierten Bipyridinylgruppe, einer substituierten oder unsubstituierten Pyrazinylgruppe, einer substituierten oder unsubstituierten Pyrimidinylgruppe, einer substituierten oder unsubstituierten Pyridazinylgruppe, einer substituierten oder unsubstituierten Isoindolylgruppe, einer substituierten oder unsubstituierten Indolylgruppe, einer substituierten oder unsubstituierten Indazolylgruppe, einer substituierten oder unsubstituierten Purinylgruppe, einer substituierten oder unsubstituierten Chinolinylgruppe, einer substituierten oder unsubstituierten Benzochinolinylgruppe, einer substituierten oder unsubstituierten Phthalazinylgruppe, einer substituierten oder unsubstituierten Naphthyridinylgruppe, einer substituierten oder unsubstituierten Chinoxalinylgruppe, einer substituierten oder unsubstituierten Chinazolinylgruppe, einer substituierten oder unsubstituierten Cinnolinylgruppe, einer substituierten oder unsubstituierten Carbazolylgruppe, einer substituierten oder unsubstituierten Phenanthridinylgruppe, einer substituierten oder unsubstituierten Acridinylgruppe, einer substituierten oder unsubstituierten Phenanthrolinylgruppe, einer substituierten oder unsubstituierten Phenazinylgruppe, einer substituierten oder unsubstituierten Benzooxazolylgruppe, einer substituierten oder unsubstituierten Benzoimidazolylgruppe, einer substituierten oder unsubstituierten Furanylgruppe, einer substituierten oder unsubstituierten Benzofuranylgruppe, einer substituierten oder unsubstituierten Thiophenylgruppe, einer substituierten oder unsubstituierten Benzothiophenylgruppe, einer substituierten oder unsubstituierten Thiazolylgruppe, einer substituierten oder unsubstituierten Isothiazolylgruppe, einer substituierten oder unsubstituierten Benzothiazolylgruppe, einer substituierten oder unsubstituierten Isoxazolylgruppe, einer substituierten oder unsubstituierten Oxazolylgruppe, einer substituierten oder unsubstituierten Triazolylgruppe, einer substituierten oder unsubstituierten Tetrazolylgruppe, einer substituierten oder unsubstituierten Oxadiazolylgruppe, einer substituierten oder unsubstituierten Triazinylgruppe, einer substituierten oder unsubstituierten Benzooxazolylgruppe, einer substituierten oder unsubstituierten Dibenzopuranylgruppe, einer substituierten oder unsubstituierten Dibenzothiophenylgruppe und einer substituierten oder unsubstituierten Benzocarbazolylgruppe sind,

$L_1$, $L_2$ und $L_3$ jeweils unabhängig voneinander eines von einer substituierten oder unsubstituierten Phenylengruppe, einer substituierten oder unsubstituierten Pentalenylengruppe, einer substituierten oder unsubstituierten Indenylengruppe, einer substituierten oder unsubstituierten Naphthylengruppe, einer substituierten oder unsubstituierten Azulenylengruppe, einer substituierten oder unsubstituierten Heptalenylengruppe, einer substituierten oder unsubstituierten Indacenylengruppe, einer substituierten oder unsubstituierten Acenaphthylengruppe, einer substituierten oder unsubstituierten Fluorenylengruppe, einer substituierten oder unsubstituierten Phenalenylengruppe, einer substituierten oder unsubstituierten Phenanthrenylengruppe, einer substituierten oder unsubstituierten Anthrylengruppe, einer substituierten oder unsubstituierten Fluoranthenylengruppe, einer substituierten oder unsubstituierten Triphenylenylengruppe, einer substituierten oder unsubstituierten Pyrenylengruppe, einer substituierten oder unsubstituierten Chrysenylengruppe, einer substituierten oder unsubstituierten Naphthacenylengruppe, einer substituierten oder unsubstituierten Picenylengruppe, einer substituierten oder unsubstituierten Perylenylengruppe, einer substituierten oder unsubstituierten Pentaphenylengruppe, einer substituierten oder unsubstituierten Hexacenylengruppe, einer substituierten oder unsubstituierten Pyrrolylengruppe, einer substituierten oder unsubstituierten Pyrazolylengruppe, einer substituierten oder unsubstituierten Imidazolylengruppe, einer substituierten oder unsubstituierten Imidazolinylengruppe, einer substituierten oder unsubstituierten Imidazopyridinylengruppe, einer substituierten oder unsubstituierten Imidazopyrimidinylengruppe, einer substituierten oder unsubstituierten Pyridinylengruppe, einer substituierten oder unsubstituierten Pyrazinylengruppe, einer substituierten oder unsubstituierten Pyrimidinylengruppe, einer substituierten oder unsubstituierten Indolylengruppe, einer substituierten oder unsubstituierten Purinylengruppe, einer substituierten oder unsubstituierten Chinolinylengruppe, einer substituierten oder unsubstituierten Phthalazinylengruppe, einer substituierten oder unsubstituierten Indolizinylengruppe, einer substituierten oder unsubstituierten Naphthyridinylengruppe, einer substituierten oder unsubstituierten Chinazolinylengruppe, einer substituierten oder unsubstituierten Cinnolinylengruppe, einer substituierten oder unsubstituierten Indazolylengruppe, einer substituierten oder unsubstituierten Carbazolylengruppe, einer substituierten oder unsubstituierten Phenazinylengruppe, einer substituierten oder unsubstituierten Phenanthridinylengruppe, einer substituierten oder unsubstituierten Pyranylengruppe, einer substituierten oder unsubstituierten Chromenylengruppe, einer substituierten oder unsubstituierten Furanylengruppe, einer substituierten oder unsubstituierten Benzofuranylengruppe, einer substituierten oder unsubstituierten Thiophenylengruppe, einer substituierten oder unsubstituierten Benzothiophenylengruppe, einer substituierten oder unsubstituierten Isothiazolylengruppe, einer substituierten oder unsubstituierten Benzoimidazolylengruppe, einer substituierten oder unsubstituierten Isoxazolylengruppe, einer substituierten oder unsubstituierten Dibenzothiophenylengruppe, einer substituierten oder unsubstituierten Dibenzopuranylengruppe, einer substituierten oder unsubstituierten Triazinylengruppe und einer substituierten oder unsubstituierten Oxadiazolylengruppe sind, und

a, b und c jeweils unabhängig voneinander eine der ganzen Zahlen von 0 bis 1 sind.

**11.** OLED nach einem vorangehenden Anspruch, wobei das Elektronensteuermaterial mindestens eine von den nachstehenden Verbindungen 1 und 2 umfasst:

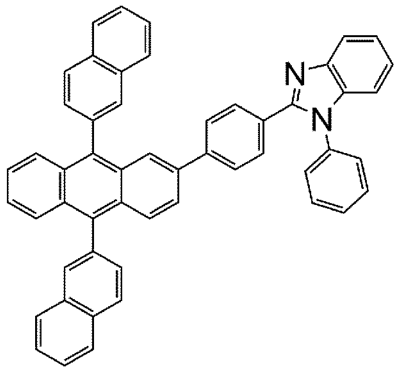 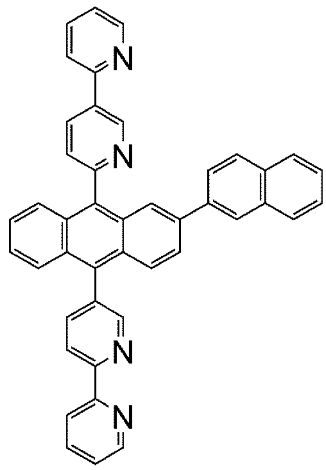

1 2

12. OLED nach einem vorangehenden Anspruch, wobei das Hostmaterial eine bipolare Verbindung mit sowohl einer Lochtransporteinheit als auch einer Elektronentransporteinheit umfasst.

13. OLED nach einem vorangehenden Anspruch, wobei das Hostmaterial ein Gemisch aus einer bipolaren Verbindung mit sowohl einer Lochtransporteinheit als auch einer Elektronentransporteinheit und einer Verbindung mit zumindest einer Lochtransporteinheit umfasst.

14. OLED nach einem vorangehenden Anspruch, wobei die phosphoreszierende Emissionsschicht rotes oder grünes Licht emittiert.

15. OLED nach einem vorangehenden Anspruch, wobei die Elektronentransportschicht eine Verbindung, dargestellt durch nachstehende Formel 4, umfasst:

Formel 4

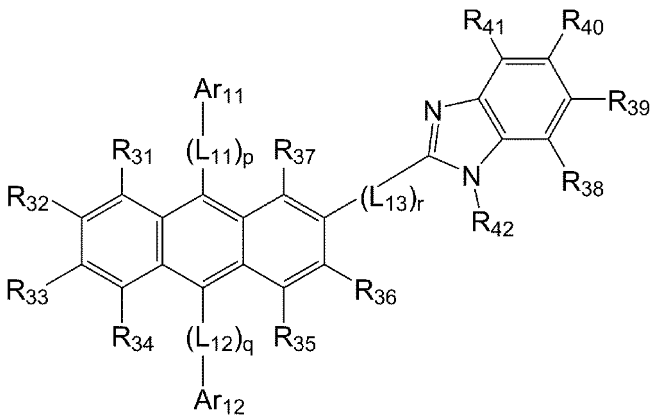

wobei $R_{31}$ bis $R_{42}$ jeweils unabhängig voneinander eines von einem Wasserstoffatom, einem Deuteriumatom, einer substituierten oder unsubstituierten Methylgruppe, einer substituierten oder unsubstituierten Ethylgruppe, einer substituierten oder unsubstituierten Propylgruppe, einer substituierten oder unsubstituierten Butylgruppe, einer substituierten oder unsubstituierten Phenylgruppe, einer substituierten oder unsubstituierten Biphenylgruppe, einer substituierten oder unsubstituierten Naphthylgruppe, einer substituierten oder unsubstituierten Anthrylgruppe, einer substituierten oder unsubstituierten Phenanthrenylgruppe, einer substituierten oder unsubstituierten Pyrenylgruppe sind,

$Ar_{11}$ und $Ar_{12}$ jeweils unabhängig voneinander eines von einer substituierten oder unsubstituierten Phenylgruppe, einer substituierten oder unsubstituierten Pentalenylgruppe, einer substituierten oder unsubstituierten Indenylgruppe, einer substituierten oder unsubstituierten Naphthylgruppe, einer substituierten oder unsubstituierten Azulenylgruppe, einer substituierten oder unsubstituierten Heptalenylgruppe, einer substituierten oder unsubstituierten Indacenylgruppe, einer substituierten oder unsubstituierten Acenaphthylgruppe, einer substituierten oder unsubstituierten Fluorenylgruppe, einer substituierten oder unsubstituierten Spirofluorenylgruppe, einer substituierten oder unsubstituierten Phenalenylgruppe, einer substituierten oder unsubstituierten Phenanthrenylgruppe, einer substituierten oder unsubstituierten Anthrylgruppe, einer substituierten oder unsubstituierten Fluoranthenylgruppe, einer substituierten oder unsubstituierten Triphenylenylgruppe, einer substituierten oder unsubstituierten Pyrenylgruppe, einer substituierten oder unsubstituierten Chrysenylgruppe, einer substituierten oder unsubstituierten Naphthacenylgruppe, einer substituierten oder unsubstituierten Picenylgruppe, einer substituierten oder unsubstituierten Perylenylgruppe, einer substituierten oder unsubstituierten Pentaphenylgruppe, einer substituierten oder unsubstituierten Hexacenylgruppe, einer substituierten oder unsubstituierten Pyrrolylgruppe, einer substituierten oder unsubstituierten Imidazolylgruppe, einer substituierten oder unsubstituierten Pyrazolylgruppe, einer substituierten oder unsubstituierten Pyridinylgruppe, einer substituierten oder unsubstituierten Bipyridinylgruppe, einer substituierten oder unsubstituierten Pyrazinylgruppe, einer substituierten oder unsubstituierten Pyrimidinylgruppe, einer substituierten oder unsubstituierten Pyridazinylgruppe, einer substituierten oder unsubstituierten Isoindolylgruppe, einer substituierten oder unsubstituierten Indolylgruppe, einer substituierten oder unsubstituierten Indazolylgruppe, einer substituierten oder unsubstituierten Purinylgruppe, einer substituierten oder unsubstituierten Chinolinylgruppe, einer substituierten oder unsubstituierten Benzochinolinylgruppe, einer substituierten oder unsubstituierten Phthalazinylgruppe, einer substituierten oder unsubstituierten Naphthyridinylgruppe, einer substituierten oder unsubstituierten Chinoxalinylgruppe, einer substituierten oder unsubstituierten Chinazolinylgruppe, einer substituierten oder unsubstituierten Cinnolinylgruppe, einer substituierten oder unsubstituierten Carbazolylgruppe, einer substituierten oder unsubstituierten Phenanthridinylgruppe, einer substituierten oder unsubstituierten Acridinylgruppe, einer substituierten oder unsubstituierten Phenanthrolinylgruppe, einer substituierten oder unsubstituierten Phenazinylgruppe, einer substituierten oder unsubstituierten Benzooxazolylgruppe, einer substituierten oder unsubstituierten Benzoimidazolylgruppe, einer substituierten oder unsubstituierten Furanylgruppe, einer substituierten oder unsubstituierten Benzofuranylgruppe, einer substituierten oder unsubstituierten Thiophenylgruppe, einer substituierten oder unsubstituierten Benzothiophenylgruppe, einer substituierten oder unsubstituierten Thiazolylgruppe, einer substituierten oder unsubstituierten Isothiazolylgruppe, einer substituierten oder unsubstituierten Benzothiazolylgruppe, einer substituierten oder unsubstituierten Isoxazolylgruppe, einer substituierten oder unsubstituierten Oxazolylgruppe, einer substituierten oder unsubstituierten Triazolylgruppe, einer substituierten oder unsubstituierten Tetrazolylgruppe, einer substituierten oder unsubstituierten Oxadiazolylgruppe, einer substituierten oder unsubstituierten Triazinylgruppe, einer substituierten oder unsubstituierten Benzooxazolylgruppe, einer substituierten oder unsubstituierten Dibenzopuranylgruppe, einer substituierten oder unsubstituierten Dibenzothiophenylgruppe und einer substituierten oder unsubstituierten Benzocarbazolylgruppe sind,

$L_{11}$, $L_{12}$ und $L_{13}$ jeweils unabhängig voneinander eines von einer substituierten oder unsubstituierten Phenylengruppe, einer substituierten oder unsubstituierten Pentalenylengruppe, einer substituierten oder unsubstituierten Indenylengruppe, einer substituierten oder unsubstituierten Naphthylengruppe, einer substituierten oder unsubstituierten Azulenylengruppe, einer substituierten oder unsubstituierten Heptalenylengruppe, einer substituierten oder unsubstituierten Indacenylengruppe, einer substituierten oder unsubstituierten Acenaphthylengruppe, einer substituierten oder unsubstituierten Fluorenylengruppe, einer substituierten oder unsubstituierten Phenalenylengruppe, einer substituierten oder unsubstituierten Phenanthrenylengruppe, einer substituierten oder unsubstituierten Anthrylengruppe, einer substituierten oder unsubstituierten Fluoranthenylengruppe, einer substituierten oder unsubstituierten Triphenylenylengruppe, einer substituierten oder unsubstituierten Pyrenylengruppe, einer substituierten oder unsubstituierten Chrysenylengruppe, einer substituierten oder unsubstituierten Naphthacenylengruppe, einer substituierten oder unsubstituierten Picenylengruppe, einer substituierten oder unsubstituierten Perylenylengruppe, einer substituierten oder unsubstituierten Pentaphenylengruppe, einer substituierten oder unsubstituierten Hexacenylengruppe, einer substituierten oder unsubstituierten Pyrrolylengruppe, einer substituierten oder unsubstituierten Pyrazolylengruppe, einer substituierten oder unsubstituierten Imidazolylengruppe, einer substituierten oder unsubstituierten Imidazolinylengruppe, einer substituierten oder unsubstituierten Imidazopyridinylengruppe, einer substituierten oder unsubstituierten Imidazopyrimidinylengruppe, einer substituierten oder unsubstituierten Pyridinylengruppe, einer substituierten oder unsubstituierten Pyrazinylengruppe, einer substituierten oder unsubstituierten Pyrimidinylengruppe, einer substituierten oder unsubstituierten Indolylengruppe, einer substituierten oder unsubstituierten Purinylengruppe, einer substituierten oder unsubstituierten Chinolinylengruppe, einer substituierten oder unsubstituierten Phthalazinylengruppe, einer substituierten oder unsubstituierten Indolizinylengruppe, einer substituierten oder unsubstituierten Naphthyridinylengruppe, einer substituierten oder unsubstituierten Chinazolinylengruppe, einer substituierten oder unsubstituierten Cinnolinylengruppe, einer substituierten oder unsubstituierten Indazolylengruppe, einer substituierten oder unsubstituierten Carbazolylengruppe, einer substituierten oder unsubstituierten Phenazinylengruppe, einer substituierten oder unsubstituierten Phenanthridinylengruppe, einer substituierten oder unsubstituierten Pyranylengruppe, einer substituierten oder unsubstituierten Chromenylengruppe, einer substituierten oder unsubstituierten Furanylengruppe, einer substituierten oder unsubstituierten Benzofuranylengruppe, einer substituierten oder unsubstituierten Thiophenylengruppe, einer substituierten oder unsubstituierten Benzothiophenylengruppe, einer substituierten oder unsubstituierten Isothiazolylengruppe, einer substituierten oder unsubstituierten Benzoimidazolylengruppe, einer substituierten oder unsubstituierten Isoxazolylengruppe, einer substituierten oder unsubstituierten Dibenzothiophenylengruppe, einer substituierten oder unsubstituierten Dibenzopuranylengruppe, einer substituierten oder unsubstituierten Triazinylengruppe und einer substituierten oder unsubstituierten Oxadiazolylengruppe sind, und

p, q und r jeweils unabhängig voneinander eine ganze Zahl von 0 bis 1 sind.

**16.** OLED nach Anspruch 15, wobei die Elektronentransportschicht weiterhin mindestens eines, ausgewählt aus einem Lithiumchinolat (LiQ) und nachstehender Verbindung 101, umfasst:

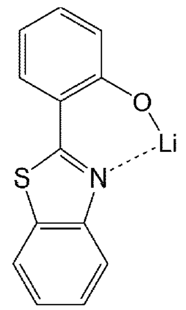

101

**17.** OLED nach Anspruch 15 oder Anspruch 16, wobei die Elektronentransportschicht weiterhin mindestens eines, ausgewählt aus 1,4,5,8,9,12-Hexaazatriphenylenhexacarbonitril, Tetracyanochinodimethan, Anthrachinon, Perylenbisimid und Tetracyanoanthrachinodimethan, umfasst.

**18.** OLED nach einem der Ansprüche 15 bis 17, wobei die Elektronentransportschicht weiterhin mindestens eines, ausgewählt aus mindestens einem Metall, ausgewählt aus Li, Cs, Na, K, Ca, Mg, Ba und Ra; Metallcarbonat; Metallacetat; Metallbenzoat; Metallacetoacetat; Metallacetylacetonat; und Metallstearat, umfasst.

**19.** OLED nach einem vorangehenden Anspruch, wobei die OLED weiterhin eine Lochtransportschicht, angeordnet zwischen der phosphoreszierenden Emissionsschicht und der ersten Elektrode, umfasst, wobei die Lochtransportschicht eine Verbindung, dargestellt durch nachstehende Formel 5, umfasst:

Formel 5

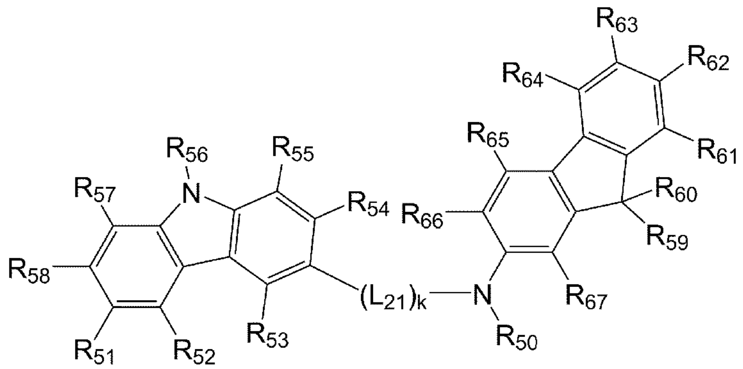

wobei $R_{50}$ eines von einer substituierten oder unsubstituierten Phenylgruppe, einer substituierten oder unsubstituierten Naphthylgruppe, einer substituierten oder unsubstituierten Anthrylgruppe, einer substituierten oder unsubstituierten Biphenylgruppe und einer substituierten oder unsubstituierten Pyridylgruppe ist;

$L_{21}$ eines von einem substituierten oder unsubstituierten $C_1$-$C_{30}$-Alkylenrest, einem substituierten oder unsubstituierten $C_2$-$C_{30}$-Alkenylenrest, einem substituierten oder unsubstituierten $C_6$-$C_{30}$-Arylenrest und einem substituierten oder unsubstituierten $C_2$-$C_{30}$-Heteroarylenrest ist; $R_{51}$ bis $R_{67}$ jeweils unabhängig voneinander eines von einem

Wasserstoffatom, einem Deuteriumatom, einem Halogenatom, einer Hydroxygruppe, einer Cyanogruppe, einer Nitrogruppe, einer Carboxylgruppe, einem substituierten oder unsubstituierten $C_1$-$C_{30}$-Alkylrest, einem substituierten oder unsubstituierten $C_2$-$C_{30}$-Alkenylrest, einem substituierten oder unsubstituierten $C_2$-$C_{30}$-Alkinylrest, einem substituierten oder unsubstituierten $C_1$-$C_{30}$-Alkoxyrest, einem substituierten oder unsubstituierten $C_1$-$C_{30}$-Alkylthiolrest, einem substituierten oder unsubstituierten $C_3$-$C_{30}$-Cycloalkylrest, einem substituierten oder unsubstituierten $C_3$-$C_{30}$-Cycloalkenylrest, einem substituierten oder unsubstituierten $C_6$-$C_{30}$-Arylrest, einem substituierten oder unsubstituierten $C_6$-$C_{30}$-Aryloxyrest, einem substituierten oder unsubstituierten $C_6$-$C_{30}$-Arylthiorest, einem substituierten oder unsubstituierten $C_2$-$C_{30}$-Heteroarylrest und einem durch -N($Q_{11}$)($Q_{12}$) dargestellten Rest sind; $Q_{11}$ und $Q_{12}$ jeweils unabhängig voneinander eines von einem Wasserstoffatom, einem Deuteriumatom, einem Halogenatom, einer Hydroxygruppe, einer Cyanogruppe, einer Aminogruppe, einer Nitrogruppe, einer Carboxylgruppe, einem $C_1$-$C_{30}$-Alkylrest, einem $C_2$-$C_{30}$-Alkenylrest, einem $C_2$-$C_{30}$-Alkinylrest, einem $C_1$-$C_{30}$-Alkoxyrest, einem $C_1$-$C_{30}$-Alkylthiolrest einem $C_3$-$C_{30}$-Cycloalkylrest, einem $C_3$-$C_{30}$-Cycloalkenylrest, einem $C_6$-$C_{30}$-Arylrest, einem $C_6$-$C_{30}$-Aryloxyrest, einem $C_6$-$C_{30}$-Aryl-thiorest und einem $C_2$-$C_{30}$-Heteroarylrest sind; und
k 0, 1, 2 oder 3 ist.

**20.** OLED nach einem vorangehenden Anspruch, wobei die OLED weiterhin eine Lochinjektionsschicht, angeordnet zwischen der Lochtransportschicht und der ersten Elektrode, umfasst, wobei die Lochinjektionsschicht eine Verbindung, dargestellt durch nachstehende Formel 6, umfasst:

Formel 6

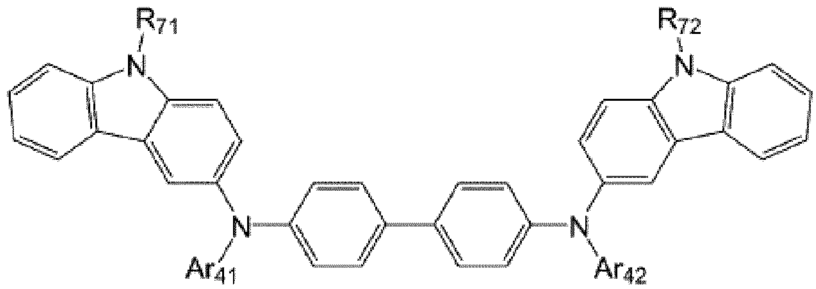

wobei $Ar_{41}$ und $Ar_{42}$ jeweils unabhängig voneinander eines von einem substituierten oder unsubstituierten $C_6$-$C_{30}$-Arylenrest und einem substituierten oder unsubstituierten $C_2$-$C_{30}$-Heteroarylenrest sind,
$R_{71}$ und $R_{72}$ jeweils unabhängig voneinander eines von einem Wasserstoffatom, einem Deuteriumatom, einem Halogenatom, einer Hydroxygruppe, einer Cyanogruppe, einer Nitrogruppe, einer Aminogruppe, einer Amidinogruppe, einem Hydrazin, einem Hydrazon, einer Carboxylgruppe oder einem Salz davon, einer Sulfonsäuregruppe oder einem Salz davon, einer Phosphorsäuregruppe oder einem Salz davon, einem substituierten oder unsubstituierten $C_1$-$C_{30}$-Alkylrest, einem substituierten oder unsubstituierten $C_2$-$C_{30}$-Alkenylrest, einem substituierten oder unsubstituierten $C_2$-$C_{30}$-Alkinylrest, einem substituierten oder unsubstituierten $C_1$-$C_{30}$-Alkoxyrest, einem substituierten oder unsubstituierten $C_3$-$C_{30}$-Cycloalkylrest, einem substituierten oder unsubstituierten $C_6$-$C_{30}$-Arylrest, einem substituierten oder unsubstituierten $C_6$-$C_{30}$-Aryloxyrest und einem substituierten oder unsubstituierten $C_6$-$C_{30}$-Arylthiorest sind.

**21.** Organische lichtemittierende Anzeigevorrichtung, umfassend einen Transistor mit Source, Drain, Gate und einer aktiven Schicht, und die OLED nach einem vorangehenden Anspruch, wobei eine erste Elektrode der OLED elektrisch verbunden mit Source oder Drain ist.

## Revendications

**1.** Dispositif électroluminescent organique (OLED) comprenant :

une première électrode ;
une seconde électrode opposée à la première électrode ;
une couche d’émission phosphorescente disposée entre la première électrode et la seconde électrode ;
une couche de transport d’électrons disposée entre la couche d’émission phosphorescente et la deuxième électrode ; et

une couche de contrôle d'électrons disposée entre la couche d'émission phosphorescente et la couche de transport d'électrons,

où la couche d'émission phosphorescente comprend un matériau hôte et un matériau dopant, et la couche de contrôle d'électrons comprend un matériau de contrôle d'électrons, où le niveau d'énergie orbitale moléculaire occupé le plus élevé (HOMO) du matériau hôte (EHH), le niveau d'énergie orbital moléculaire non occupé le plus faible (LUMO) et le niveau d'énergie LUMO du matériau de contrôle d'électrons ($EL_C$) satisfont aux deux relations de $|EH_H - EH_C| \leq 0{,}3$ eV et $|EL_H - EL_C| \leq 0{,}5$ eV, où une épaisseur de la couche de contrôle d'électrons est de 50 à 450 Å (10 Å = 1 nm) et le matériau de contrôle d'électrons comprend un composé représenté par la formule 1 ci-dessous :

Formule 1

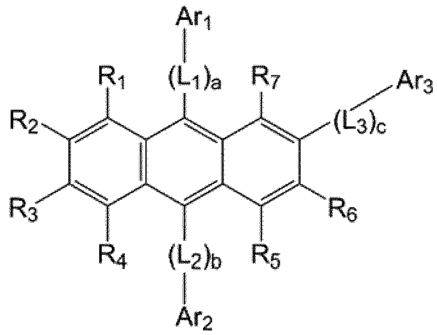

dans laquelle $R_1$ à $R_7$ sont chacun indépendamment l'un d'un hydrogène, d'un deutérium, d'un halogène, d'un groupe hydroxy, d'un groupe cyano, d'un groupe nitro, d'un groupe amino, d'un groupe carboxyle, d'un groupe alkyle en $C_1$ à $C_{30}$ substitué ou non substitué, d'un groupe alcényle en $C_2$ à $C_{30}$ substitué ou non substitué, d'un groupe alcynyle en $C_2$ à $C_{30}$ substitué ou non substitué, d'un groupe alkoxy en $C_1$ à $C_{30}$ substitué ou non substitué, d'un groupe cycloalkyle en $C_3$ à $C_{30}$ substitué ou non substitué, d'un groupe cycloalcényle en $C_3$ à $C_{30}$ substitué ou non substitué, et d'un groupe aryle en $C_6$ à $C_{30}$ substitué ou non substitué,

$Ar_1$, $Ar_2$ et $Ar_3$ sont chacun indépendamment l'un d'un groupe aryle en $C_6$ à $C_{30}$ substitué ou non substitué, d'un groupe aryloxy en $C_6$ à $C_{30}$ substitué ou non substitué, d'un groupe arylthio en $C_6$ à $C_{30}$ substitué ou non substitué, d'un groupe hétéroaryle en $C_2$ à $C_{30}$ substitué ou non substitué et d'un groupe représenté par $-N(Q_1)(Q_2)$, où au moins un de $Ar_1$, $Ar_2$ et $Ar_3$ est un groupe hétéroaryle en $C_2$ à $C_{30}$ substitué ou non substitué, où $Q_1$ et $Q_2$ sont chacun indépendamment l'un d'un hydrogène, d'un deutérium, d'un halogène, d'un groupe hydroxy, d'un groupe cyano, d'un groupe amino, d'un groupe nitro, d'un groupe carboxyle, d'un groupe alkyle en $C_1$ à $C_{30}$ substitué ou non substitué, d'un groupe alcényle en $C_2$ à $C_{30}$ substitué ou non substitué, d'un groupe alcynyle en $C_2$ à $C_{30}$ substitué ou non substitué, d'un groupe alkoxy en $C_1$ à $C_{30}$ substitué ou non substitué, d'un groupe cycloalkyle en $C_3$ à $C_{30}$ substitué ou non substitué, d'un groupe cycloalcényle en $C_3$ à $C_{30}$ substitué ou non substitué, d'un groupe aryle en $C_6$ à $C_{30}$ substitué ou non substitué, d'un groupe aryloxy en $C_6$ à $C_{30}$ substitué ou non substitué, d'un groupe arylthio en $C_6$ à $C_{30}$ substitué ou non substitué, et d'un groupe hétéroaryle en $C_2$ à $C_{30}$ substitué ou non substitué,

$L_1$, $L_2$ et $L_3$ sont chacun indépendamment l'un d'un groupe arylène en $C_6$ à $C_{30}$ substitué ou non substitué et d'un groupe hétéroarylène en $C_2$ à $C_{30}$ substitué ou non substitué, et

a, b et c valent chacun indépendamment 0, 1, 2 ou 3.

**2.** OLED selon la revendication 1, dans lequel $EH_H$, $EL_H$, $EH_C$ et $EL_C$ satisfont aux deux relations $0 \leq EH_H - EH_C \leq 0{,}3$ eV et $0 \leq EL_H - EL_C \leq 0{,}5$ eV.

**3.** OLED selon la revendication 1 ou la revendication 2, dans lequel la mobilité d'électron du matériau de contrôle d'électrons est supérieure ou égale à la mobilité de trou du matériau de contrôle d'électrons.

**4.** OLED selon l'une quelconque des revendications précédentes, dans lequel $EH_C$ est de -5,2 eV à -6,1 eV et/ou dans lequel $EL_C$ est de -2,5 eV à -3,2 eV, où les niveaux d'énergie HOMO et LUMO sont mesurés par voltamétrie cyclique.

**5.** OLED selon l'une quelconque des revendications précédentes, dans lequel la teneur du matériau de contrôle d'électrons est de 30 % en poids (% en poids) à 100 % en poids sur la base du poids total de la couche de contrôle d'électrons.

**6.** OLED selon l'une quelconque des revendications précédentes, dans lequel le rapport d'épaisseur de la couche de transport d'électrons et de la couche de contrôle d'électrons est de 5:1 à 5:10.

**7.** OLED selon l'une quelconque des revendications précédentes, comprenant :

une couche de blocage d'électrons disposée entre la couche d'émission phosphorescente et la première électrode,
où la couche de blocage d'électrons comprend un matériau de blocage d'électrons, et le niveau d'énergie LUMO du matériau de blocage d'électrons $EL_B$ satisfait à la relation de $EL_B > EL_H$.

**8.** OLED selon la revendication 7, dans lequel le matériau de blocage d'électrons comprend au moins l'un d'un dérivé de triphénylamine, d'un dérivé de carbazole et d'un dérivé de spirobifluorène.

**9.** OLED selon la revendication 7 ou 8, dans lequel une épaisseur de la couche de blocage d'électrons est de 10 à 1000 Å.

**10.** OLED selon l'une quelconque des revendications précédentes, dans lequel le matériau de contrôle d'électrons comprend au moins un composé représenté par les formules 2 et 3 ci-dessous :

Formule 2

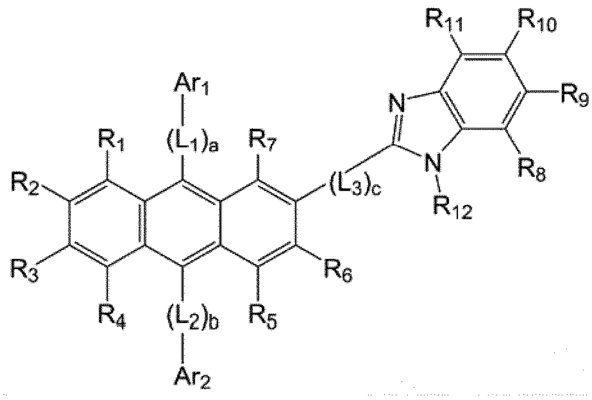

Formule 3

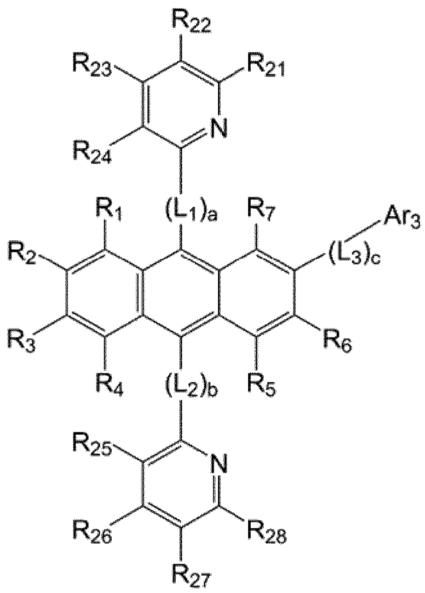

où, dans les formules 2 et 3, $R_1$ à $R_{12}$ et $R_{21}$ à $R_{28}$ sont chacun indépendamment l'un d'un hydrogène, d'un deutérium, d'un groupe méthyle substitué ou non substitué, d'un groupe éthyle substitué ou non substitué, d'un groupe propyle

substitué ou non substitué, d'un groupe butyle substitué ou non substitué, d'un groupe phényle substitué ou non substitué, d'un groupe biphényle substitué ou non substitué, d'un groupe naphtyle substitué ou non substitué, d'un groupe anthryle substitué ou non substitué, d'un groupe phénanthrényle substitué ou non substitué, d'un groupe pyrényle substitué ou non substitué,

$Ar_1$, $Ar_2$ et $Ar_3$ sont chacun indépendamment l'un d'un groupe phényle substitué ou non substitué, d'un groupe pentalényle substitué ou non substitué, d'un groupe indényle substitué ou non substitué, d'un groupe naphtyle substitué ou non substitué, d'un groupe azulényle substitué ou non substitué, d'un groupe heptalényle substitué ou non substitué, d'un groupe indacényle substitué ou non substitué, d'un groupe acénaphtyle substitué ou non substitué, d'un groupe fluorényle substitué ou non substitué, d'un groupe spirofluorényle substitué ou non substitué, d'un groupe phénalényle substitué ou non substitué, d'un groupe phénanthrényle substitué ou non substitué, d'un groupe anthryle substitué ou non substitué, d'un groupe fluoranthényle substitué ou non substitué, d'un groupe triphénylényle substitué ou non substitué, d'un groupe pyrényle substitué ou non substitué, d'un groupe chrysényle substitué ou non substitué, d'un groupe naphtacényle substitué ou non substitué, d'un groupe picényle substitué ou non substitué, d'un groupe pérylényle substitué ou non substitué, d'un groupe pentaphényle substitué ou non substitué, d'un groupe hexacényle substitué ou non substitué, d'un groupe pyrrolyle substitué ou non substitué, d'un groupe imidazolyle substitué ou non substitué, d'un groupe pyrazolyle substitué ou non substitué, d'un groupe pyridinyle substitué ou non substitué, d'un groupe bipyridinyle substitué ou non substitué, d'un groupe pyrazinyle substitué ou non substitué, d'un groupe pyrimidinyle substitué ou non substitué, d'un groupe pyridazinyle substitué ou non substitué, d'un groupe isoindolyle substitué ou non substitué, d'un groupe indolyle substitué ou non substitué, d'un groupe indazolyle substitué ou non substitué, d'un groupe purinyle substitué ou non substitué, d'un groupe quinolinyle substitué ou non substitué, d'un groupe benzoquinolinyle substitué ou non substitué, d'un groupe phtalazinyle substitué ou non substitué, d'un groupe naphtyridinyle substitué ou non substitué, d'un groupe quinoxalinyle substitué ou non substitué, d'un groupe quinazolinyle substitué ou non substitué, d'un groupe cinnolinyle substitué ou non substitué, d'un groupe carbazolyle substitué ou non substitué, d'un groupe phénanthridinyle substitué ou non substitué, d'un groupe acridinyle substitué ou non substitué, d'un groupe phénanthrolinyle substitué ou non substitué, d'un groupe phénazinyle substitué ou non substitué, d'un groupe benzooxazolyle substitué ou non substitué, d'un groupe benzoimidazolyle substitué ou non substitué, d'un groupe furanyle substitué ou non substitué, d'un groupe benzo-furanyle substitué ou non substitué, d'un groupe thiophényle substitué ou non substitué, d'un groupe benzothiophényle substitué ou non substitué, d'un groupe thiazolyle substitué ou non substitué, d'un groupe isothiazolyle substitué ou non substitué, d'un groupe benzothiazolyle substitué ou non substitué, d'un groupe isoxazolyle substitué ou non substitué, d'un groupe oxazolyle substitué ou non substitué, d'un groupe triazolyle substitué ou non substitué, d'un groupe tétrazolyle substitué ou non substitué, d'un groupe oxadiazolyle substitué ou non substitué, d'un groupe triazinyle substitué ou non substitué, d'un groupe benzooxazolyle substitué ou non substitué, d'un groupe dibenzopuranyle substitué ou non substitué, d'un groupe dibenzothiophényle substitué ou non substitué et d'un groupe benzocarbazolyle substitué ou non substitué,

$L_1$, $L_2$ et $L_3$ sont chacun indépendamment l'un d'un groupe phénylène substitué ou non substitué, d'un groupe pentalénylène substitué ou non substitué, d'un groupe indénylène substitué ou non substitué, d'un groupe naphtylène substitué ou non substitué, d'un groupe azulénylène substitué ou non substitué, d'un groupe heptalénylène substitué ou non substitué, d'un groupe indacénylène substitué ou non substitué, d'un groupe acénaphtylène substitué ou non substitué, d'un groupe fluorénylène substitué ou non substitué, d'un groupe phénalénylène substitué ou non substitué, d'un groupe phénanthrénylène substitué ou non substitué, d'un groupe anthrylène substitué ou non substitué, d'un groupe fluoranthénylène substitué ou non substitué, d'un groupe triphénylénylène substitué ou non substitué, d'un groupe pyrénylène substitué ou non substitué, d'un groupe chrysénylène substitué ou non substitué, d'un groupe napthtacénylène substitué ou non substitué, d'un groupe picénylène substitué ou non substitué, d'un groupe pérylénylène substitué ou non substitué, d'un groupe pentaphénylène substitué ou non substitué, d'un groupe hexacénylène substitué ou non substitué, d'un groupe pyrrolylène substitué ou non substitué, d'un groupe pyrazolylène substitué ou non substitué, d'un groupe imidazolylène substitué ou non substitué, d'un groupe imidazolinylène substitué ou non substitué, d'un groupe imidazopyridinylène substitué ou non substitué, d'un groupe imidazopyrimidinylène substitué ou non substitué, d'un groupe pyridinylène substitué ou non substitué, d'un groupe pyrazinylène substitué ou non substitué, d'un groupe pyrimidinylène substitué ou non substitué, d'un groupe indolylène substitué ou non substitué, d'un groupe purinylène substitué ou non substitué, d'un groupe quinolinylène substitué ou non substitué, d'un groupe phtalazinylène substitué ou non substitué, d'un groupe indolizinylène substitué ou non substitué, d'un groupe naphtyridinylène substitué ou non substitué, d'un groupe quinazolinylène substitué ou non substitué, d'un groupe cinnolinylène substitué ou non substitué, d'un groupe indazolylène substitué ou non substitué, d'un groupe carbazolylène substitué ou non substitué, d'un groupe phénazinylène substitué ou non substitué, d'un groupe phénanthridinylène substitué ou non substitué, d'un groupe pyranylène substitué ou non substitué, d'un groupe chroménylène substitué ou non substitué, d'un groupe furanylène substitué ou non substitué, d'un groupe benzofuranylène substitué ou non substitué, d'un groupe thiophénylène substitué ou non substitué,

d'un groupe benzothiophénylène substitué ou non substitué, d'un groupe isothiazolylène substitué ou non substitué, d'un groupe benzoimidazolylène substitué ou non substitué, d'un groupe isoxazolylène substitué ou non substitué, d'un groupe dibenzothiophénylène substitué ou non substitué, d'un groupe dibenzopuranylène substitué ou non substitué, d'un groupe triazinylène substitué ou non substitué, et d'un groupe oxadiazolylène substitué ou non substitué, et

a, b et c sont chacun indépendamment un des nombres entiers de 0 à 1.

**11.** OLED selon l'une quelconque des revendications précédentes, dans lequel le matériau de contrôle d'électrons comprend au moins un des composés 1 et 2 ci-dessous :

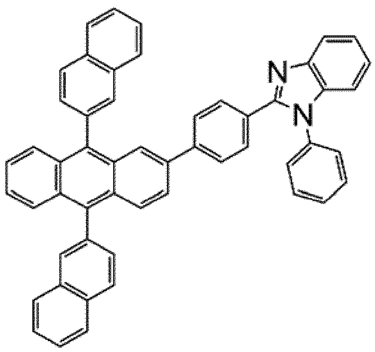

1

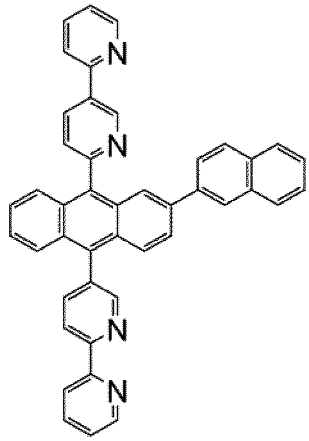

2

**12.** OLED selon l'une quelconque des revendications précédentes, dans lequel le matériau hôte comprend un composé bipolaire ayant à la fois une unité de transport de trous et une unité de transport d'électrons.

**13.** OLED selon l'une quelconque des revendications précédentes, dans lequel le matériau hôte comprend un mélange d'un composé bipolaire ayant à la fois une unité de transport de trous et une unité de transport d'électrons, et d'un composé ayant au moins une unité de transport de trous.

**14.** OLED selon l'une quelconque des revendications précédentes, dans lequel la couche d'émission phosphorescente émet de la lumière rouge ou verte.

**15.** OLED selon l'une quelconque des revendications précédentes, dans lequel la couche de transport d'électrons comprend un composé représenté par la formule 4 ci-dessous :

Formule 4

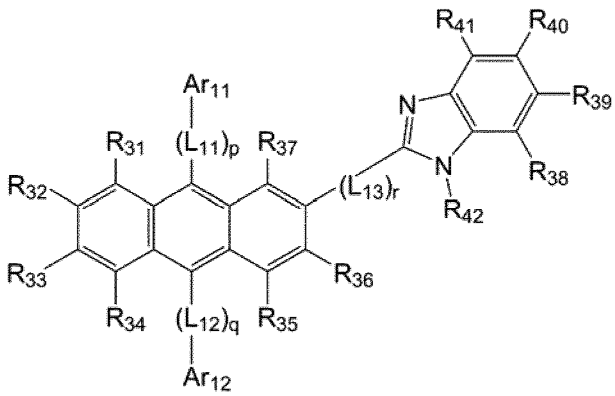

dans laquelle $R_{31}$ à $R_{42}$ sont chacun indépendamment l'un d'un hydrogène, d'un deutérium, d'un groupe méthyle

substitué ou non substitué, d'un groupe éthyle substitué ou non substitué, d'un groupe propyle substitué ou non substitué, d'un groupe butyle substitué ou non substitué, d'un groupe phényle substitué ou non substitué, d'un groupe biphényle substitué ou non substitué, d'un groupe naphtyle substitué ou non substitué, d'un groupe anthryle substitué ou non substitué, d'un groupe phénanthrényle substitué ou non substitué, d'un groupe pyrényle substitué ou non substitué,

$Ar_{11}$ et $Ar_{12}$ sont chacun indépendamment l'un d'un groupe phényle substitué ou non substitué, d'un groupe pentalényle substitué ou non substitué, d'un groupe indényle substitué ou non substitué, d'un groupe naphtyle substitué ou non substitué, d'un groupe azulényle substitué ou non substitué, d'un groupe heptalényle substitué ou non substitué, d'un groupe indacényle substitué ou non substitué, d'un groupe acénaphtyle substitué ou non substitué, d'un groupe fluorényle substitué ou non substitué, d'un groupe spirofluorényle substitué ou non substitué, d'un groupe phénalényle substitué ou non substitué, d'un groupe phénanthrényle substitué ou non substitué, d'un groupe anthryle substitué ou non substitué, d'un groupe fluoranthényle substitué ou non substitué, d'un groupe triphénylényle substitué ou non substitué, d'un groupe pyrényle substitué ou non substitué, d'un groupe chrysényle substitué ou non substitué, d'un groupe naphtacényle substitué ou non substitué, d'un groupe picényle substitué ou non substitué, d'un groupe pérylényle substitué ou non substitué, d'un groupe pentaphényle substitué ou non substitué, d'un groupe hexacényle substitué ou non substitué, d'un groupe pyrrolyle substitué ou non substitué, d'un groupe imidazolyle substitué ou non substitué, d'un groupe pyrazolyle substitué ou non substitué, d'un groupe pyridinyle substitué ou non substitué, d'un groupe bipyridinyle substitué ou non substitué, d'un groupe pyrazinyle substitué ou non substitué, d'un groupe pyrimidinyle substitué ou non substitué, d'un groupe pyridazinyle substitué ou non substitué, d'un groupe isoindolyle substitué ou non substitué, d'un groupe indolyle substitué ou non substitué, d'un groupe indazolyle substitué ou non substitué, d'un groupe purinyle substitué ou non substitué, d'un groupe quinolinyle substitué ou non substitué, d'un groupe benzoquinolinyle substitué ou non substitué, d'un groupe phtalazinyle substitué ou non substitué, d'un groupe naphtyridinyle substitué ou non substitué, d'un groupe quinoxalinyle substitué ou non substitué, d'un groupe quinazolinyle substitué ou non substitué, d'un groupe cinnolinyle substitué ou non substitué, d'un groupe carbazolyle substitué ou non substitué, d'un groupe phénanthridinyle substitué ou non substitué, d'un groupe acridinyle substitué ou non substitué, d'un groupe phénanthrolinyle substitué ou non substitué, d'un groupe phénazinyle substitué ou non substitué, d'un groupe benzooxazolyle substitué ou non substitué, d'un groupe benzoimidazolyle substitué ou non substitué, d'un groupe furanyle substitué ou non substitué, d'un groupe benzo-furanyle substitué ou non substitué, d'un groupe thiophényle substitué ou non substitué, d'un groupe benzothiophényle substitué ou non substitué, d'un groupe thiazolyle substitué ou non substitué, d'un groupe isothiazolyle substitué ou non substitué, d'un groupe benzothiazolyle substitué ou non substitué, d'un groupe isoxazolyle substitué ou non substitué, d'un groupe oxazolyle substitué ou non substitué, d'un groupe triazolyle substitué ou non substitué, d'un groupe tétrazolyle substitué ou non substitué, d'un groupe oxadiazolyle substitué ou non substitué, d'un groupe triazinyle substitué ou non substitué, d'un groupe benzooxazolyle substitué ou non substitué, d'un groupe dibenzopuranyle substitué ou non substitué, d'un groupe dibenzothiophényle substitué ou non substitué, et d'un groupe benzocarbazolyle substitué ou non substitué,

$L_{11}$, $L_{12}$ et $L_{13}$ sont chacun indépendamment l'un d'un groupe phénylène substitué ou non substitué, d'un groupe pentalénylène substitué ou non substitué, d'un groupe indénylène substitué ou non substitué, d'un groupe naphtylène substitué ou non substitué, d'un groupe azulénylène substitué ou non substitué, d'un groupe heptalénylène substitué ou non substitué, d'un groupe indacénylène substitué ou non substitué, d'un groupe acénaphtylène substitué ou non substitué, d'un groupe fluorénylène substitué ou non substitué, d'un groupe phénalénylène substitué ou non substitué, d'un groupe phénanthrénylène substitué ou non substitué, d'un groupe anthrylène substitué ou non substitué, d'un groupe fluoranthénylène substitué ou non substitué, d'un groupe triphénylénylène substitué ou non substitué, d'un groupe pyrénylène substitué ou non substitué, d'un groupe chrysénylène substitué ou non substitué, d'un groupe napthtacénylène substitué ou non substitué, d'un groupe picénylène substitué ou non substitué, d'un groupe pérylénylène substitué ou non substitué, d'un groupe pentaphénylène substitué ou non substitué, d'un groupe hexacénylène substitué ou non substitué, d'un groupe pyrrolylène substitué ou non substitué, d'un groupe pyrazolylène substitué ou non substitué, d'un groupe imidazolylène substitué ou non substitué, d'un groupe imidazolinylène substitué ou non substitué, d'un groupe imidazopyridinylène substitué ou non substitué, d'un groupe imidazopyrimidinylène substitué ou non substitué, d'un groupe pyridinylène substitué ou non substitué, d'un groupe pyrazinylène substitué ou non substitué, d'un groupe pyrimidinylène substitué ou non substitué, d'un groupe indolylène substitué ou non substitué, d'un groupe purinylène substitué ou non substitué, d'un groupe quinolinylène substitué ou non substitué, d'un groupe phtalazinylène substitué ou non substitué, d'un groupe indolizinylène substitué ou non substitué, d'un groupe naphtyridinylène substitué ou non substitué, d'un groupe quinazolinylène substitué ou non substitué, d'un groupe cinnolinylène substitué ou non substitué, d'un groupe indazolylène substitué ou non substitué, d'un groupe carbazolylène substitué ou non substitué, d'un groupe phénazinylène substitué ou non substitué, d'un groupe phénanthridinylène substitué ou non substitué, d'un groupe pyranylène substitué ou non substitué, d'un groupe chroménylène substitué ou non substitué, d'un groupe furanylène substitué ou non substitué,

d'un groupe benzofuranylène substitué ou non substitué, d'un groupe thiophénylène substitué ou non substitué, d'un groupe benzothiophénylène substitué ou non substitué, d'un groupe isothiazolylène substitué ou non substitué, d'un groupe benzoimidazolylène substitué ou non substitué, d'un groupe isoxazolylène substitué ou non substitué, d'un groupe dibenzothiophénylène substitué ou non substitué, d'un groupe dibenzopuranylène substitué ou non substitué, d'un groupe triazinylène substitué ou non substitué, et d'un groupe oxadiazolylène substitué ou non substitué, et

p, q et r sont chacun indépendamment un nombre entier de 0 à 1.

**16.** OLED selon la revendication 15, dans lequel la couche de transport d'électrons comprend en outre au moins l'un choisi parmi un quinolate de lithium (LiQ) et le composé 101 ci-dessous :

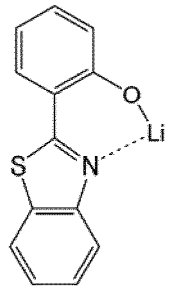

101

**17.** OLED selon la revendication 15 ou la revendication 16, dans lequel la couche de transport d'électrons comprend en outre au moins l'un choisi parmi le 1,4,5,8,9,12-hexaazatriphénylène-hexacarbonitrile, le tétra-cyanoquino-diméthane, l'anthraquinone, le pérylènebisimide et le tétracyanoanthraquinodiméthane.

**18.** OLED selon l'une quelconque des revendications 15 à 17, dans lequel la couche de transport d'électrons comprend en outre au moins l'un choisi parmi au moins un métal choisi parmi Li, Cs, Na, K, Ca, Mg, Ba et Ra ; un carbonate de métal ; un acétate de métal ; un benzoate de métal ; un acétoacétate de métal ; un acétylacétonate de métal ; et un stéarate de métal.

**19.** OLED selon l'une quelconque des revendications précédentes, l'OLED comprenant en outre une couche de transport de trous disposée entre la couche d'émission phosphorescente et la première électrode, où la couche de transport de trous comprend un composé représenté par la formule 5 ci-dessous :

Formule 5

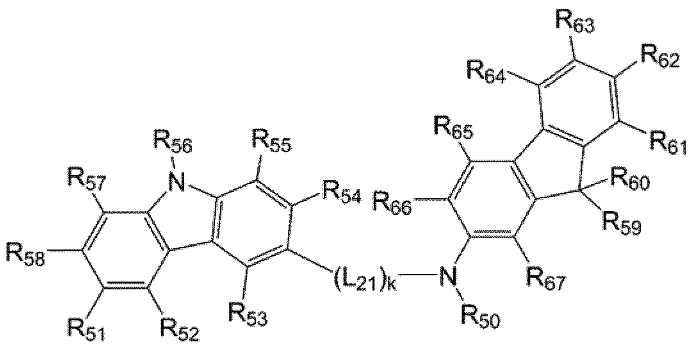

dans laquelle $R_{50}$ est l'un d'un groupe phényle substitué ou non substitué, d'un groupe naphtyle substitué ou non substitué, d'un groupe anthryle substitué ou non substitué, d'un groupe biphényle substitué ou non substitué, et d'un groupe pyridyle substitué ou non substitué ;

$L_{21}$ est l'un d'un groupe alkylène en $C_1$ à $C_{30}$ substitué ou non substitué, d'un groupe alcénylène en $C_2$ à $C_{30}$ substitué ou non substitué, d'un groupe arylène en $C_6$ à $C_{30}$ substitué ou non substitué, et d'un groupe hétéroarylène en $C_2$ à $C_{30}$ substitué ou non substitué ;

$R_{51}$ à $R_{67}$ sont chacun indépendamment l'un d'un hydrogène, d'un deutérium, d'un halogène, d'un groupe hydroxy,

d'un groupe cyano, d'un groupe nitro, d'un groupe carboxyle, d'un groupe alkyle en $C_1$ à $C_{30}$ substitué ou non substitué, d'un groupe alcényle en $C_2$ à $C_{30}$ substitué ou non substitué, d'un groupe alcynyle en $C_2$ à $C_{30}$ substitué ou non substitué, d'un groupe alkoxy en $C_1$ à $C_{30}$ substitué ou non substitué, d'un groupe alkylthiol en $C_1$ à $C_{30}$ substitué ou non substitué, d'un groupe cycloalkyle en $C_3$ à $C_{30}$ substitué ou non substitué, d'un groupe cycloalcényle en $C_3$ à $C_{30}$ substitué ou non substitué, d'un groupe aryle en $C_6$ à $C_{30}$ substitué ou non substitué, d'un groupe aryloxy en $C_6$ à $C_{30}$ substitué ou non substitué, d'un groupe arylthio en $C_6$ à $C_{30}$ substitué ou non substitué, d'un groupe hétéroaryle en $C_2$ à $C_{30}$ substitué ou non substitué, et d'un groupe représenté par $-N(Q_{11})(Q_{12})$ ; $Q_{11}$ et $Q_{12}$ sont chacun indépendamment l'un d'un hydrogène, d'un deutérium, d'un halogène, d'un groupe hydroxy, d'un groupe cyano, d'un groupe amino, d'un groupe nitro, d'un groupe carboxyle, d'un groupe alkyle en $C_1$ à $C_{30}$ substitué ou non substitué, d'un groupe alcényle en $C_2$ à $C_{30}$ substitué ou non substitué, d'un groupe alcynyle en $C_2$ à $C_{30}$ substitué ou non substitué, d'un groupe alkoxy en $C_1$ à $C_{30}$, d'un groupe alkylthiol en $C_1$ à $C_{30}$, d'un groupe cycloalkyle en $C_3$ à $C_{30}$, d'un groupe cycloalcényle en $C_3$ à $C_{30}$, d'un groupe aryle en $C_6$ à $C_{30}$, d'un groupe aryloxy en $C_6$ à $C_{30}$, d'un groupe arylthio en $C_6$ à $C_{30}$, et d'un groupe hétéroaryle en $C_2$ à $C_{30}$ ; et
k vaut 0, 1, 2 ou 3.

**20.** OLED selon l'une quelconque des revendications précédentes, l'OLED comprenant en outre une couche d'injection de trous disposée entre la couche de transport de trous et la première électrode, où la couche d'injection de trous comprend un composé représenté par la formule 6 ci-dessous :

Formule 6

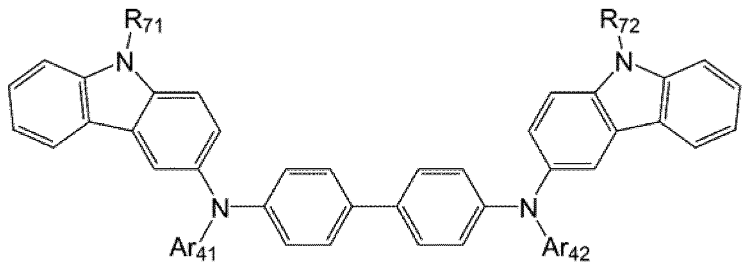

dans laquelle $Ar_{41}$ et $Ar_{42}$ sont chacun indépendamment l'un d'un groupe arylène en $C_6$ à $C_{30}$ substitué ou non substitué et d'un groupe hétéroarylène en $C_2$ à $C_{30}$ substitué ou non substitué ;
$R_{71}$ et $R_{72}$ sont chacun indépendamment l'un d'un hydrogène, d'un deutérium, d'un halogène, d'un groupe hydroxy, d'un groupe cyano, d'un groupe nitro, d'un groupe amino, d'un groupe amidino, d'une hydrazine, d'une hydrazone, d'un groupe carboxyle ou d'un de ses sels, d'un groupe acide sulfonique ou d'un de ses sels, d'un groupe acide phosphorique ou d'un de ses sels, d'un groupe alkyle en $C_1$ à $C_{30}$ substitué ou non substitué, d'un groupe alcényle en $C_2$ à $C_{30}$ substitué ou non substitué, d'un groupe alcynyle en $C_2$ à $C_{30}$ substitué ou non substitué, d'un groupe alkoxy en $C_1$ à $C_{30}$ substitué ou non substitué, d'un groupe cycloalkyle en $C_3$ à $C_{30}$ substitué ou non substitué, d'un groupe aryle en $C_6$ à $C_{30}$ substitué ou non substitué, d'un groupe aryloxy en $C_6$ à $C_{30}$ substitué ou non substitué, et d'un groupe arylthio en $C_6$ à $C_{30}$ substitué ou non substitué.

**21.** Appareil d'affichage électroluminescent organique comprenant un transistor qui comprend une source, un drain, une porte et une couche active, et l'OLED selon l'une quelconque des revendications précédentes, où une première électrode de l'OLED est connectée électriquement à la source ou au drain.

FIG. 1

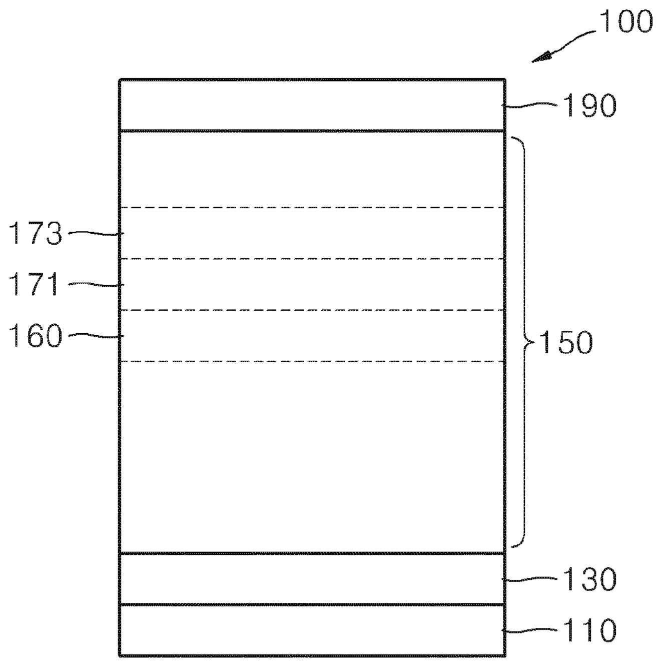

FIG. 2

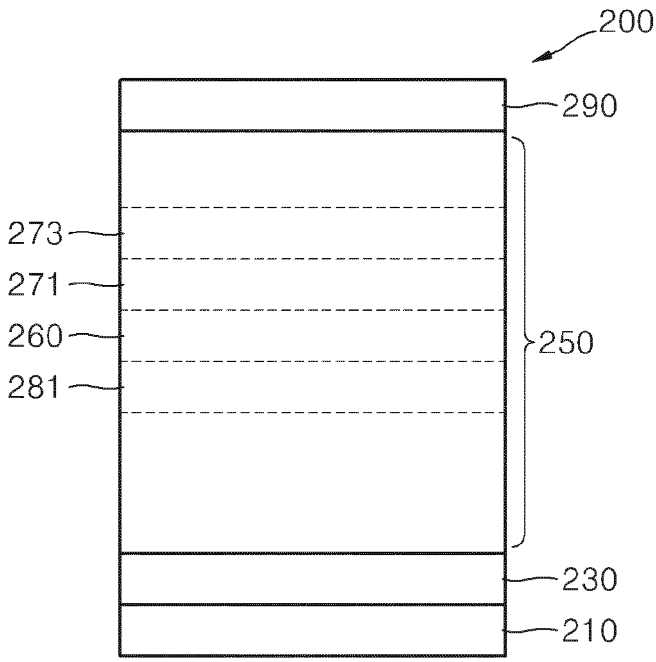

FIG. 3

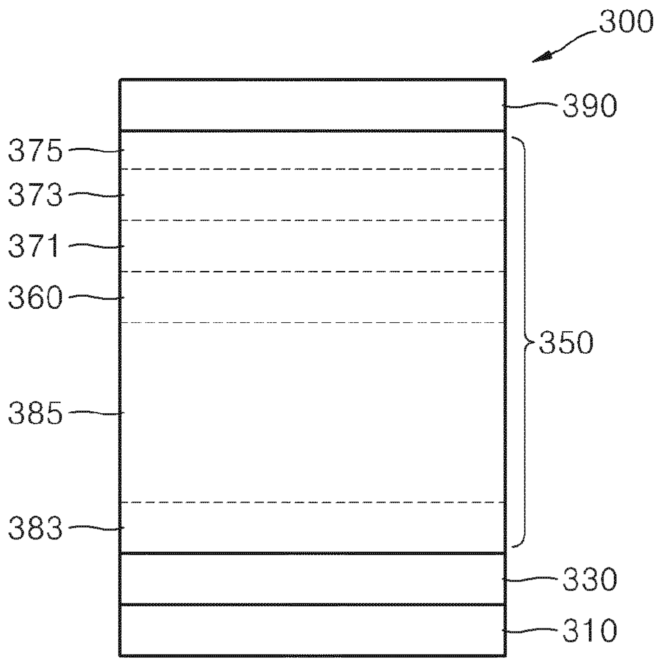

FIG. 4

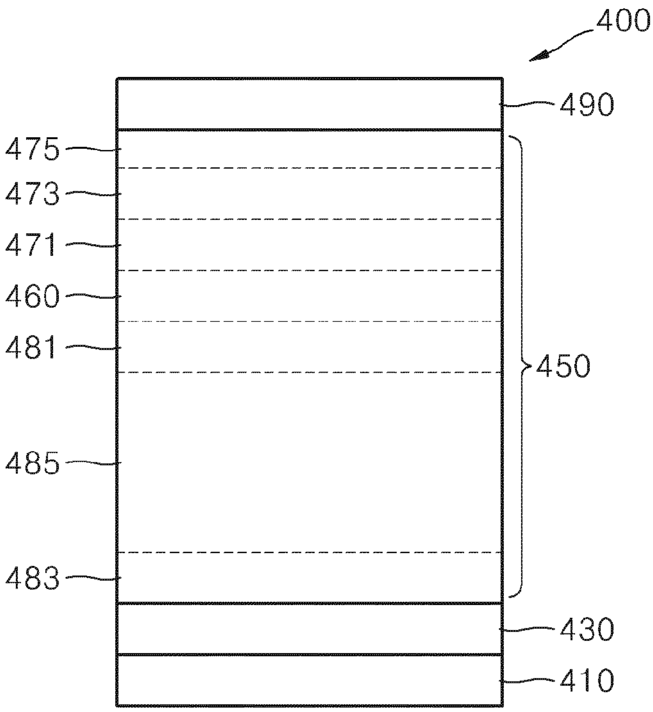

FIG. 5

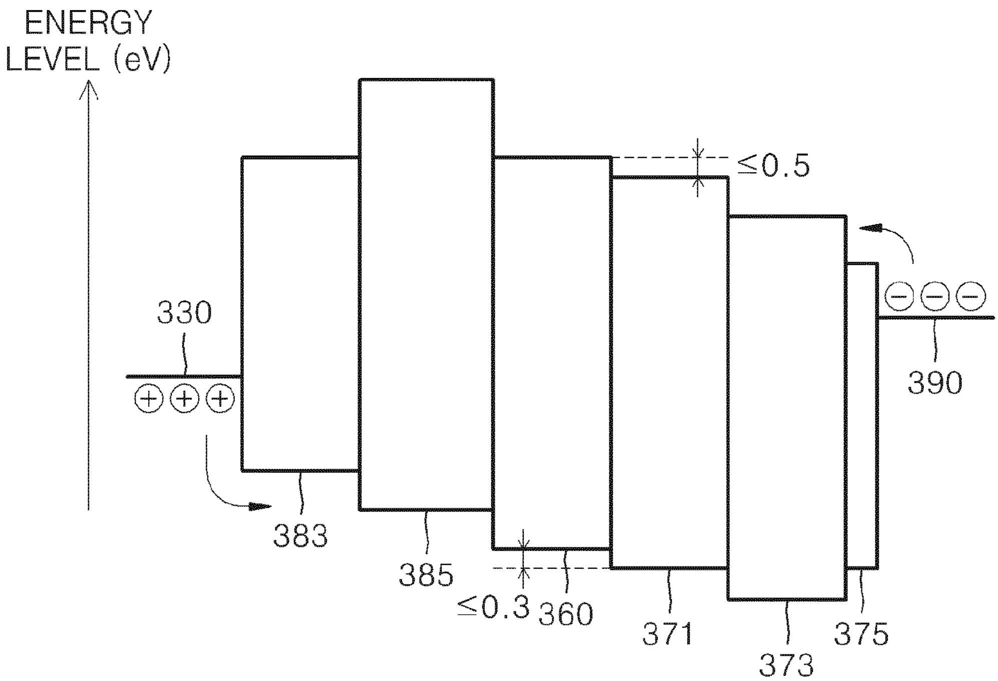

FIG. 6

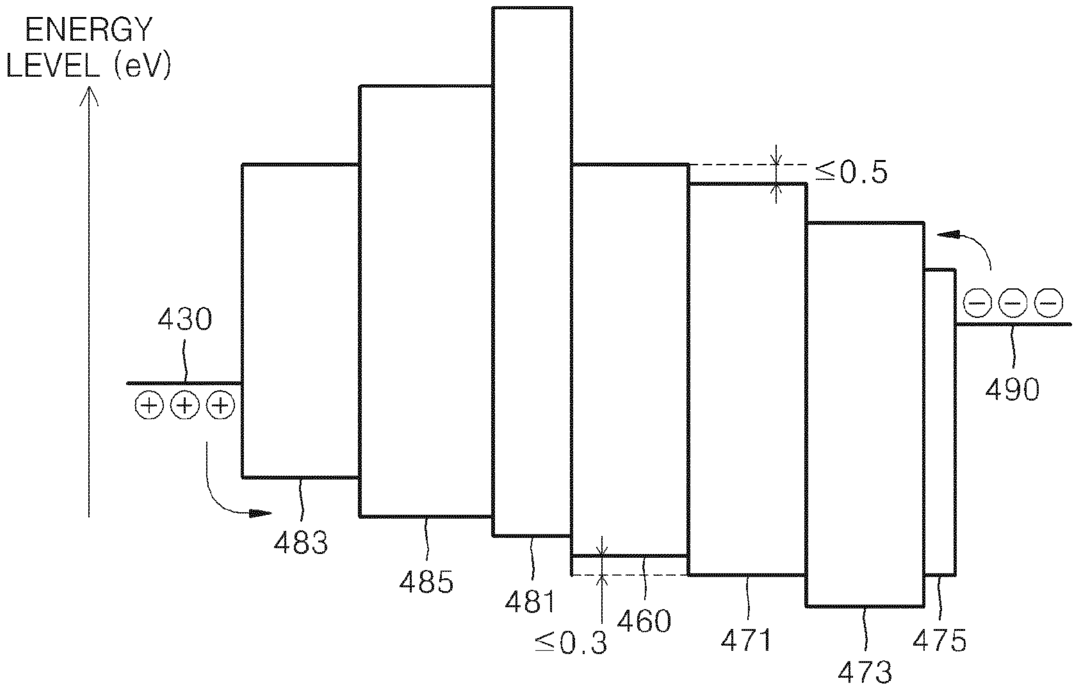

FIG. 7

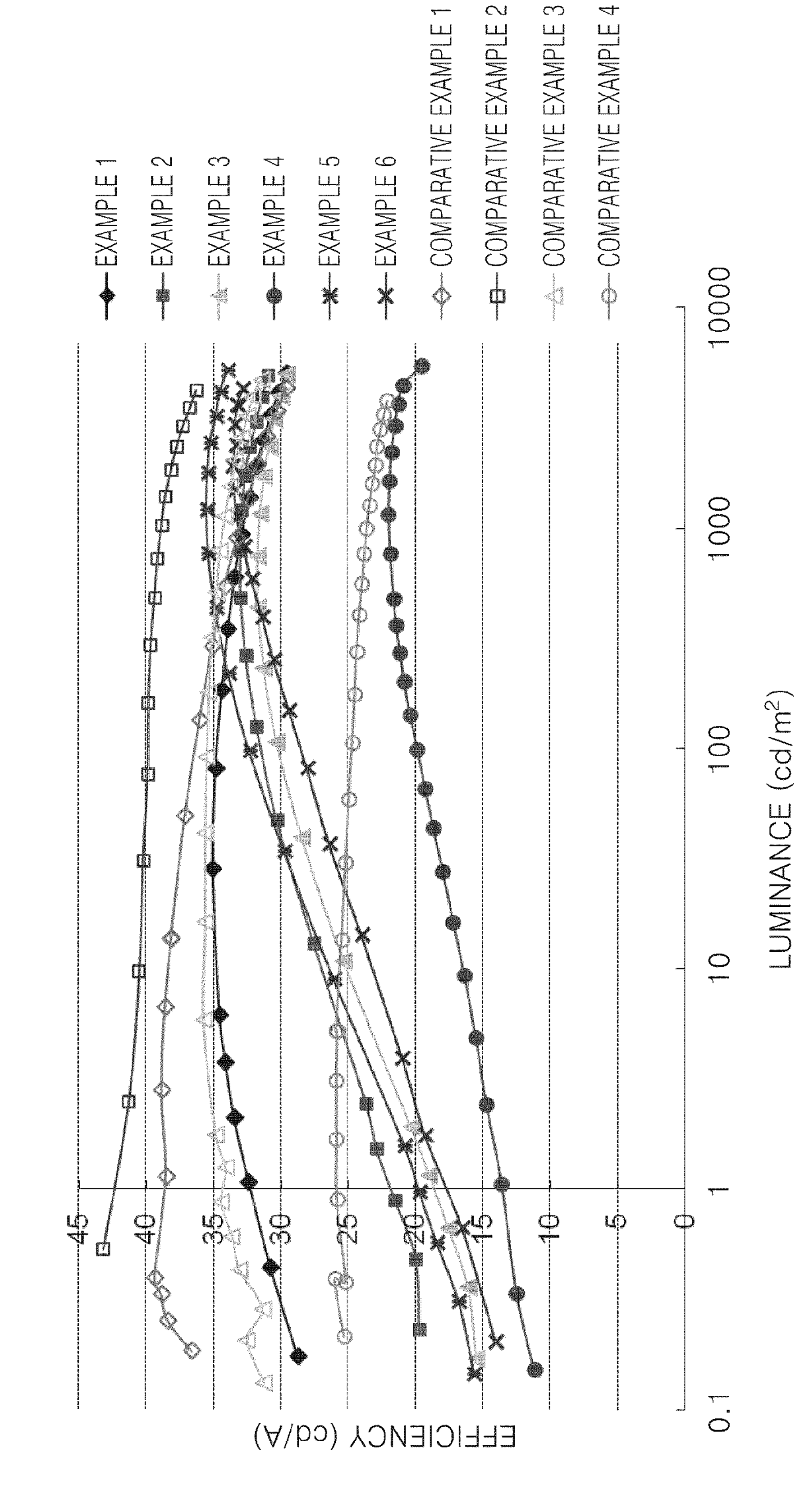
EFFICIENCY (cd/A)
LUMINANCE (cd/m2)
0
5
10
15
20
25
30
35
40
45
0.1
1
10
100
1000
10000
EXAMPLE 1
EXAMPLE 2
EXAMPLE 3
EXAMPLE 4
EXAMPLE 5
EXAMPLE 6
COMPARATIVE EXAMPLE 1
COMPARATIVE EXAMPLE 2
COMPARATIVE EXAMPLE 3
COMPARATIVE EXAMPLE 4

FIG. 8

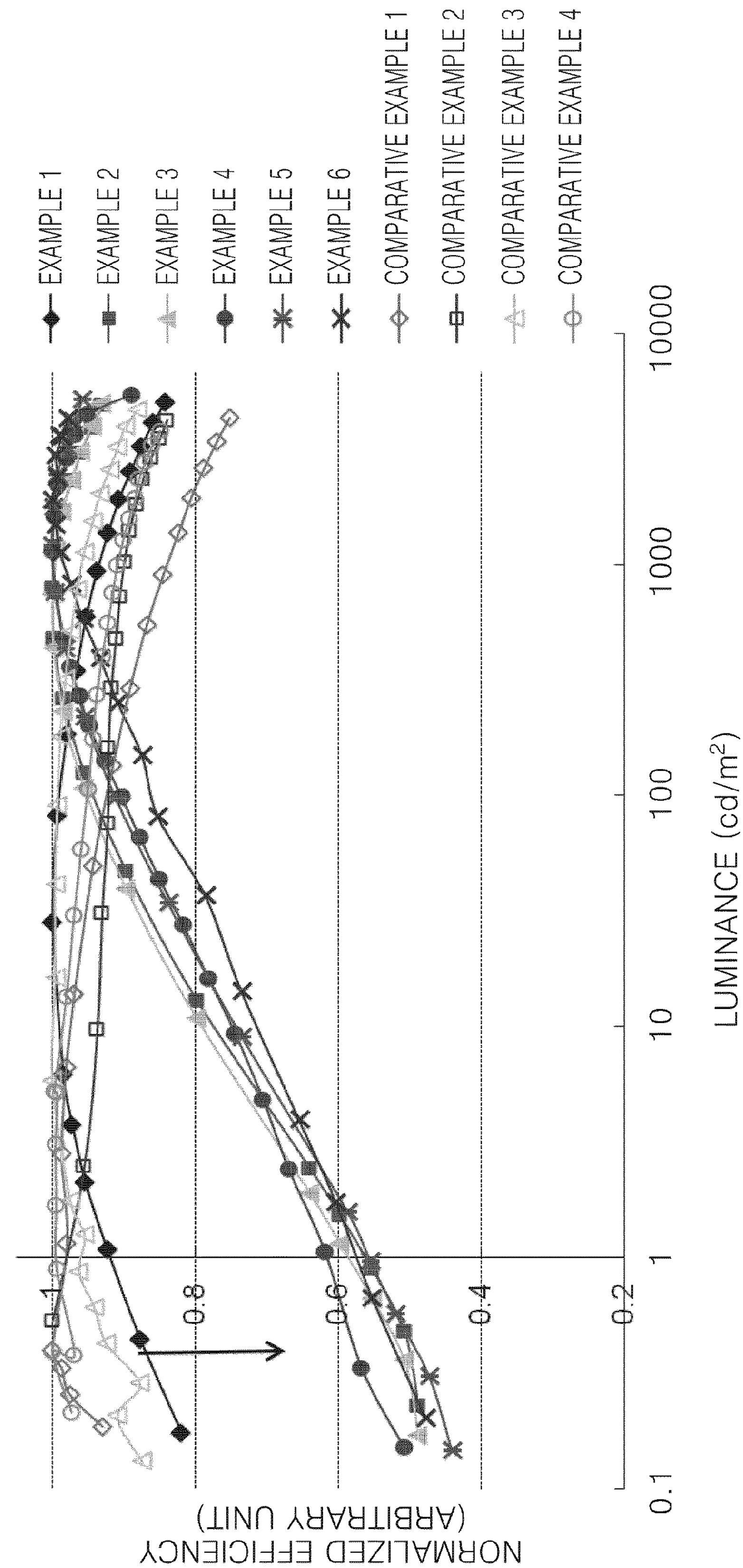
NORMALIZED EFFICIENCY
(ARBITRARY UNIT)
LUMINANCE (cd/m²)
0.1
1
10
100
1000
10000
0.2
0.4
0.6
0.8
1
EXAMPLE 1
EXAMPLE 2
EXAMPLE 3
EXAMPLE 4
EXAMPLE 5
EXAMPLE 6
COMPARATIVE EXAMPLE 1
COMPARATIVE EXAMPLE 2
COMPARATIVE EXAMPLE 3
COMPARATIVE EXAMPLE 4

FIG. 9

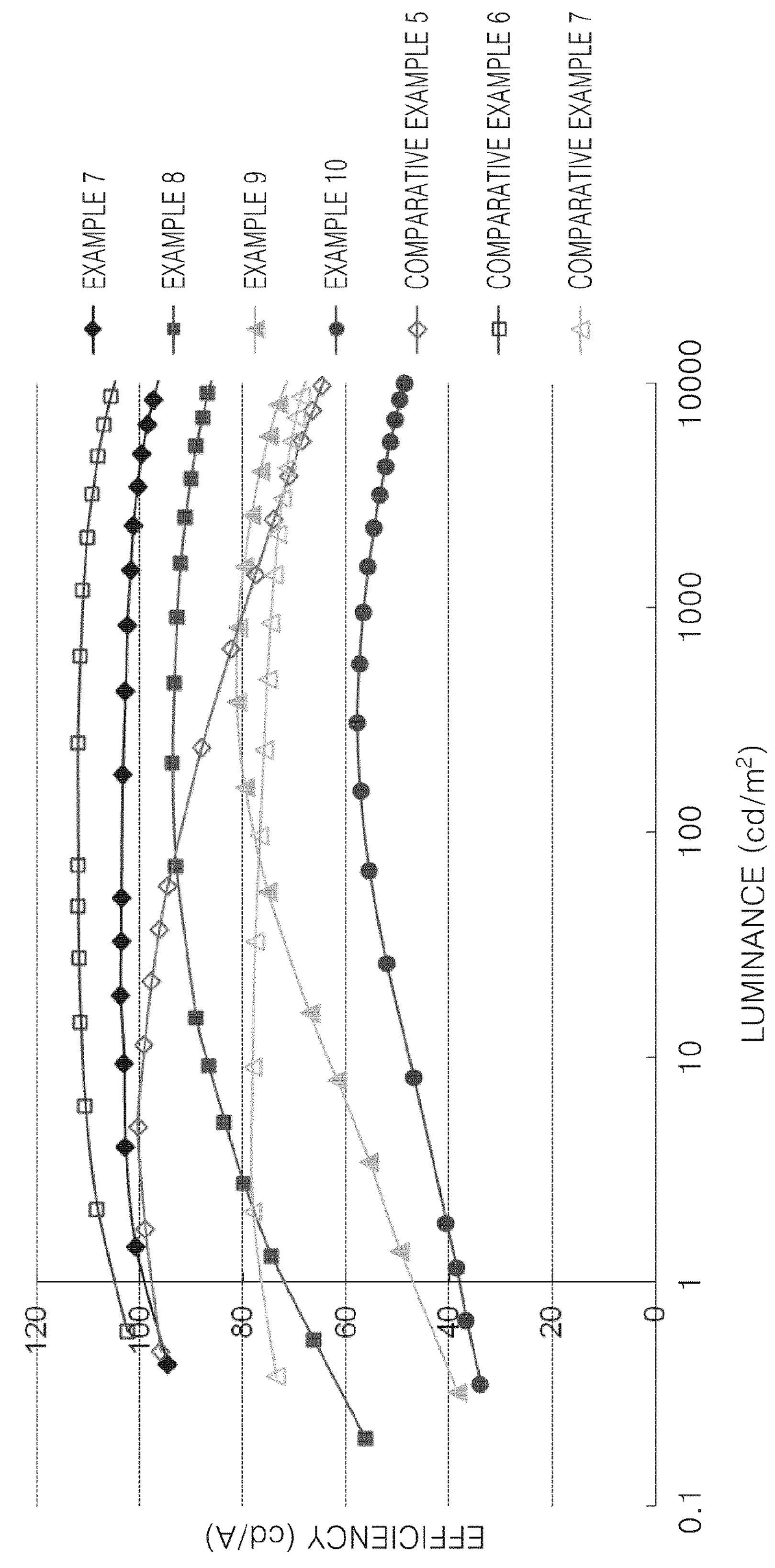
EFFICIENCY (cd/A)
120
100
80
60
40
20
0
0.1
1
10
100
1000
10000
LUMINANCE (cd/m²)
EXAMPLE 7
EXAMPLE 8
EXAMPLE 9
EXAMPLE 10
COMPARATIVE EXAMPLE 5
COMPARATIVE EXAMPLE 6
COMPARATIVE EXAMPLE 7

FIG. 10

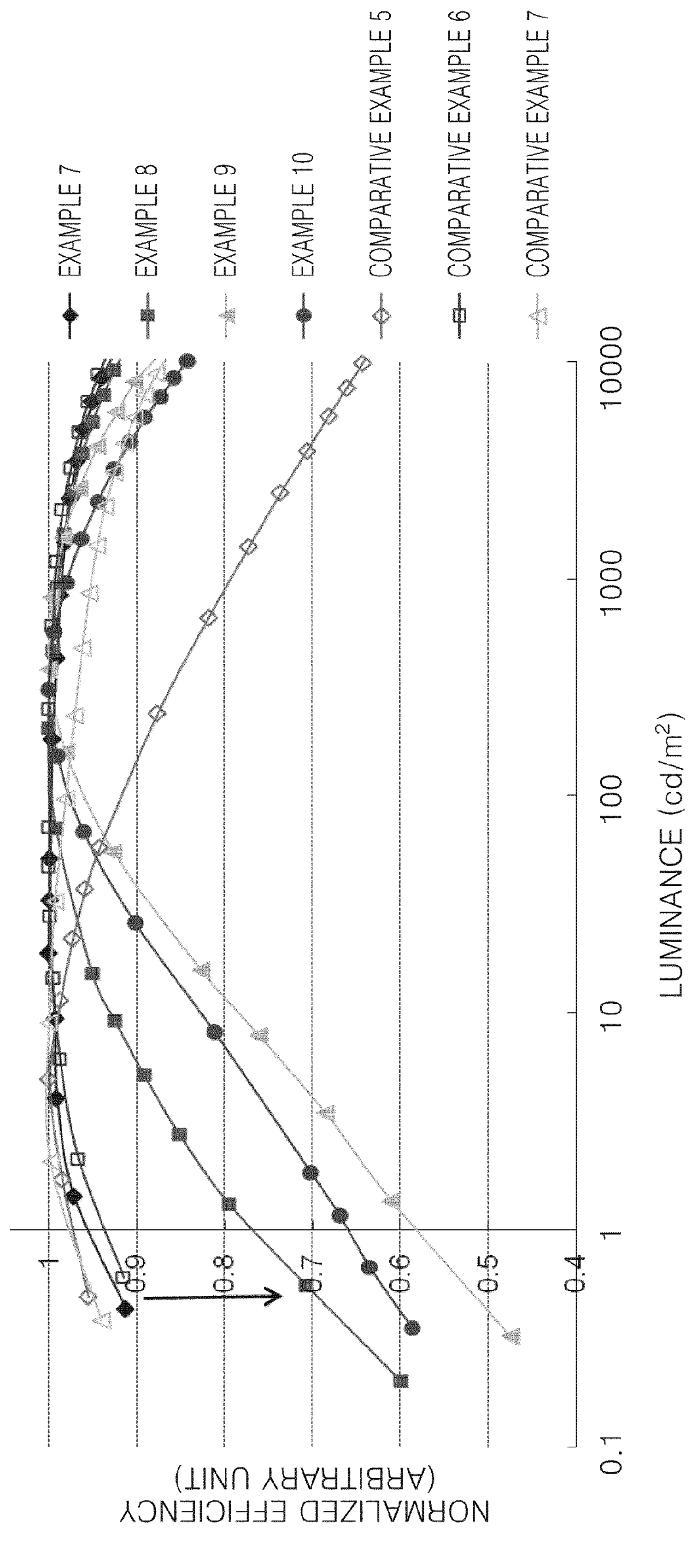
NORMALIZED EFFICIENCY
(ARBITRARY UNIT)
LUMINANCE (cd/m²)
0.1
1
10
100
1000
10000
0.4
0.5
0.6
0.7
0.8
0.9
1
EXAMPLE 7
EXAMPLE 8
EXAMPLE 9
EXAMPLE 10
COMPARATIVE EXAMPLE 5
COMPARATIVE EXAMPLE 6
COMPARATIVE EXAMPLE 7

FIG. 11

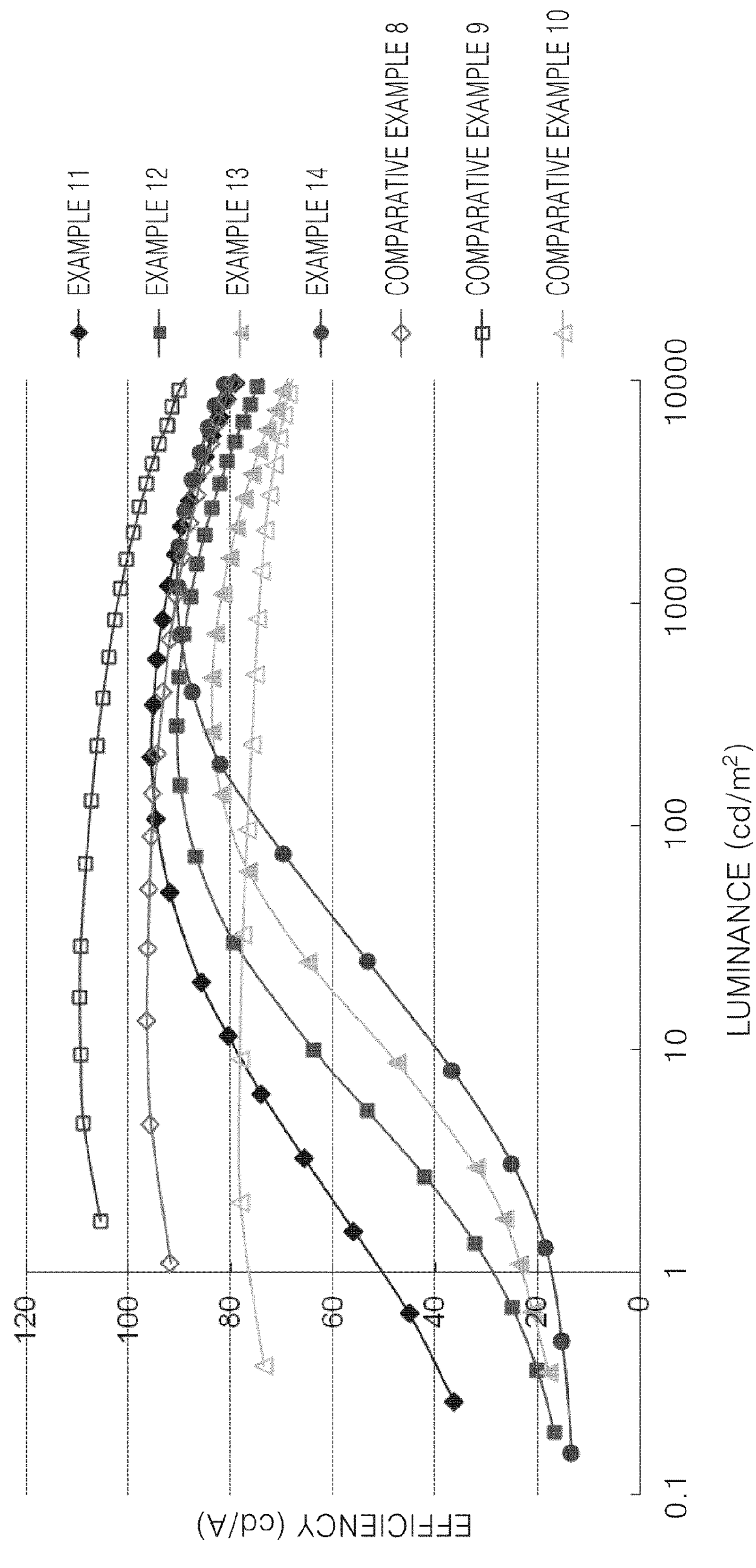
EFFICIENCY (cd/A)
0
20
40
60
80
100
120
0.1
1
10
100
1000
10000
LUMINANCE (cd/m2)
EXAMPLE 11
EXAMPLE 12
EXAMPLE 13
EXAMPLE 14
COMPARATIVE EXAMPLE 8
COMPARATIVE EXAMPLE 9
COMPARATIVE EXAMPLE 10

FIG. 12

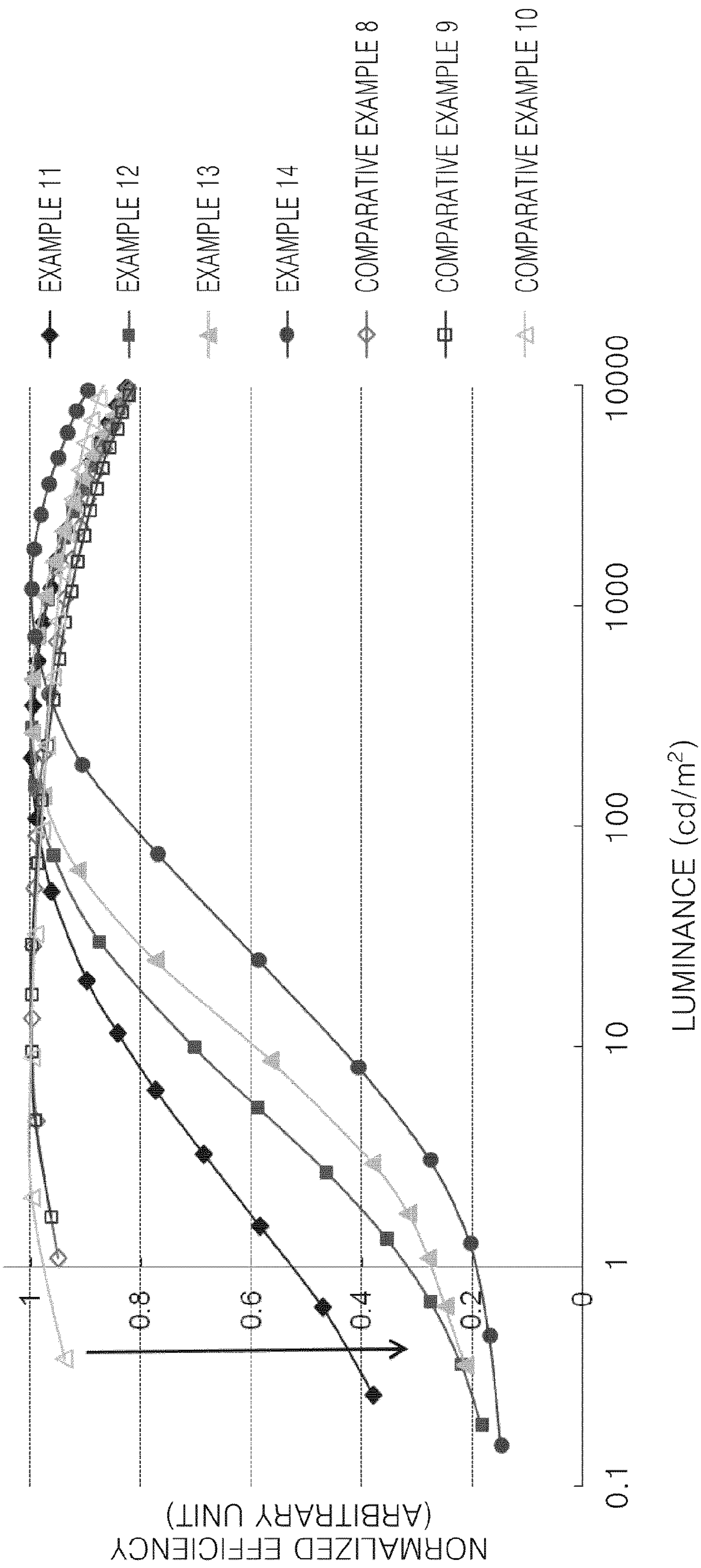
NORMALIZED EFFICIENCY
(ARBITRARY UNIT)
0
0.2
0.4
0.6
0.8
1
0.1
1
10
100
1000
10000
LUMINANCE (cd/m$^2$)
EXAMPLE 11
EXAMPLE 12
EXAMPLE 13
EXAMPLE 14
COMPARATIVE EXAMPLE 8
COMPARATIVE EXAMPLE 9
COMPARATIVE EXAMPLE 10

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 20090191427 A1
- US 20070252516 A1